Europäisches Patentamt

European Patent Office

Office européen des brevets

(19)

(11) EP 0 939 343 A1

(12) EUROPEAN PATENT APPLICATION

(43) Date of publication:
01.09.1999 Bulletin 1999/35

(51) Int Cl.⁶: G03F 7/20

(21) Application number: 99301386.1

(22) Date of filing: 25.02.1999

(84) Designated Contracting States:
**AT BE CH CY DE DK ES FI FR GB GR IE IT LI LU MC NL PT SE**
Designated Extension States:
**AL LT LV MK RO SI**

(30) Priority: 26.02.1998 JP 4541598
02.05.1998 JP 13747398
02.05.1998 JP 13747498
21.07.1998 JP 22109798
09.09.1998 JP 25514398

(71) Applicant: **CANON KABUSHIKI KAISHA**
**Tokyo (JP)**

(72) Inventors:
• **Kawashima, Miyoko,**
**c/o Canon Kabushiki Kaisha**
**Tokyo (JP)**

• **Iwasaki, Yuichi, c/o Canon Kabushiki Kaisha**
**Tokyo (JP)**
• **Suzuki, Akiyoshi, c/o Canon Kabushiki Kaisha**
**Tokyo (JP)**
• **Sugita, Mitsuro, c/o Canon Kabushiki Kaisha**
**Tokyo (JP)**
• **Saitoh, Kenji, c/o Canon Kabushiki Kaisha**
**Tokyo (JP)**

(74) Representative:
**Beresford, Keith Denis Lewis et al**
**BERESFORD & Co.**
**2-5 Warwick Court**
**High Holborn**
**London WC1R 5DJ (GB)**

(54) **Exposure method and exposure apparatus**

(57) An exposure method and apparatus for exposing a resist with a pattern image of a mask having patterns being different with respect to contrast of image, wherein the position where an image of a pattern, of the patterns of the mask, having lower contrast of image is formed is exposed with an image of contrast higher than the lower contrast image, whereby contrast of exposure amount distribution related to the pattern of lower contrast is improved.

FIG. 1

**Description**

FIELD OF THE INVENTION AND RELATED ART

This invention relates to an exposure method and exposure apparatus and, more particularly, to an exposure method and exposure apparatus for exposing a photosensitive substrate to a fine circuit pattern. The exposure method and exposure apparatus of the present invention are suitably usable in manufacture of various devices such as a semiconductor chip (e.g., IC or LSI), a display device (e.g., liquid crystal panel), a detector element (e.g., magnetic head), or an image pickup device (e.g., CCD), for example.

For manufacture of devices such as IC, LSI or liquid crystal panel on the basis of photolithography, a projection exposure method and projection exposure apparatus are used, in which a circuit pattern of a photomask or reticle (hereinafter "mask") is projected through a projection optical system onto a photosensitive substrate such as a silicon wafer or glass plate (hereinafter "wafer") having a photoresist, for example, applied thereto, by which the circuit pattern is transferred or printed on the substrate.

Increasing density of integration of such device has forced further miniaturization of a pattern to be transferred to a chip region of a wafer and, thus, further improvement of resolution and further increase of the area of the chip region. In the projection exposure method and projection exposure apparatus which are in the mainstream of the wafer microprocessing techniques, therefore, attempts have been made to improve the resolution and the exposure area so that an image of a size (linewidth) of 0.5 micron or less can be formed in a wide range.

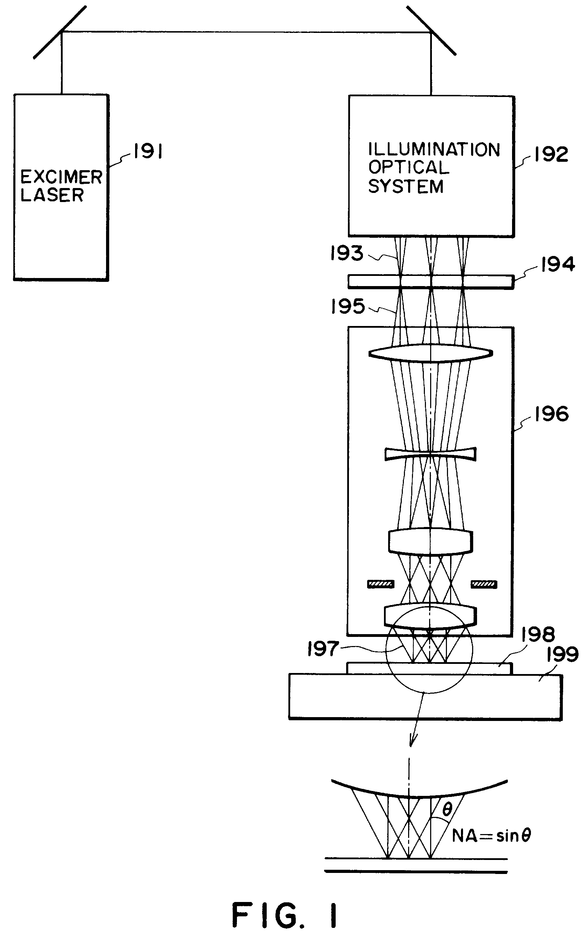

Figure 1 is a schematic view of a projection exposure apparatus of known type. Denoted in the drawing at 191 is an excimer laser which is a light source for exposure with ultraviolet rays. Denoted at 192 is an illumination optical system, and denoted at 193 is illumination light. Denoted at 194 is a mask, and denoted at 195 is exposure light on object side, emitted from the mask 194 and entering an optical system 196. Denoted at 196 is a reduction projection optical system, and denoted at 197 is exposure light on image side, emitted from the optical system 196 and impinging on a wafer (photosensitive substate) 198. Denoted at 199 is a substrate stage for holding the photosensitive substrate.

Laser light emitted from the excimer laser 191 is directed by a directing optical system to the illumination optical system 192, by which the light is transformed into illumination light 193 having a predetermined light intensity distribution, orientation distribution, and opening angle (numerical aperture NA), for example. The thus provided illumination light 193 illuminates the mask 194. The mask 194 has a fine pattern of chromium, for example, formed on a quartz substrate. This pattern has a size corresponding to an inverse (e.g., 2x, 4x or 5x) of the projection magnification of the projection optical system 196 with respect to the size of the fine pattern which is going to be formed on the wafer 198. The illumination light 193 is diffracted by this fine pattern as it passes through the mask 194, whereby exposure light 195 on object side is defined. The projection optical system 196 functions to transform the object side exposure light 195 into image side exposure light 197 with which the fine pattern of the mask 194 is imaged upon the wafer 198 at the aforementioned projection magnification and with sufficiently small aberration. As illustrated in an enlarged view at the bottom of Figure 1, the image side exposure light 197 is converged on the wafer 198 at predetermined numerical aperture NA (= sinθ), whereby an image of the fine pattern is formed on the wafer 198. The substrate stage 199 performs stepping motion along the image plane of the projection optical system so that fine patterns are sequentially formed on different regions (shot regions each being a region for providing one or plural chips) on the wafer 198. Thus, the substrate stage 199 shifts its position with respect to the projection optical system 196.

With projection exposure apparatuses having an excimer laser as a light source, such as above and being used prevalently, practically it is difficult to form a pattern of 0.15 micron or less.

The projection optical system 196 has a limitation in resolution due to trade-off between optical resolution and depth of focus which is attributable to the wavelength of exposure light (hereinafter "exposure wavelength"). The resolution R and the depth of focus DOF of a projection exposure apparatus can be expressed using Rayleigh's equation, such as equations (1) and (2) below:

$$R = k_1 (\lambda/NA) \tag{1}$$

$$DOF = k_2 (\lambda/NA^2) \tag{2}$$

where $\lambda$ is the exposure wavelength, NA is the image side numerical aperture of the projection optical system 196, and normally $k_1$ and $k_2$ are of values of about 0.5 - 0.7. From equations (1) and (2), it is seen that, while improvement of resolution with small resolution R may be attainable by enlarging NA ("enlargement of NA"), since in practical exposure the depth of focus DOF of the projection optical system 196 should have a certain value or more, the "enlargement of NA" beyond a certain level is not practicable and thus further improvement of resolution necessitates shortening of exposure wavelength $\lambda$ ("shortening of wavelength").

However, the shortening of wavelength encounters a serious difficulty. It is that there is no lens glass material available for the projection optical system 196. Almost all glass materials have a transmission factor of nearly zero, with respect to deep ultraviolet ray region. There is synthetic silica as a glass material produced specifically for use in exposure apparatus (exposure wavelength of about 248 nm) in accordance with special manufacturing processes. However, the transmission factor of even such synthetic silica decreases considerably with respect to exposure wavelength not longer than 193 nm. Thus, it may be very difficult to develop a practical glass material having a sufficiently high transmission factor in a region not longer than exposure wavelength 150 nm, corresponding to a fine pattern of 0.15 micron or less.

Further, a glass material to be used in deep ultraviolet ray region should satisfy, to some extent, various conditions, other than the transmission factor, such as durability, uniformness of refraction factor, optical distortion, and workability, for example. Taking theses situations into account, development of a practical glass material for use in a exposure wavelength region not longer than 150 nm will not easily accomplished.

In projection exposure methods and projection exposure apparatuses such as described, shortening of exposure wavelength to about 150 nm or less is necessary for accomplishing formation of a pattern of 0.15 micron or less upon a wafer 198, whereas, because of unavailability of practical glass material for such wavelength region, practically it is very difficult to produce a pattern of 0.15 micron or less upon a wafer 198.

U.S. Patent No. 5,415,835 shows a method of forming a fine pattern on the basis of interference exposure using two mutually coherent light beams (hereinafter "double-beam interference exposure"), interfering with each other to produce interference fringe. This double-beam interference exposure may attain formation of a pattern of 0.15 micron or less upon a wafer.

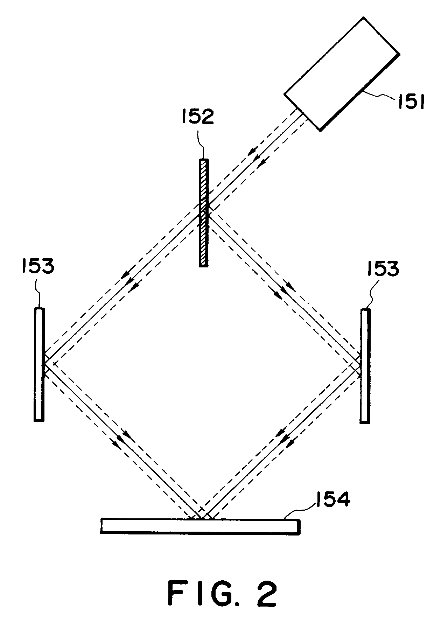

The principle of such double-beam interference exposure will be explained with reference to Figure 2. Laser light from a laser 151 having coherency and comprising parallel light ray flux is divided by a half mirror 152 into two light beams. These two light beams are reflected by flat mirrors 153, respectively, by which the laser light beams (coherent parallel light fluxes) intersect with each other with a certain angle not greater than 90 deg. Interference fringe is thus produced at the intersection. A wafer 154 is exposed with this interference fringe (light intensity distribution thereof), whereby a fine periodic pattern (periodic exposure amount distribution) corresponding to the light intensity distribution of the interference fringe is formed on the wafer. Through subsequent development process to the wafer, a fine periodic resist mask (for etching) is provided on the wafer.

In Figure 2, if the two light beams intersect with each other upon the wafer surface while these two light beams are inclined with respect to a normal to the wafer surface, in opposite directions and by the same angle, the resolution R by this double-beam interference exposure can be expressed by equation (3) below:

$$R = \lambda/(4\sin\theta)$$

$$= \lambda/4NA$$

$$= 0.25(\lambda/NA) \qquad\qquad \cdots(3)$$

where R represents the linewidths of a bright portion and a dark portion of the interference fringe, that is, the linewidths of the line and space constituting the periodic pattern, and $\theta$ represents incidence angle (absolute value) of the two beams with respect to the image plane. Since $\sin\theta$ corresponds to image side numerical aperture of the optical system in projection exposure, it is expressed as $\sin\theta = NA$.

Comparing equation (1) for resolution in ordinary projection exposure with equation (3) for resolution in double-beam interference exposure, since the resolution R in double-beam interference exposure correspond to a case where in equation (1) $k_1 = 0.25$ is put on, it is seen that the double-beam interference exposure attains a resolution twice or more higher than the resolution of ordinary projection exposure where $k_1 = 0.5$ to 0.7.

Although it is not discussed in the aforementioned U.S. patent, R = 0.10 micron may be attainable with $\lambda$ = 0.248 nm (KrF excimer laser) and NA = 0.6, for example.

However, what is attainable with this double-beam interference exposure is basically a simple periodic pattern (exposure amount distribution) corresponding to the light intensity distribution of interference fringe, only. It is not attainable to produce a complicated pattern such as a circuit pattern, with the double-beam interference exposure.

U.S. Patent No. 5,415,835 proposes the following procedure. That is, first a simple (periodic) exposure amount distribution is applied to a resist of a wafer through interference fringe by using a double-beam interference exposure apparatus and, thereafter, a separate exposure apparatus is used so that a portion of the resist corresponding to the bright portion of the interference fringe is exposed to an image of an opening of a mask by which a certain exposure amount is applied to that portion (dual exposure). By this, the exposure amounts only at particular line portions of plural bright portions of the interference fringe are enlarged uniformly, beyond the threshold of the resist. Consequently, after development, isolated lines (resist pattern) are produced.

With this dual exposure method proposed in U.S. Patent No. 5,415,835, however, what is attainable is only a circuit pattern of simple shape which comprises a portion of stripe patterns that can be formed by double-beam interference exposure. On the other hand, an ordinary circuit pattern comprises a combination of many types of patterns having various linewidths and various orientations. It is therefore not attainable to produce a complicated pattern such as a circuit pattern.

Japanese Laid-Open Patent Application, Laid-Open No. 253649/1995 shows a dual exposure method with which a fine isolated pattern similar to that of the aforementioned U.S. Patent No. 5,415,835 may be formed. In accordance with this dual exposure method, an ordinary projection exposure apparatus is used to perform both a double-beam interference exposure based on a phase shift pattern and an exposure based on an image of a fine opening pattern (which are not resolvable with this exposure apparatus), to the same region on a resist of a wafer. The exposure wavelengths used in these exposures differ from each other by 50 nm or more.

Further, in the dual exposure method shown in Japanese Laid-Open Patent Application, Laid-Open No. 253649/1995, the pattern of the mask is formed by use of a material having wavelength selectivity such that the double-beam interference exposure and the ordinary exposure are performed by using one and the same mask (pattern). The pattern (of the mask) in the ordinary exposure comprises one or more isolated patterns, and also the circuit pattern (exposure amount distribution or surface step distribution after development) produced as a result of dual exposure comprises one or more isolated patterns, only.

Therefore, even with the dual exposure method shown in Japanese Laid-Open Patent Application, Laid-Open No. 253649/1995, like the aforementioned U.S. Patent No. 5,415,835, it is not attainable to produce a pattern of complicated shape such as a circuit pattern.

## SUMMARY OF THE INVENTION

It is an object of the present invention to provide an exposure method and/or an exposure apparatus by which a circuit pattern of complicated shape can be produced through multiple exposure. Here, the words "multiple exposure" are referred to a process wherein exposures are made to the same location on a resist without intervention of a development process between these exposures. The exposures may be double or triple or more.

In accordance with an aspect of the present invention, there is provided an exposure method and exposure apparatus for exposing a resist with a mask having pattern portions being different with respect to contrast of image, wherein the position where an image of a pattern portion, of the mask, having lowest contrast of image is formed is exposed with an image of contrast higher than the lowest contrast image, whereby contrast of exposure amount distribution related to the pattern portion of lowest contrast is improved.

In accordance with an another aspect of the present invention, there is provided an exposure method and apparatus for exposing a resist with a mask having pattern portions being different with respect to linewidth, wherein the position where an image of a pattern portion, of the mask, having smallest linewidth is formed is exposed with an image of contrast higher than the image of the smallest linewidth pattern portion, whereby contrast of exposure amount distribution related to the patter of lower contrast is improved.

In accordance with a further aspect of the present invention, there is provided an exposure method and exposure apparatus for exposing a resist with a mask having plural pattern portions being different with respect to contrast of image, wherein multiple exposure to be performed with the method or apparatus includes a first exposure in which exposure amount by an image of a patter portion, of the pattern portions of the mask, of lowest contrast does not exceed an exposure threshold of the resist while exposure amount by an image of another pattern portion exceeds the exposure threshold, and a second exposure in which the position where the image of lowest contrast is formed is exposed with an image of contrast higher than the image of lowest contrast.

In accordance with a still further aspect of the present invention, there is provided an exposure method and exposure apparatus for exposing a resist with a mask having plural pattern portions being different with respect to linewidth, wherein multiple exposure to be performed with the method or apparatus includes a first exposure in which exposure amount by an image of a patter portion, of the pattern portions of the mask, of smallest linewidth does not exceed an exposure threshold of the resist while exposure amount by an image of another pattern portion exceeds the exposure threshold, and a second exposure in which the position where the image of smallest linewidth is formed is exposed with an image of contrast higher than the image of lowest contrast.

In one preferred form of these aspects of the present invention, the resist may be exposed with images of patterns of the mask by use of radiation such as ultraviolet rays, X-rays or electron beam, for example, and with use of or without use of a projection optical system.

The image of high or higher contrast may be formed by use of radiation of the same wavelength as the aforementioned radiation.

The resist may be exposed with the higher contrast image and the image of the pattern simultaneously. The resist may be exposed with the higher contrast image and, thereafter, it may be imaged with the image of the pattern. The resist may be exposed with the image of the pattern and, thereafter, it may be exposed with the higher contrast image.

The image of higher contrast may be formed by projecting a mask of phase shift type. The phase shift type mask may comprise a Levenson type phase shift mask. The phase shift type mask may include a phase shifter portion for applying a mutual phase shift of 180 deg. to radiation beams passing through two regions, respectively, without passing a light blocking portion. The phase shift type mask may include an isolated pattern provided by the phase shifter portion. The phase shift type mask may include a repetition pattern having arrayed phase shifter portions.

The image of higher contrast may be formed by projecting two parallel lights, resulting from division of laser light, onto the resist in different directions, to cause interference of them on the resist. The image of higher contrast may be formed by using a probe of light or electrons. The image of higher contrast may be formed by illuminating a repetition pattern of the mask along an oblique direction and by projecting it.

The first-mentioned mask may comprise a phase shift mask. The first-mentioned mask may comprise a phase shift mask of one of halftone type, rim type and chromium-less shifter light blocking type, with a result of good contrast exposure amount distribution.

The pattern of the first-mentioned mask may be illuminated along an oblique direction and may be projected by a projection optical system. The image of higher contrast may be formed in a state where $\sigma$ is not greater than 0.3 and by imaging a pattern of a phase shift mask, wherein the phase shift mask may comprise a Levenson type phase shift mask.

In one preferred form of exposure method and exposure apparatus of the present invention, the center position of the intensity distribution of an image of the pattern of the mask should be registered with the center position of the intensity distribution of the image of higher contrast. However, from the relation with contrast of exposure amount distribution to be finally formed upon the resist, deviation within a certain range is allowed to the center positions of the intensity distributions of these images.

There is no limitation to exposure wavelength, in the present invention. However, the present invention is particularly suitably usable with exposure wavelength of 250 nm or shorter. Exposure wavelength not longer than 250 may be provided by use of KrF excimer laser (about 248 nm) or ArF excimer laser (about 193 nm).

The present invention may be embodied, for example, by use of a projection exposure apparatus comprising a projection optical system for projecting a pattern of a mask to a wafer, and a mask illumination optical system which can perform (large $\sigma$) partial coherent illumination wherein $\sigma$ (sigma) is relatively large, and (small $\sigma$) partial coherent illumination wherein $\sigma$ is relatively small or coherent illumination. For example, projection exposure of the mask pattern (circuit pattern) may be performed through the large $\sigma$ partial coherent illumination, while a phase shift type mask may be illuminated through coherent illumination or small $\sigma$ partial coherent illumination. With such double-beam interference illumination, exposure of higher contrast image by interference image can be made.

The words "partial coherent illumination" refer to illumination wherein the value of $\sigma$ (= "mask side numerical aperture of illumination optical system"/"mask side numerical aperture of projection optical system") is larger than zero and smaller than 1. The words "coherent illumination" refer to one in which the value of $\sigma$ is zero or close to zero, and it is very small as compared with $\sigma$ of partial illumination. Large $\sigma$ refers to $\sigma$ not smaller than 0.6, while small $\sigma$ refers to $\sigma$ not larger than 0.3.

The exposure apparatus may include an optical system for the mask illumination optical system, wherein partial coherent illumination, coherent illumination, and partial coherent illumination of relatively small $\sigma$ can be interchanged.

The present invention may be embodied by an exposure system which includes a double-beam interference exposure apparatus such as shown in Figure 2, a projection exposure apparatus such as shown in Figure 1, and a movement stage used in both of these exposure apparatuses for holding a wafer (photosensitive substrate). Exposure wavelength to be used may be not longer than 400 nm as described and, particularly, not longer than 250 nm. Light of exposure wavelength not longer than 250 nm may be provided by use of KrF excimer laser (about 248 nm) or ArF excimer laser (about 193 nm).

These and other objects, features and advantages of the present invention will become more apparent Upon a consideration of the following description of the preferred embodiments of the present invention taken in conjunction with the accompanying drawings.

BRIEF DESCRIPTION OF THE DRAWINGS

Figure 1 is a schematic view of a projection exposure apparatus of known type.

Figure 2 is a schematic view of a double-beam interference exposure apparatus, for performing periodic pattern exposure.

Figure 3 is a flow chart for explaining an exposure method according to an embodiment of the present invention.

Figures 4A and 4B are schematic views, respectively, for explaining a periodic pattern (exposure pattern) which can be produced by double-beam interference exposure.

Figures 5A and 5B are graphs for explaining exposure sensitivity characteristic of a resist.

Figure 6 is a schematic view for explaining pattern formation with development.

Figure 7 is a schematic view for explaining a periodic pattern (exposure pattern) which can be produced by double-beam interference exposure.

Figure 8 is a schematic view for explaining a periodic pattern (exposure pattern) which can be produced by double-beam interference exposure according to an embodiment of the present invention.

Figures 9A and 9B are schematic views, respectively, for explaining an example of exposure pattern (lithography pattern) which can be produced in a first embodiment of the present invention.

Figures 10A and 10B are schematic views, respectively, for explaining another example of exposure pattern (lithography pattern) which can be produced in the first embodiment of the present invention.

Figures 11A and 11B are schematic views, respectively, for explaining a further example of exposure pattern (lithography pattern) which can be produced in the first embodiment of the present invention.

Figure 12 is a schematic view for explaining a gate pattern which can be produced in a second embodiment of the present invention.

Figure 13 is a schematic view for explaining dual exposure process in the second embodiment of the present invention.

Figure 14 is an enlarged view of a gate pattern.

Figure 15 is a schematic view for explaining a pattern forming process.

Figure 16 is a schematic view for explaining an example of projection exposure apparatus for performing periodic pattern exposure based on double-beam interference.

Figure 17 is a schematic view for explaining an example of mask and illumination method therefor, to be used in a projection exposure apparatus of the present invention.

Figure 18 is a schematic view for explaining another example of mask and illumination method therefor, to be used in a projection exposure apparatus of the present invention.

Figure 19 is a schematic view for explaining an example of double-beam interference exposure apparatus according to the present invention.

Figure 20 is a schematic view for explaining an example of high resolution exposure apparatus according to the present invention.

Figure 21 is a schematic view for explaining another example of high resolution exposure apparatus according to the present invention.

Figure 22 is a flow chart for explaining an exposure method according to a third embodiment of the present invention.

Figures 23A - 23G are schematic views, respectively, for explaining an exposure patter to be produced by pattern exposure.

Figures 24A - 24G are schematic views, respectively, for explaining an example of exposure pattern (lithography pattern) to be produced by an embodiment of the present invention.

Figures 25A - 25H are schematic views, respectively, for explaining examples of phase shift mask for producing various patterns, as well as exposure amount distributions on wafer surfaces.

Figures 26A - 26H are schematic views, respectively, for explaining another example of exposure pattern (lithography pattern) to be produced by an embodiment of the present invention.

Figures 27A - 27F are schematic views, respectively, for explaining a ground mask for gate pattern exposure and an ordinary mask, as well as exposure distribution on the mask surface.

Figures 28A - 28C are schematic views, respectively, for explaining an exposure amount distribution and a resist image, provided by dual exposure for gate pattern production.

Figure 29 is a schematic view for tow-dimensionally explaining an embodiment of the present invention.

Figures 30A - 30F are schematic views, respectively, for explaining another example of forming a gate pattern by using a black ground.

Figures 31A - 31C are schematic views, respectively, for explaining an exposure amount distribution and a resist pattern, to be provided by dual exposure.

Figure 32 is a schematic view for two-dimensionally explaining the pattern forming procedure.

Figures 33A and 33B are schematic views, respectively, for explaining another example of mask pattern for producing a circuit pattern.

Figures 34A - 34F are schematic views, respectively, for explaining exposure amount distribution in relation to a circuit pattern.

Figures 35A - 35B are schematic views, respectively, for explaining the circuit pattern forming procedure.

Figures 36A - 36C are schematic views, respectively, for explaining dual exposure with a high-contrast periodic pattern and a low-contrast pattern with a single to three bars.

Figures 37 is a schematic view for explaining intensity distributions (exposure amount distributions) to be produced on a resist by exposure with a three-bar pattern (image), exposure with a periodic pattern (image) and dual exposure with a three-bar pattern (image) and periodic pattern (image), respectively.

Figure 38 is a schematic view for explaining intensity distributions to be produced by dual exposure using patterns (images) with single to three bars and a periodic pattern (image).

Figure 39 is a schematic view for explaining intensity distributions resulting from exposures using patterns (images) with single to three bars, being made by use of a phase shift mask and while changing illumination condition ($\sigma$).

Figure 40 shows graphs for explaining the relation between defocus and contrast, when exposures of patterns with single to three bars are made by use of a phase shift mask and under $\sigma = 0.5$.

Figure 41 shows graphs for explaining the relation between defocus and contrast, when dual exposure by a pattern with single to three bars and a periodic pattern is made in accordance with ordinary illumination of $\sigma = 0.2$ for the periodic pattern and with ring-like illumination of $\sigma = 0.8$ for the bar pattern.

Figure 42 shows graphs for explaining a linewidth linearity error, when exposures by patterns (images) of single to three bars are made in accordance with ring-like illumination of $\sigma = 0.53 - 0.8$.

Figure 43 shows graphs for explaining linewidth linearity error, when dual exposures by patterns (images) of single to three bars and a periodic pattern (image) are made in accordance with ordinary illumination of $\sigma = 0.2$ for the periodic pattern and with ring-like illumination of $\sigma = 0.53 - 0.8$ for bar patterns.

Figure 44 is a schematic view for explaining dual exposure with a periodic pattern and a three-bar pattern having a large linewidth ratio.

Figure 45 is a schematic view for explaining dual exposure with a periodic pattern and a bar pattern having different linewidth bars.

Figure 46 is a schematic view for explaining a difference in two-dimensional image by single exposure with a single bar pattern and dual exposure combined with a periodic pattern.

Figure 47 is a schematic view for explaining intensity distributions resulting from exposure with a zero-contrast pattern (image), exposure with a high-contrast periodic pattern (image) and dual exposure based on these exposures.

Figure 48 is a schematic view for explaining intensity distributions resulting from exposure with a zero-contrast pattern (image), exposure with a high-contrast periodic pattern (image) and dual exposure based on these exposures.

Figure 49 is a schematic view of a reticle having an ordinary chromium pattern.

Figure 50 is a schematic view of a reticle having a halftone phase shift pattern.

Figure 51 is a schematic view of a reticle having a rim type phase shift pattern.

Figure 52 is a schematic view of a reticle having a chromium-less shifter light blocking type phase shift pattern.

Figure 53 is a schematic view of an example of exposure apparatus for double-beam interference, according to the present invention.

Figure 54 is a schematic view for explaining a mask and an illumination method which are usable in the exposure apparatus of Figure 53.

Figure 55 is a schematic view for explaining another example of mask and illumination method, usable in the exposure apparatus of Figure 53.

Figure 56 is a schematic view of a mask according to the present invention.

Figure 57 is a schematic view of another mask according to the present invention.

Figure 58 is a schematic view for explaining an effective light source in an illumination system of the Figure 53 apparatus.

Figure 59 is a schematic view for explaining light intensity distribution upon a pupil plane in the Figure 53 apparatus.

Figure 60 is a schematic view for explaining another example of effective light source in the illumination optical system of the Figure 53 apparatus.

Figure 61 is a schematic view for explaining another example of light intensity distribution upon a pupil plane in the Figure 53 apparatus.

Figure 62 is a schematic view for explaining a further example of light intensity distribution upon a pupil plane in the Figure 53 apparatus.

Figure 63 is a schematic view for explaining another example of effective light source in the illumination optical system of the Figure 53 apparatus.

Figure 64 is a schematic view for explaining another example of light intensity distribution upon a pupil plane in the Figure 53 apparatus.

Figure 65 is a schematic view for explaining a further example of light intensity distribution upon a pupil plane in the Figure 53 apparatus.

Figure 66 is a schematic view for explaining a double-beam interference pattern according to the present invention.

Figure 67 is a schematic view for explaining a double-beam interference pattern and an ordinary pattern, according to the present invention.

Figure 68 is a schematic view for explaining a check pattern according to the present invention.

Figure 69 is a schematic view for explaining a desired pattern according to the present invention.

Figure 70 is a schematic view of a main portion of an exposure apparatus according to an embodiment of the present invention.

Figure 71 is a schematic view of a mask usable in the Figure 70 embodiment.

Figure 72 is a schematic view for explaining the principle of double-beam interference in the present invention.

Figure 73 is a schematic view for explaining a mask and an illumination method in the double-beam interference, according to the present invention.

Figure 74 is a schematic view of an effective light source, in Figure 72.

Figure 75 is a schematic view for explaining light intensity distribution on a pupil plane, in Figure 72.

Figure 76 is a schematic view for explaining a mask and a check pattern image, in Figure 72.

Figure 77 is a schematic view of a main portion of an exposure apparatus according to another embodiment of the present invention.

Figure 78 is a schematic view of an effective light source in an illumination system according to the present invention.

Figure 79 is a schematic view for explaining intensity distribution at a pupil, in an exposure apparatus according to the present invention.

Figure 80 is a schematic view for explaining another example of intensity distribution at a pupil, in an exposure apparatus according to the present invention.

Figure 81 is a schematic view of a light pattern upon a photosensitive substrate, in an embodiment of the present invention.

Figure 82 is a schematic view for explaining multiple exposure based on double-beam interference and ordinary exposure, according to the present invention.

Figure 83 is a schematic view of an example of circuit pattern which can be produced in accordance with the present invention.

Figure 84 is a schematic view of another example of circuit pattern which can be produced in accordance with the present invention.

Figure 85 is a schematic view for explaining pupil filters usable in the present invention.

Figure 86 is a schematic view for explaining light intensity distribution upon a pupil plane, in the present invention.

Figure 87 is a schematic view of a light pattern on a photosensitive substrate, provided by four-beam interference in accordance with the present invention.

Figure 88 is a schematic view for explaining multiple exposure based on four-beam interference and ordinary exposure, in accordance with the present invention.

Figure 89 is a schematic view of an example of pattern, which can be produced by the four-beam interference and ordinary exposure in the present invention.

Figure 90 is a schematic view for explaining exposure amount setting in a multiple exposure process according to the present invention.

Figures 91A and 91B are schematic views, respectively, for explaining defocus characteristics a pattern produced in accordance with the multiple exposure process of the present invention.

Figures 92A and 92B are schematic views, respectively, similarly for explaining defocus characteristics a pattern produced in accordance with the multiple exposure process of the present invention.

Figure 93 is a flow chart of device manufacturing processes according to an embodiment of the present invention.

Figure 94 is a flow chart of a wafer process, in the procedure of Figure 93.

Figure 95 is a schematic view for explaining another example of exposure amount setting for a positive type resist, in a multiple exposure method according to a further embodiment of the present invention.

Figures 96A - 96D are schematic views, respectively, for explaining pattern defocus characteristic the multiple exposure process, according to an embodiment of the present invention.

## DESCRIPTION OF THE PREFERRED EMBODIMENTS

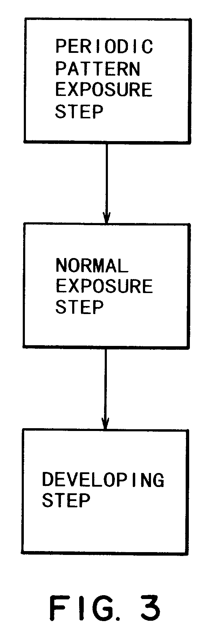

Figure 3 is a flow chart of exposure apparatus according to an embodiment of the present invention. Figure 3 shows the flow of blocks for (i) a periodic pattern exposure step wherein exposure of a resist is performed with an image of high contrast (high contrast image), according to an important feature of this embodiment, (ii) an ordinary exposure step wherein exposure of the resist is performed by an image of a mask having such a circuit pattern that the exposure amount distribution becomes low in contrast when conventional method is used, and (iii) a developing step for developing the resist to which dual exposure by the above-described two steps has been made. It is to be noted that the order of periodic pattern exposure step and the ordinary exposure step in Figure 3 may be reversed. Alternatively, they may be made simultaneously. If the procedure comprises triple exposure or more than triple exposure in which one of the periodic pattern exposure and the ordinary exposure includes plural exposure steps, the periodic pattern exposure and the ordinary exposure may be made alternately. A precise alignment step, for example, is interposed between these exposure steps, although not shown in the drawing. The periodic pattern exposure or the ordinary exposure step may be performed by use of a step-and-repeat type or step-and-scan type projection exposure apparatus.

The mask for ordinary exposure has plural patterns which are different from each other with respect to linewidth or orientation. The circuit pattern with which the exposure amount distribution on the resist through multiple exposure is a fine pattern, among the plural patterns, having a smallest linewidth and whose image has lowest contrast.

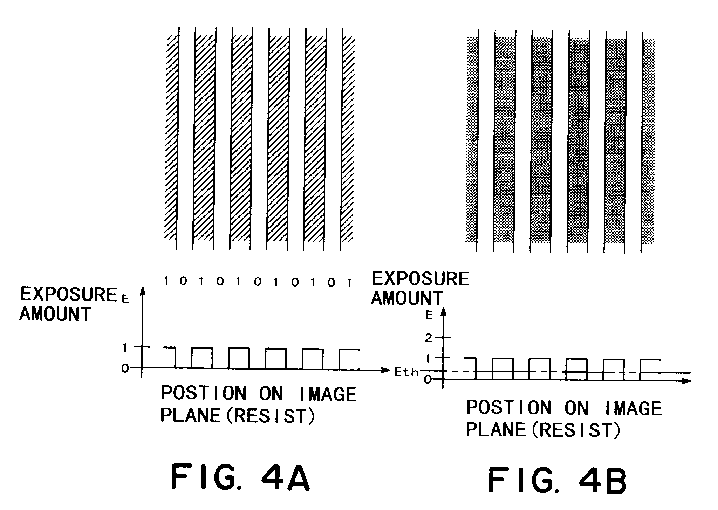

When multiple exposure is to be done in accordance with the flow of Figure 3, first a resist of a wafer (photosensitive substrate) is exposed with a periodic pattern image such as shown in Figure 4A. Numerals in Figure 4A denote exposure amounts. Figure 4A shows an image of a periodic pattern of a mask, wherein blank portions correspond to portions (i.e., shadow) with which the resist is not exposed (sensitized). Hatched portions correspond to portions (i.e., light) with which the resist is exposed. The exposure amount is assumed as zero (0) at the blank portions and as 1 at the hatched portions. What illustrated in Figure 4A may be deemed as the pattern of the mask itself. If a resist is exposed only with such periodic pattern and, without multiple exposure, it is developed, the relation between the exposure amount by the image of periodic pattern and the exposure threshold of the resist is usually set so that the resist exposure threshold $E_{th}$ (limit value with which the resist film thickness after development becomes zero) comes between exposure amounts 0 and 1 as shown in the graph at the bottom of Figure 4B. Upper half of Figure 4B shows in plan view a lithography pattern (surface step pattern) finally obtainable after development of the resist, having been exposed with the image of Figure 4A. One of the blank portion and hatched portion corresponds to protrusion of the surface step while the other corresponds to groove.

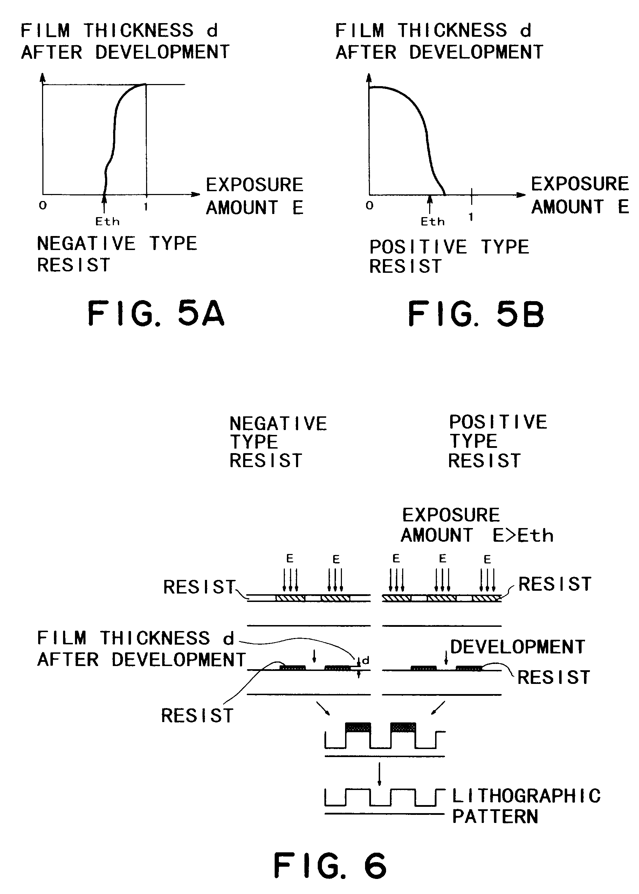

Figures 5A and 5B show exposure amount dependency of the resist film thickness after development as well as the exposure threshold, in cases of positive type wafer resist and negative type resist, respectively. The resist film thickness becomes zero with exposure amount not less than the exposure threshold, in the case of positive type resist, and with exposure amount not more than the exposure threshold, in the case of negative type resist.

Figure 6 is a schematic view for explaining, with respect to negative type resist (at upper left in the drawing) and positive type resist (at upper right), formation of a lithography pattern as a result of exposure described above and after development and etching process.

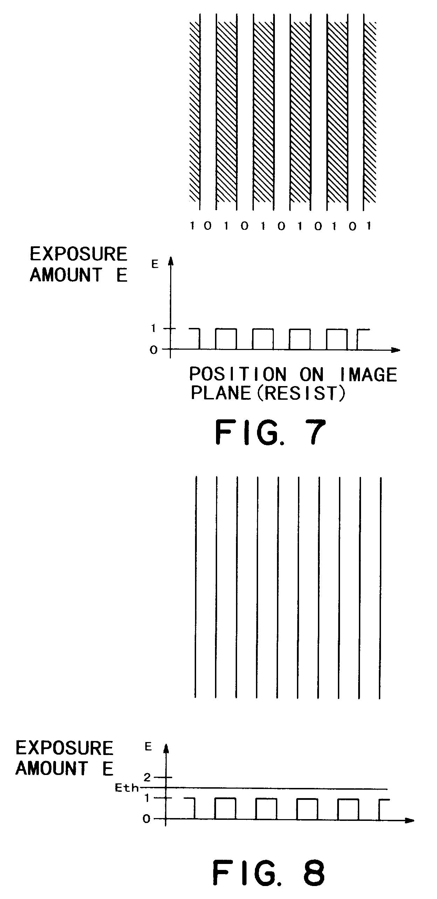

In dual exposure method of this embodiment, as compared with ordinary exposure sensitivity setting in Figures 4 - 6, if largest exposure amount in the periodic pattern exposure (first step in Figure 3) with which an image of high contrast is provided is assumed as being 1, the exposure threshold $E_{th}$ of the resist of the wafer (photosensitive substrate) is set to be larger than 1 (see the bottom of Figure 8). Here, if the resist exposure pattern (exposure amount distribution) resulting from only exposure with the periodic pattern image (Figure 7) is developed, due to insufficient exposure amount, there is produced no portions of zero film thickness, after development, although there may be small resist film thickness variation. Thus, no lithography pattern (surface step) is produced on the wafer by etching. This can be regarded as disappearance of periodic pattern recorded on the resist in latent image. Although the present invention will be described with reference to negative type resist, the present invention is usable with positive type resist. Top portion of Figure 8 shows in plan view of a lithography pattern obtainable by exposure with periodic pattern image only (although there are plural narrow lines drawn, practically they do nothing). The graph at the bottom shows the relation between exposure amount distribution on the resist in this exposure and the exposure threshold $E_{th}$.

An important feature of this embodiment resides in that, due to multiple exposure, the exposure pattern ($E_1$) by the periodic pattern image including a fine and high-contrast image (which might otherwise disappear only through the periodic pattern exposure at the first step of Figure 3) and the exposure pattern ($E_2$) by an image of circuit pattern of an arbitrary shape including a pattern of a size not greater than the resolving power of the exposure apparatus, are mixed with each other, and, as a result of which only a desired region of the resist is exposed with exposure amount ($E_1+E_2$) not less than the resist exposure threshold $E_{th}$), such that a desired lithography pattern corresponding to the circuit pattern of desired shape is finally produced. What is important in this mixture is a pattern, among the circuit pattern, having a smallest linewidth. A high contrast image is well superposed on the position of a pattern image, only by which an exposure amount distribution of desired contrast is not attainable with the exposure thereof.

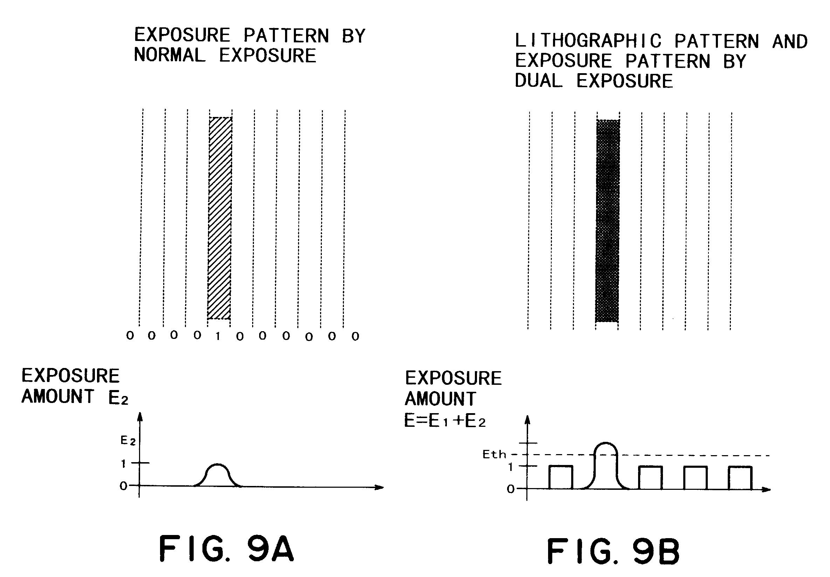

Figure 9A shows an exposure pattern of a resist resulting from the ordinary exposure described above. It is a pattern, of the circuit pattern to be projected on the wafer, having a smallest linewidth. It comprises exposure amount distribution on the resist by an image of a pattern which is not resolved because the pattern is a fine pattern less than the resolution of the projection exposure apparatus. Clearly, the produced exposure amount distribution is blurred and expanded.

The pattern on the mask, having a smallest linewidth, which provides the exposure pattern of Figure 9A may be a fine pattern having a linewidth a half of the linewidth resolvable by the projection exposure apparatus, that is, the linewidth by which desired contrast is obtainable. The mask pattern includes, in addition to such fine pattern, various patterns of various linewidths resolvable.

When ordinary exposure of a circuit pattern, providing a blurred exposure pattern of Figure 9A, is performed before (or after or simultaneously) the periodic pattern exposure of Figure 7 by which a sharp fine exposure pattern can be produced, superposedly to the same region (same position) on the same resist without intervention of development process, the total exposure amount distribution on that region of the resist will be such as shown in the graph at the bottom of Figure 9B. Here, the ratio between the exposure amount $E_1$ by the high contrast image through the periodic pattern exposure and the exposure amount $E_2$ by the blurred image of the ordinary exposure is set to 1:1, and also the resist exposure threshold $E_{th}$ is set to in the range of the sum $E_1+E_2$ (=2) of the exposure amount $E_1$ (=1) by the periodic pattern exposure and the exposure amount $E_2$ (=1) by the ordinary exposure. Therefore, when the wafer to which the dual exposure of this embodiment has been made is developed, a lithography pattern such as shown at the top of Figure 9B is produced. In this procedure, the center of the blurred exposure pattern by the ordinary exposure and the peak of the sharp exposure pattern by the periodic pattern exposure should be registered with each other. The isolated line pattern shown in the plan view of the lithography pattern at the top of Figure 9B has resolution (i.e., linewidth) similar to a lithography pattern to be produced by periodic pattern exposure. Thus, a pattern of very small linewidth above the resolution of ordinary projection exposure is accomplished, by this dual exposure. On the other hand, among the pattern printed by this ordinary exposure, a pattern having a relatively large linewidth in the range of resolution of the exposure apparatus, other than one having smallest linewidth, the contrast of exposure amount distribution of which can be improved by the dual exposure, provides an image of good contrast.

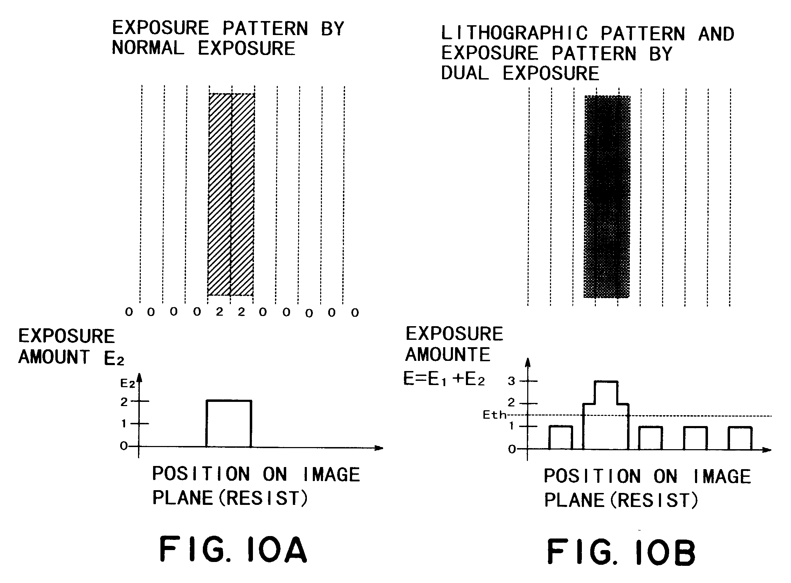

If the ordinary exposure for producing an exposure pattern by a pattern image of large linewidth shown in Figure 10 (i.e., projection exposure effective to produce exposure amount distribution not less than the exposure threshold $E_{th}$ (here, exposure amount twice the threshold) and with a linewidth twice the exposure pattern of Figure 7) is performed after the periodic pattern exposure of Figure 7 without development process, superposedly upon the same region (position) on the same resist, and if the center of the exposure pattern by the ordinary exposure is in registration with the center or peak of the exposure pattern by the periodic pattern exposure, the produced combined image or combined exposure pattern has good symmetry. Thus, a good combined image or combined exposure pattern can be produced. If so or not so, however, the combined exposure pattern on the resist, that is, the total exposure amount distribution will be such as shown in the graph at the bottom of Figure 10B, for example. After development, the exposure pattern by the periodic pattern exposure disappears and, finally, only the lithography pattern by ordinary exposure such as shown at the top of Figure 10B is formed.

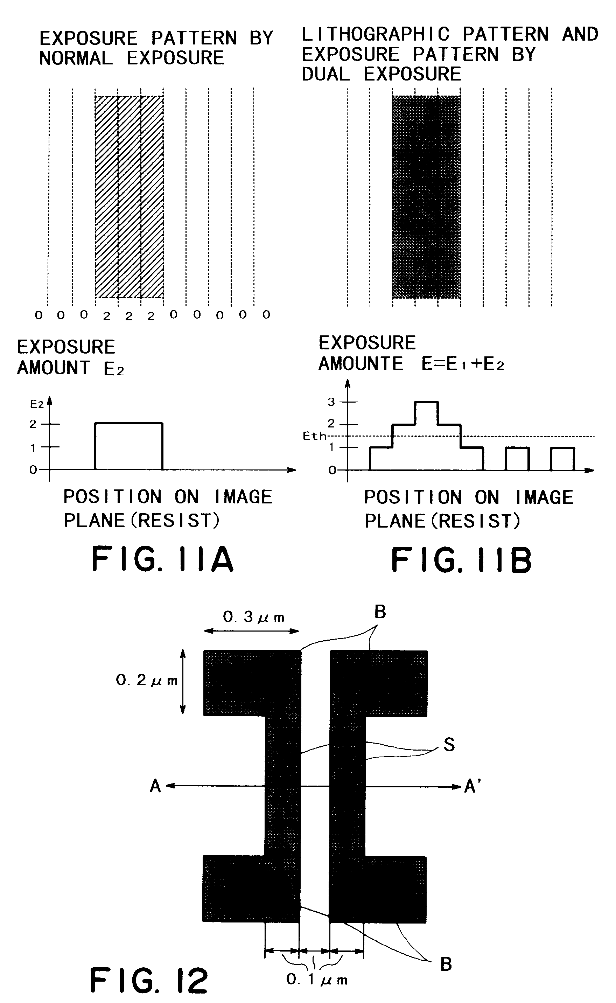

Also in a case of a circuit pattern, as the exposure pattern of Figure 11A, which may result in an exposure pattern resolvable at high contrast at linewidth three times the linewidth of the exposure pattern of Figure 7, or in a case of a circuit pattern (not shown) which may result in an exposure pattern resolvable at high contrast at linewidth four times the linewidth of the exposure pattern of Figure 7, like the case of Figure 10 only a lithography pattern based on ordinary exposure is formed (Figure 10B) after development even though dual exposure is performed. Thus, even by dual exposure comprising periodic pattern exposure and ordinary exposure using a mask having plural patterns different in linewidth as producing exposure pattern of Figure 8 and exposure pattern of Figure 8 or 9, a lithography pattern finally obtainable can be exactly defined in shape just corresponding to the circuit pattern of the mask, including its linewidth. Therefore, various lithography patterns obtainable through projection exposure, for example, can be formed with the dual exposure method of this embodiment of the present invention.

By adjusting exposure amount distribution (absolute value and distribution) to be provided by the periodic pattern exposure comprising high contrast image and the ordinary exposure including low contrast image corresponding to a pattern of smallest linewidth, as well as by adjusting the threshold $E_{th}$ of the resist of the photosensitive substrate, a circuit pattern can be formed on the wafer which circuit pattern may comprise a combination of various patterns such as shown in Figures 8, 9B, 10B and 11B and which may have a smallest linewidth (resolution) similar to that of an exposure pattern obtainable through simple periodic pattern exposure (as the pattern of Figure 9B).

The principle of dual exposure in this embodiment described above can be summarized as follows.

(1) An exposure pattern formed in a region by periodic pattern exposure with a maximum exposure amount not greater than the exposure threshold $E_{th}$, to which region the ordinary exposure is not performed, disappears as a result of development.

(2) As regards the exposure pattern region (exposure region) of ordinary exposure to which an exposure amount not greater than the resist exposure threshold $E_{th}$ is supplied to the resist, an exposure pattern having resolution the same as the periodic pattern exposure which is determined by the combination of exposure patterns by respective ordinary exposure and periodic pattern exposure, can be formed in that region.

(3) As regards the exposure pattern region (exposure region) of ordinary exposure to which an exposure amount not less than the resist exposure threshold $E_{th}$ is supplied to the resist, an exposure pattern having the same resolution as the exposure pattern by ordinary exposure which is determined by the exposure patterns by respective ordinary exposure and periodic pattern exposure, can be formed in that region.

Additionally, there is a further advantage in the dual exposure method of this embodiment that, when the periodic pattern exposure to which highest resolution is required is performed on the basis of double-beam interference exposure using a phase shift type reticle, for example, a depth of focus remarkably larger than that by imaging of a periodic pattern through ordinary projection exposure can be provided.

As regards the order of periodic pattern exposure and ordinary exposure, while the former is made first in the foregoing description, the order may be reversed or they may be performed simultaneously.

Next, a second embodiment of the exposure method of the present invention will be described.

In this embodiment, a circuit pattern (lithography pattern) to be produced by exposure concerns what can be called a gate pattern such as shown in 12. Thus, for a mask to be used in ordinary exposure, a mask with a circuit pattern having analogous shape as the pattern of Figure 12 may be used.

The gate pattern of Figure 12 has a smallest linewidth of 0.1 micron in the direction A-A' in the drawing, but it has a smallest linewidth of 0.2 micron or more in the longitudinal direction, which is within the range of resolution by ordinary exposure. In accordance with this embodiment of the present invention, as regards s two-dimensional pattern having a smallest linewidth pattern portion S with respect to which high resolution is required only in one-dimensional direction (lateral direction), periodic pattern exposure based on double-beam interference exposure, for example, is performed only with respect to the one-dimensional direction in which high resolution is required. Reference character B in the drawing denotes pattern portions having a relatively large linewidth.

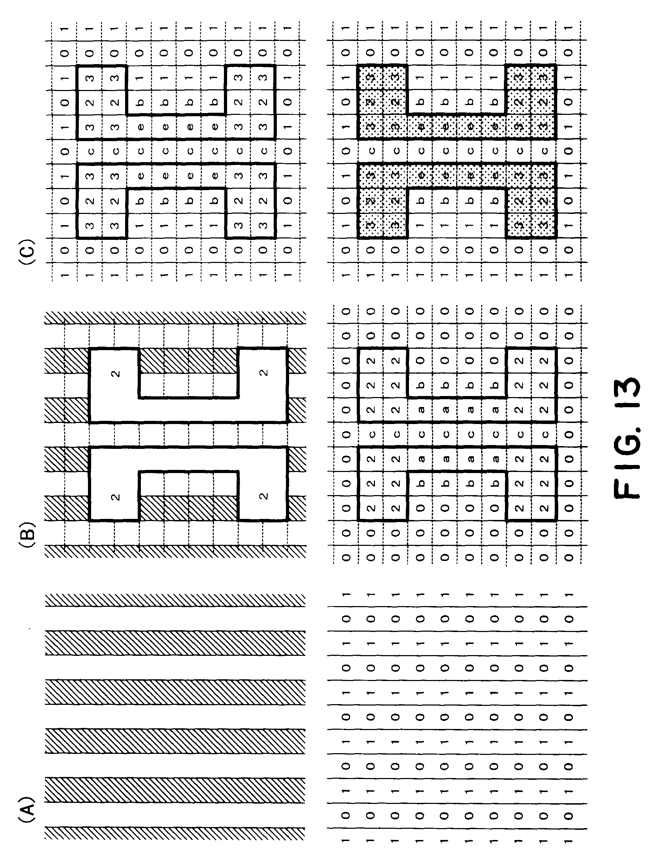

Referring to Figure 13, the procedure of dual exposure using the same exposure wavelength and based on a combination of one-dimensional periodic pattern exposure and ordinary exposure of a gate pattern which cannot be resolved only by ordinary exposure, will be explained.

Figure 13 at (A) is a plan view of a periodic exposure pattern to be produced by double-beam interference exposure in which a repetition pattern is formed with respect to a one-dimensional direction. This exposure pattern has a period of 0.2 micron, and this exposure pattern corresponds to a line-and-space pattern of 0.1 micron linewidth of each line and space. Numerical values at the bottom of Figure 13 denote exposure amounts upon the resist.

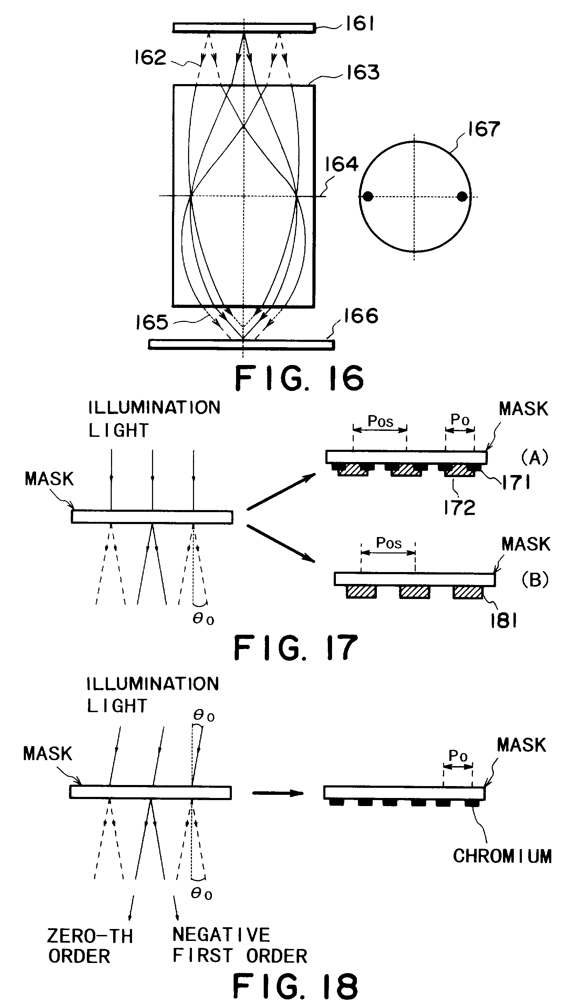

An exposure apparatus for accomplishing the periodic pattern exposure through such double-beam interference, may be one shown in Figure 2 and having a laser 151, a half mirror 152 and a flat mirror 153, or a projection exposure apparatus shown in Figure 16 wherein the mask and the illumination light is arranged such as shown in Figure 17 or 18. Of course, the projection exposure apparatus shown in Figure 16, 17 or 18 may be used for ordinary exposure.

The exposure apparatus of Figure 2 will now be explained in detail.

In the exposure apparatus of Figure 12, as described hereinbefore, two light beams to be combined are obliquely incident on the wafer 154 at an incidence angle $\theta$, whereby interference fringe (image) is formed on the resist of the wafer 154. The linewidth of the interference fringe formed on the wafer 154 can be expressed by equation (3) mentioned hereinbefore. The relation between the angle $\theta$ and the image plane side NA of the wave dividing and combining optical system is $NA = \sin\theta$. The angle $\theta$ can be changed as desired by changing angles of the paired flat mirrors 153, respectively. If the angle $\theta$ of these flat mirrors is made large, the linewidth of each fringe of the interference fringe pattern becomes smaller. For example, in a case where the wavelength (exposure wavelength) of the two light beams is 248 nm (KrF excimer laser), use of an angle $\theta$ of 38 deg. enables formation of an interference fringe pattern having dark and bright fringes of about 0.1 micron linewidth. In this case, $NA = \sin\theta = 0.62$. If the angle $\theta$ is made larger than 38 deg., interference fringe of narrower linewidth can be formed and, therefore, higher resolution is attainable.

Next, an exposure apparatus shown in Figures 16 - 18 will be explained.

The exposure apparatus of Figure 16 is a step-and-repeat type or step-and-scan type projection exposure apparatus having a reduction projection optical system (comprising a number of lenses) for projecting a circuit pattern of a reticle onto a wafer in reduced scale. In this type of exposure apparatuses, currently an image side NA not less than 0.6 with respect to an exposure wavelength 248 nm is available.

Denoted in Figure 16 at 161 is a mask (reticle), and denoted at 162 is object side exposure light emitted from the mask 161 and entering an optical system 163. Denoted at 163 is a projection optical system, and denoted at 164 is an aperture stop. Denoted at 165 is image side exposure light emitted from the projection optical system 163 and impinging on a wafer 166. Denoted at 166 is a wafer which is a photosensitive substrate. Denoted at 167 is a pupil plane which corresponds to a circular opening of the stop 164. The positions thereon of the two light beams are depicted by a pair of dots. Figure 16 is a schematic view of the exposure apparatus when it is set to an exposure mode for periodic pattern exposure. Thus, each the object side exposure light 162 and the image side exposure light 165 comprises two parallel light ray beams without a light ray beam parallel to the optical axis, as compared with those of ordinary exposure in Figure 1.

In order to perform double-beam interference exposure through a projection exposure apparatus such as shown in Figure 16, a mask and an illumination method therefor may be so set as shown in Figure 17 or 18. Referring to Figures 17 and 18, three examples of combination of mask and illumination method therefor will be explained.

Figure 17 at (A) shows a Levenson type phase shift mask. As illustrated at a left-hand portion of Figure 17, this mask may be illuminated perpendicularly. For example, this mask may comprise a mask having light blocking portions 171 of chromium of a pitch $P_O$ which can be expressed by equation (4) and phase shifters 172 of quartz of a pitch $P_{OS}$ which can be expressed by equation (5).

$$P_0 = \lambda/(M \cdot 2NA) \tag{4}$$

$$P_{OS} = 2P_0 = \lambda/(M \cdot NA) \tag{5}$$

wherein M is the projection magnification of the projection optical system 163, $\lambda$ is exposure wavelength and NA is image side numerical aperture of the projection optical system 163.

On the other hand, the mask shown in Figure 17 may comprise a shifter edge type phase shift mask having no light blocking portion of chromium. As shown in the left-hand portion of Figure 17, also this mask may be illuminated perpendicularly. Similarly to the Levenson type phase shift mask, this mask has phase shifters 181 of quartz of a pitch $P_{OS}$ which satisfies equation (5) above. The masks shown at (A) and (B) both include a substrate made of quartz.

In order to perform double-beam interference exposure using a phase shift mask shown in Figure 17 at (A) or (B), the mask may be illuminated in accordance with coherent illumination wherein $\sigma = 0$ (or a value close to zero) or with small $\sigma$ partial coherent illumination wherein $\sigma \leqq 0.3$. More specifically, the stop with circular opening in the illumination optical system for illuminating the mask may be changed by replacing a stop for ordinary mask (this being for large $\sigma$ coherent illumination with $\sigma \geqq 0.6$) by a small $\sigma$ stop for phase shift mask described above, and illumination light is projected to the mask surface in a direction perpendicular thereto (i.e., in a direction parallel to the optical axis).

When the phase shift mask is so illuminated as above, there is no zero-th order transmissively diffractive light emerging from the mask in the perpendicular direction because a phase difference $\pi$ is applied to adjacent transmissive lights from the phase shifter so that they cancel with each other. On the other hand, there are produced two parallel light ray beams ($\pm$ first order transmissively diffractive lights) from the mask which are symmetrical with each other with respect to the optical axis of the projection optical system 163. These light beams (object side exposure light 165) interfere with each other on the wafer 166 to produce interference fringe (image) thereupon. Diffractive light of second order or higher does not enter the opening of the aperture stop 164 of the projection optical system 163, and therefore it does not contribute to imaging.

The mask shown in Figure 18 may comprise a mask having light blocking portions of chromium of a pitch $P_O$ which can be expressed by equation (6) similar to equation (4), for example, and it may be illuminated in a direction inclined by an angle $\theta_0$ with respect to the optical axis of the projection optical system 163.

$$P_O = \lambda/(M \cdot 2NA) \tag{6}$$

wherein M is the projection magnification of the projection optical system 163, $\lambda$ is exposure wavelength and NA is image side numerical aperture of the projection optical system 163.

A mask having no phase shifter such as shown in Figure 18 may be illuminated along an oblique direction by one or two parallel light ray fluxes by which two light fluxes for interference fringe formation can be produced. In that occasion, the incidence angle $\theta_0$ of the illumination light upon the mask may be set to satisfy equation (7), for example. In an idealistic case, the mask may be illuminated with a pair of parallel light ray fluxes inclined symmetrically with respect to a symmetry plane, containing the optical axis, and oppositely by an angle $\theta_0$.

$$\sin\theta_0 = M{\cdot}NA \qquad\qquad (7)$$

wherein M is the projection magnification of the projection optical system 163, and NA is image side numerical aperture of the projection optical system 163.

When oblique illumination is performed to the mask having no phase shifter shown in Figure 18, from the mask there are produced two light fluxes of zero-th order transmissively diffractive light which advances straight with an angle $\theta_0$ with respect to the optical axis and negative first order transmissively diffractive light which advances along a light path symmetrical with the light path of the zero-th order transmissively diffractive light with respect to the optical axis (i.e., advancing with an angle $-\theta_0$ with respect to the optical axis). These two light beams provide two object side exposure lights 162 shown in Figure 16. These two light beams enter the opening of the aperture stop 164 of the projection optical system 163, such that the repetition pattern of chromium is imaged thereby. The thus formed image comprises interference fringe.

In this specification, such oblique incidence illumination by parallel light fluxes is also referred to "coherent illumination".

What is described above concerns the procedure for performing double-beam interference exposure by use of a projection exposure apparatus. On the basis of this procedure, a periodic exposure pattern such as shown in Figure 13 at (A) can be produced. Since the illumination optical system 192 of the projection exposure apparatus shown in Figure 1 is structured to perform partial coherent illumination with σ is about 0.6, the optical arrangement may be changed by, for example, interchanging the aperture stop (not shown) of σ of about 0.6 in the illumination optical system 192 of Figure 1 by a small σ aperture stop corresponding to σ ≦ 0.3, by which small partial coherent illumination or substantially coherent illumination can be performed within the projection exposure apparatus.

Referring back to the second embodiment shown in Figures 12 and 13, in this embodiment, before of after the periodic pattern exposure based on double-beam interference exposure described above, ordinary exposure through mask projection is made (e.g., partial coherent illumination with σ of about 0.6 may be made to the mask by using the apparatus of Figure 1). By this, a gate pattern illustrated as blank portions in Figure 13 at (B) is printed. Upper portion at (B) of Figure 13 illustrates the relative positional relation between the gate pattern (image) for dual exposure and the periodic pattern (image) resulting from double-beam interference exposure, as well as exposure amount at the mask by the gate pattern to be projected. Lower portion illustrates exposure amounts to the wafer resist by the gate pattern image through ordinary exposure, being mapped in terms of longitudinal and lateral resolution of 0.1 micron pitch.

Minimum linewidth portion (pattern image) of the image of this gate pattern through the projection exposure is not resolved and is blurred. Thus, the contrast is low and exposure amounts at points in this portion are lowered. As regards the exposure amount by this pattern image of low contrast, when it is considered with respect to the central portion of the pattern image and peripheral portions at opposite sides of the central portion, separately, and where the exposure amounts at the central portion and the peripheral portion are denoted by $\underline{a}$ and b and the exposure amount at a portion between pattern images to which blurred images are coming from the opposite sides is denoted by C, then there are provided relations in exposure amount that 1<a<2, 0<b<1 and 0<C<1. Thus, there is produced an exposure amount distribution in which regions of the gate pattern image have different exposure amounts. The exposure amount ratio of respective exposures in dual exposure process using a mask having such gate pattern, upon the mask (resist), may be 1:2 ("periodic pattern exposure" vs. "ordinary exposure), for example.

Next, formation of a gate pattern (fine circuit pattern) of Figure 12 based on combination of periodic pattern exposure and ordinary exposure, will be explained in greater detail. In this embodiment, there is no development process performed between the periodic pattern exposure based on double-beam interference exposure and the ordinary exposure based on projection exposure. Therefore, exposure amounts at each point in the region where exposure patterns by respective exposures are superposed, are accumulated and, after the accumulation, a separate exposure pattern (exposure amount distribution) is produced. Development process will be made to this exposure pattern. In the thus produced separate exposure pattern, the contrast of the exposure amount distribution related to a smallest linewidth pattern portion of the gate pattern is improved as a result of the dual exposure, and the exposure amount there is above the resist exposure threshold (to be described later).

Figure 13 at (C) shows in its upper portion the exposure pattern (exposure amount distribution) to be produced as a result of accumulation of the exposure pattern at (A) of Figure 13 and the exposure pattern at (B) of Figure 13, being accumulated by dual exposure. The exposure amount at regions e is 1+a which is larger than 2 and smaller than 3. Lower portion at (C) in Figure 13 shows a surface step pattern (depicted by blank and hatching) produced as a result of a development process to the exposure pattern shown in the upper portion at (C) of Figure 13. In this embodiment, the resist of a wafer used has an exposure threshold which is larger than 1 and smaller than 2. Therefore, as a result of development, only such portion as having exposure amount greater than 1 appears as the surface step pattern 12.

The shape and size of the pattern depicted by blank and hatching in the lower portion at (C) of Figure 13 corresponds to those of the gate pattern shown in Figure 12. Thus, in accordance with the exposure method of this embodiment, a gate pattern (circuit pattern) having plural pattern portions B and C of different linewidths, including a very small linewidth of 0.1 micron, can be produced on the basis of dual exposure as described above, by use of a projection exposure apparatus having an illumination optical system in which two types of masks are interchangeably usable and in which large σ partial coherent illumination and one of coherent illumination and small σ partial coherent illumination can be interchangeably performed, with use of the same exposure light (exposure wavelength).

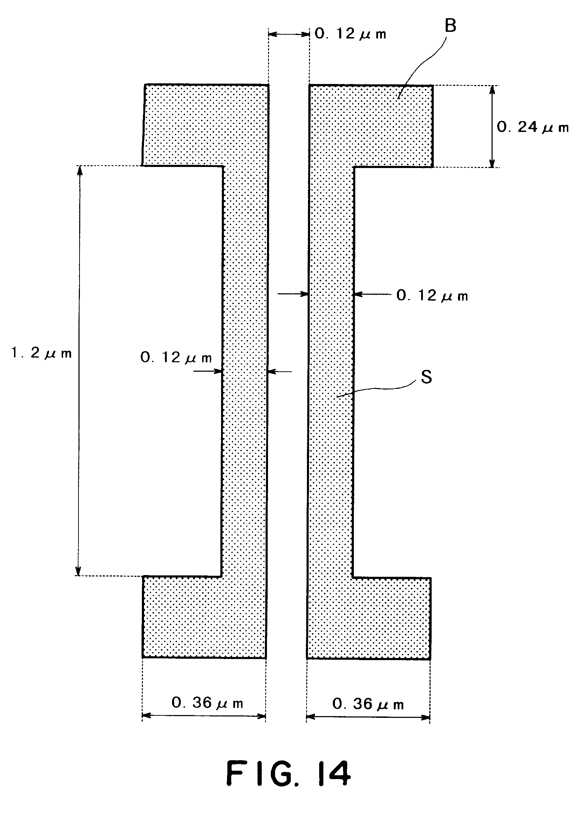

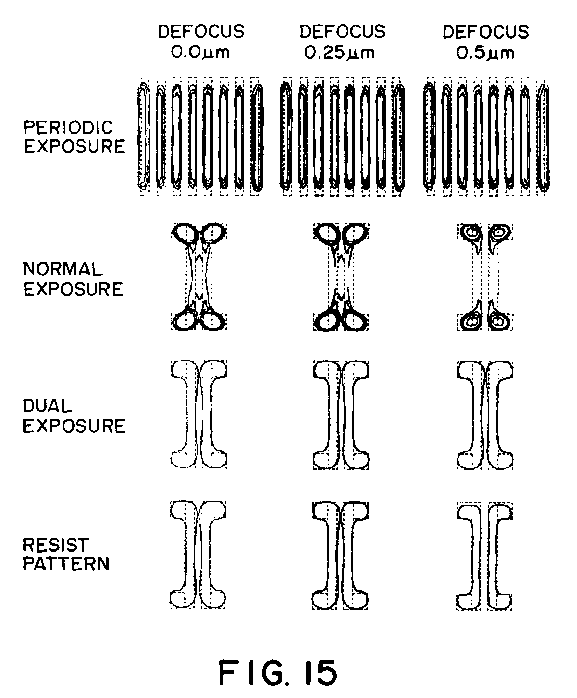

Figures 14 and 15 illustrate examples of what can be obtained by dual exposure of the second embodiment, by use of a stepper (projection exposure apparatus) having a light source of KrF excimer laser which produces laser light of wavelength $\lambda$ = 248 nm. A resist of a wafer may be exposed with an image of a gate pattern shown in Figure 14, having a smallest linewidth 0.12 micron. Without performing development thereafter, a Levenson type phase shift mask may be used to print an image of interference fringe of high contrast superposedly upon the same exposure position of the gate pattern image on the resist, so that bright portions of the interference fringe are registered with the image of smallest linewidth pattern portions of the gate pattern. Exposure condition therefor will be described below, in detail.

The projection lens may have a NA of 0.3 and, as regards the illumination system, it may be arranged so that it performs perpendicular illumination with σ = 0.3 for the periodic pattern exposure using a Levenson type phase shift mask and also that it performs oblique illumination for ordinary exposure using a mask with gate pattern, by use of light from a ring-like secondary light source (a light source at or adjacent a light exit surface of an optical integrator) having σ = 0.8 at the ring outside diameter and σ = 0.6 at the inside ring diameter for providing ring-like illumination. The exposure amount may be so set that the exposure amount by the ordinary exposure is twice the exposure amount by the periodic pattern exposure.

In Figure 15, the topmost row illustrates exposure amount distributions on wafer resist to be provided by interference fringe (image) by periodic pattern exposure. The second row illustrates exposure amount distributions on the resist by a gate pattern image by ordinary exposure. The third row illustrates exposure amount distributions to be provided by dual exposure comprising periodic pattern and projection exposure. The fourth row illustrates surface step patterns (resist patterns) to be formed on the wafer as a result of resist development.

In each row, illustrations are made to exposure amount distribution and surface step pattern, in regard to cases of a defocus amount 0.0 micron of the wafer with respect to the focus position of the projection optical system, a defocus amount of 0.2 micron and a defocus amount of 0.5 micron, respectively.

As illustrated at the second row of Figure 15, with a single projection exposure process, a good contrast and fine gate pattern image is not obtainable due to blur. However, by superposing a high contrast image of the periodic pattern at the first row of Figure 15 onto the exposure position defined on the resist by projection exposure, also the fine gate pattern image portion (image of the smallest linewidth pattern S) is improved in contrast and can be resolved as illustrated at the third row of Figure 15. A surface step pattern corresponding to a desired gate pattern such as shown at the fourth row of Figure 15 was practically produced.

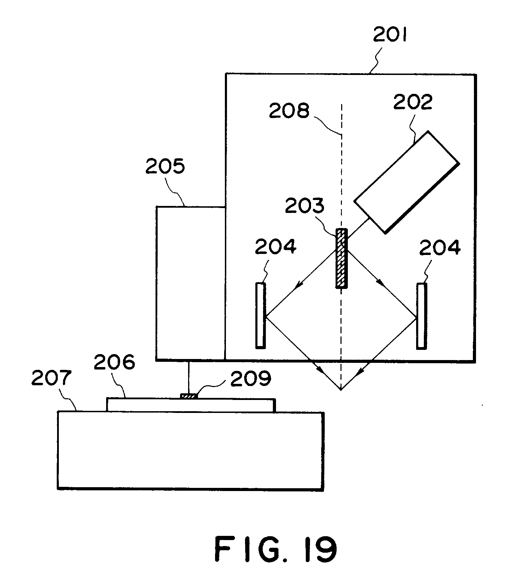

Figure 19 is a schematic view of an example of exposure apparatus for double-beam interference exposure, which is able to perform periodic pattern exposure in the multiple exposure method according to the present invention. Denoted in Figure 19 at 201 is a wave separating and combining optical system for double-beam interference, and the basis structure thereof is similar to that of the optical system of Figure 2. Denoted at 202 is a KrF excimer laser (wavelength of about 248 nm) or a ArF excimer laser (wavelength of about 193 nm). Denoted at 203 is a half mirror, and denoted at 204 is a flat mirror. Denoted at 205 is an off-axis type alignment optical system having a positional relation with the optical system 202 completely held fixed or being able to detect that positional relation as a base line (length) appropriately. This alignment optical system is operable to observe an alignment mark 209 on a wafer 206 to detect the position thereof, for wafer autoalignment. Denoted at 207 is an X-Y-Z stage which is movable along an X-Y plane perpendicular to the optical axis of the optical system 201 and along the optical axis direction (Z direction). The position of this stage with respect to the X and Y directions can be controlled precisely by using a laser interferometer (not shown), for example. Since the structures and functions of these devices 205 and 207 are well known in the art, detailed description therefor will be omitted.

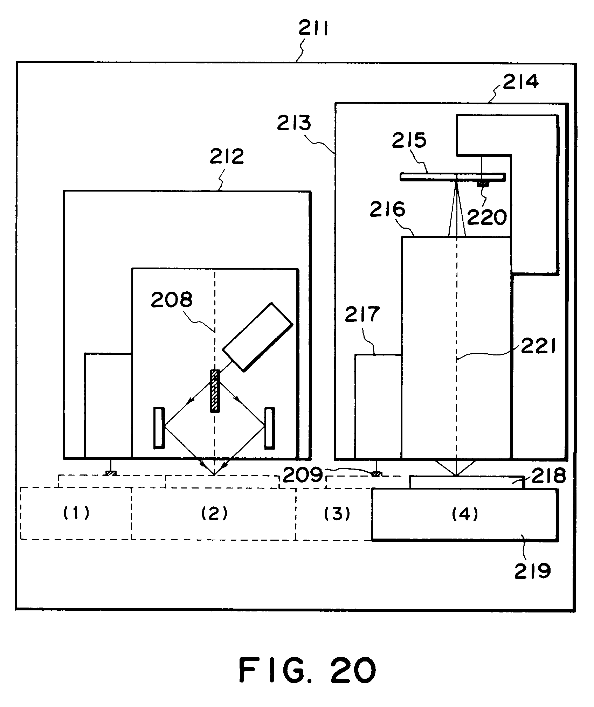

Figure 20 is a schematic view of a high resolution exposure system which comprises a double-beam interference exposure apparatus for periodic pattern exposure and a projection exposure apparatus for ordinary exposure, for performing the exposure method according to the present invention.

Denoted in Figure 20 at 212 is a double-beam interference exposure apparatus which includes optical systems 201 and 205 shown in Figure 19. Denoted at 213 is an ordinary projection exposure apparatus which comprises an illumination optical system (not shown), a reticle alignment optical system 214, an off-axis alignment optical system 217 for wafer alignment, and a projection optical system 216 for projecting a circuit pattern of a mask 215, such as shown in Figure 14, for example, onto a wafer 218 in reduced scale. The illumination optical system (not shown) of the exposure apparatus 213 is operable to perform large σ illumination, like the projection exposure apparatus used in the second embodiment described hereinbefore, and it can provide ring-like illumination of $\sigma = 0.6$ at the inside ring diameter and $\sigma = 0.8$ at the outside ring diameter.

The reticle alignment optical system 214 is operable to observe an alignment mark 220 on the mask 215 to detect the position thereof, for reticle autoalignment. The wafer alignment optical system 217 is operable to observe an alignment mark 209 on the wafer 206, both for projection exposure and double-beam interference exposure, to detect the position thereof to perform wafer autoalignment. Since the structures and functions of these optical systems 214, 216 and 217 are well known in the art, detailed description therefor will be omitted.

Denoted at 219 in Figure 20 is a single X-Y-Z stage which is used both in the double-beam interference exposure apparatus 212 and in the projection exposure apparatus 213. The stage 219 is movable along a plane perpendicular to the optical axes 208 and 221 of these exposure apparatuses 212 and 213 and along the optical axis direction. The position of the stage with respect to X and Y directions can be controlled precisely by using a laser interferometer, for example.

The stage 219 having a wafer 218 held thereon is moved into the position (1) in Figure 20, the the position of the wafer 218 thereat is measured accurately. On the basis of the result of measurement, the wafer 218 is moved into the exposure position in the exposure apparatus 212 whereat double-beam interference exposure (periodic pattern exposure) is made to the wafer 218. Thereafter, it is moved into the position (3) in Figure 20, whereat the position of the wafer 218 is measured accurately. Then, it is moved into the exposure position in the exposure apparatus 213, as depicted at position (4), whereat projection exposure (ordinary exposure) is performed to the wafer 218.

In the exposure apparatus 213, the off-axis alignment optical system 217 may be replaced by a TTL alignment optical system (not shown) for observing an alignment mark of the wafer 218 through the projection optical system 216 to detect the position thereof, or a TTR alignment optical system (not shown) for observing an alignment mark of the wafer 218 through the projection optical system 216 and through the mask 215 to detect the position thereof.

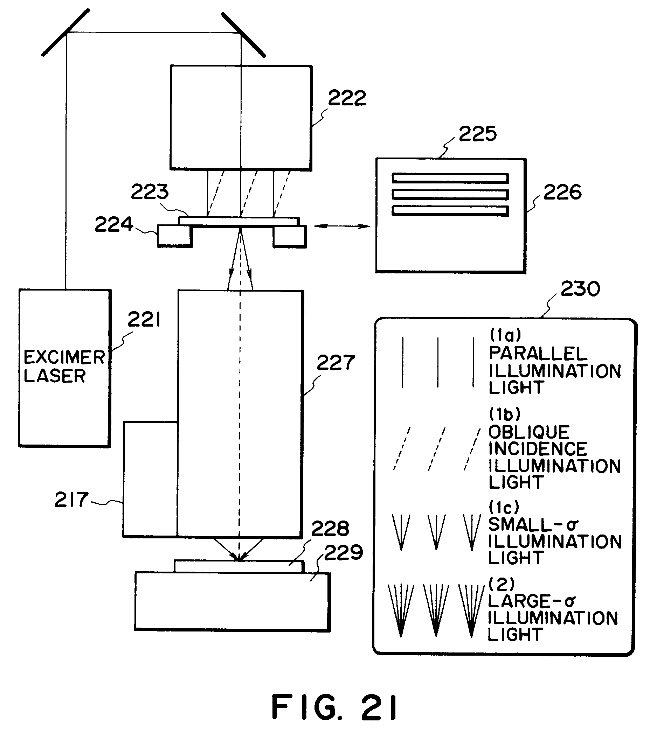

Figure 21 is a schematic view of a high resolution exposure apparatus which is able to perform both periodic pattern exposure (high contrast projection exposure), enabling the multiple exposure method of the present invention, and ordinary projection exposure (projection exposure of low contrast image or images of low and high contrasts mixed).

Denoted at 221 in Figure 21 is a KrF excimer laser (wavelength of about 248 nm) or ArF excimer laser (wavelength of about 193 nm), and denoted at 222 is an illumination optical system. Denoted at 223 is a mask, and denoted at 224 is a mask stage. Denoted at 227 is a projection optical system for projecting a circuit pattern of a mask 227 onto a wafer 228 in reduced scale. Denoted at 225 is a mask (reticle) changer for selectively supplying, to the stage 224, one of a mask having a circuit pattern as of Figure 14 formed thereon and a periodic pattern reticle without a circuit pattern, such as a Levenson type phase shift mask, an edge shifter type mask and a periodic pattern mask without phase shifter, for example. The periodic pattern reticle may be one having a certain type of circuit pattern formed at a position different from the periodic pattern.

Denoted at 229 in Figure 21 is a single X-Y-Z stage which is used both for periodic pattern exposure, based on double-beam interference exposure, and for ordinary exposure based on projection exposure. The stage 229 is movable along a plane perpendicular to the optical axis of the optical system 227 and along the optical axis direction. The position of the stage with respect to X and Y directions can be controlled precisely by using a laser interferometer, for example.

The exposure apparatus of Figure 21 comprises a reticle alignment optical system (not shown), and an off-axis alignment optical system 217 such as described with reference to Figure 20. In addition to this, the exposure apparatus includes a TTL alignment optical system and a TTR alignment optical system (both unshown). By using these alignment optical systems, alignment of the mask 223 and shot areas of the wafer 228 can be performed.

The illumination optical system 222 of the Figure 21 apparatus is structured so that large $\sigma$ partial coherent illumination and one of small $\sigma$ partial coherent illumination and coherent illumination can be performed interchangeably. For coherent illumination, illumination light (1a) or (1b) within block 230, such as having been described with reference to Figures 17 and 18, is supplied; whereas for small $\sigma$ partial coherent illumination, illumination light (1c) in block 230 is supplied, both to one of a Levenson type phase shift mask as described, an edge shifter type mask and a periodic chromium pattern mask without phase shifter. For large $\sigma$ partial coherent illumination, illumination light (2) in block 230 is supplied to a mask having a desired circuit pattern formed thereon. Changing from large $\sigma$ partial coherent illumination to small $\sigma$ partial coherent illumination may be made by replacing a stop with large aperture diameter normally disposed just after the fly's eye lens of the illumination optical system 222 by a coherent illumination stop having a sufficiently small aperture diameter as compared with the former. Here, large $\sigma$ refers to $\sigma \geqq 0.6$, and small $\sigma$ refers to $\sigma \leqq 0.3$. In place of illumination light (2) in block 230, ring-like illumination light described hereinbefore may be used.

Any one of the exposure methods and exposure apparatuses having been described above can be used for manufacture of various devices such as a semiconductor chip (e.g., IC or LSI), a display device (e.g., liquid crystal panel), a detector element (e.g., magnetic head), or an image pickup device (e.g., CCD), for example.

The present invention is not limited to the embodiments described above. Various modifications are possible within the scope of the present invention. Particularly, the number of exposures and levels of exposure amount in the periodic pattern exposure such as double-beam interference exposure and in the ordinary exposure may be selected as desired. Further, as regards superposition of exposure patterns, they may be superposed with a slight shift, for example. The selection and adjustment such as above enables enlargement of variation of circuit patterns to be produced.

Next, an example of exposure amount setting method according to the present invention will be described.

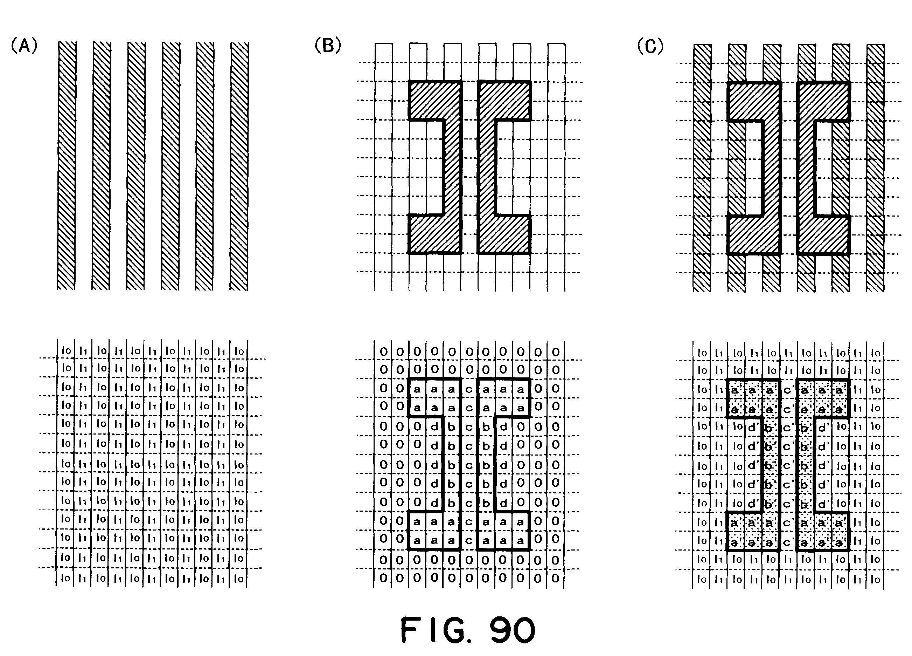

Figure 90 shows at its bottom portions the intensity distributions defined by exposures on a wafer.

The exposure amount distribution at (A) in Figure 90 results from exposure with a periodic pattern and, idealistically it comprises a rectangular wave of 1 and 0. However, since a linewidth near the resolution limit of double-beam interference exposure, it comprises a sine wave provided by zeroth order light and first order light. The maximum value of the sine wave is denoted by $I_0$, and the minimum is denoted by $I_1$. Here, depending on the $\sigma$ of illumination condition, the values of $I_0$ and $I_1$ are determined.

The exposure amount distribution at (B) of Figure 90 results from ordinary or standard exposure, and it shows representative values at respective portions. The smallest linewidth portion of this exposure pattern provided by projection exposure is not resolved but is blurred. Thus, the light intensities at these points are lowered. The exposure amount may be roughly separated into pattern central portions b, opposite side portions d, and central portions c where blurs are coming from the opposite sides. The linewidth twice the smallest linewidth is larger than the values of b, c and d. Since however it is a linewidth close to the resolution limit of projection exposure, it is slightly blurred and takes a value of a. These values a, b, c and d are variable in dependence upon the illumination condition.

The exposure amount at (C) of Figure 90 results from the addition of the exposure pattern at Figure 90(A) and the exposure pattern at Figure 90(B).

The light quantity ratio in exposures by double-beam exposure and projection exposure differs in dependence upon the illumination conditions in respective exposures. The light quantity ratio of exposures in the addition is determined as an illumination ratio of illumination system, and it may be expressed by:

"double-beam interference exposure" vs.

"projection exposure" = 1:k and the value k can be determined as follows.

The exposure amount distribution at (C) of Figure 90 can be expressed by using the above-described exposure amount distributions and light quantity ratios, and by using the following equations:

$$a' = k \times a + I_0$$

$$a'' = k \times a + I_1$$

$$b' = k \times b + I_0$$

$$c' = k \times c + I_1$$

$$d' = k \times d + I_1$$

In order to obtain a desired gate pattern, the following relations are given with respect to the sensitization threshold $I_C$ of a resist.

If, for example, the resist is negative type, it follows that:

$$a' > I_C$$

$$a'' > I_C$$

$$b' > I_C$$

$$c' < I_C$$

$$d' < I_C$$

Preferably, the values a', a" and b' have small differences, while particularly values c' and b' preferably have a large difference. By solving these formulae, optimum light quantity ratio of the respective illumination conditions can be determined. Particularly, the following two formulae related to a fine pattern are important.

For negative type resist:

$$k \times b + I_0 > I_C$$

$$k \times c + I_1 < I_C$$

For positive type resist:

$$k \times b + I_1 < I_C$$

$$k \times c + I_0 > I_C$$

In positive type resist, while the magnitude relation in the exposure amount distribution is inverted and the inequality symbol with the resist threshold $I_C$ is reversed, the optimum light quantity ratio can be determined similarly.

Combining two different illumination methods for the double-beam interference exposure and projection exposure described above, a fine circuit pattern such as shown in Figure 14 can be produced. This will be described below in detail.

In this embodiment, there is no developing process intervening between the double-beam interference exposure and ordinary projection exposure. Thus, in the region where exposure patterns of these exposures overlap, the exposure amounts are accumulated and, the cumulative exposure amount (distribution) defines a separate exposure pattern.

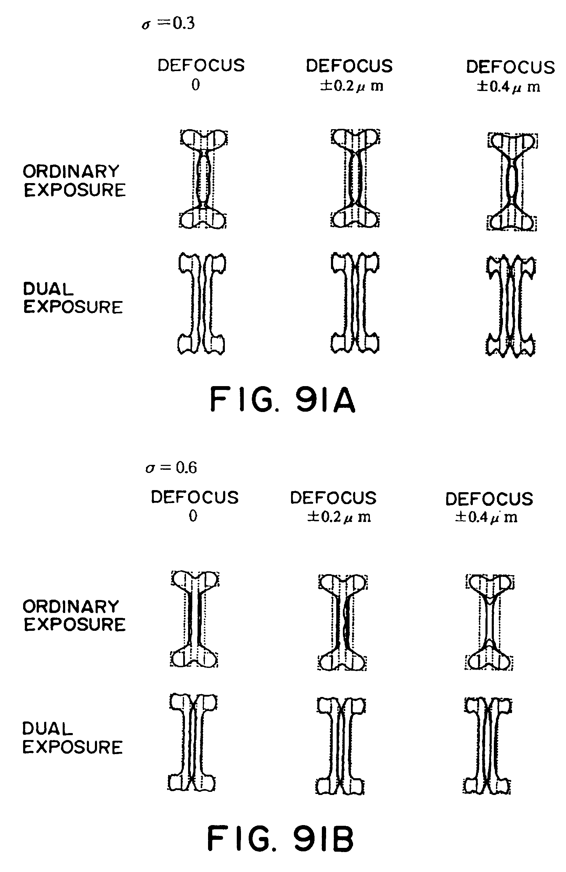

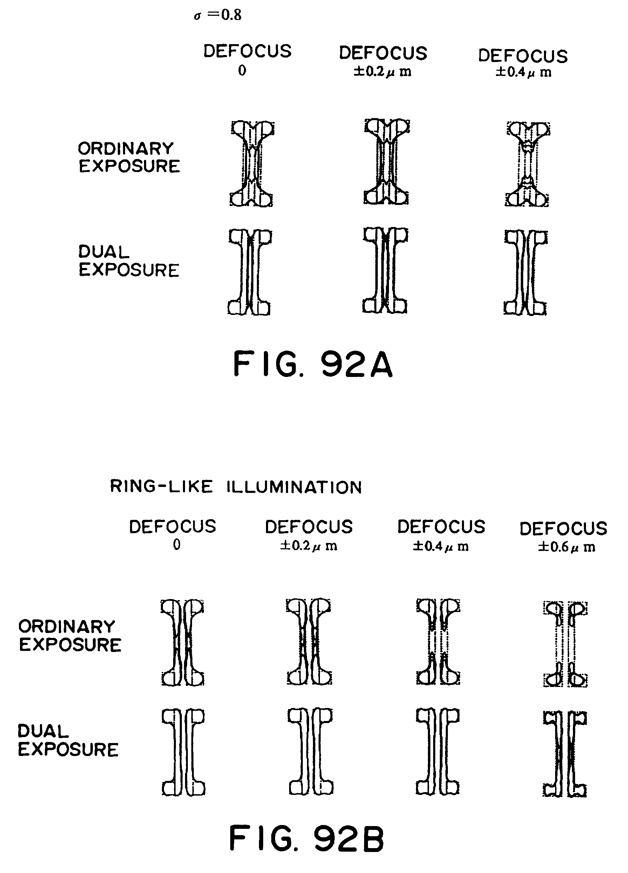

Figures 91A and 92A as well as Figures 92A and 92B show specific examples wherein a KrF excimer stepper of wavelength 248 nm is used.

More particularly, a gate pattern such as shown in Figure 14 and having a smallest linewidth 0.12 micron is printed by ordinary exposure and, in addition thereto, a Levenson type phase shift mask is used to print a periodic pattern superposedly upon its smallest linewidth.

A projection lens had a numerical aperture NA of 0.6, and σ of illumination system was 0.3 for the exposure using Levenson type mask. For ordinary mask exposure, the ring-like illumination method of σ = 0.3, 0.6 and 0.8 was adopted.

When exposure of a periodic pattern is performed in accordance with double-beam exposure using a phase shift mask, for example, coherent illumination may take a value of σ equal to zero or close to it. If the value is too small, the exposure amount per unit time decreases, causing prolongation of exposure time. It is not practicable.

For periodic pattern exposure, σ should preferably be not larger than 0.3. Thus, in Levenson mask exposure, it was at the maximum 0.3.

For ordinary exposure, generally partial coherent illumination is used. If σ is enlarged, the reproducibility of a complicated shape becomes better and the depth increases. This tendency is more notable in ring-like illumination method in which inside illuminance distribution is lower than the outside, but the contrast is disadvantageously lowered.

As shown in Figure 91A, if dual exposure is performed with ordinary exposure made under the same illumination condition of σ = 0.3 the same as that of the periodic pattern exposure, a gate pattern can be resolved in a defocus range of 0±0.2 micron. But, its line pattern portion is waved, and a narrow-width portion may unpreferably be a factor for breakage.

For ordinary pattern exposure, preferably σ should be not less than 0.6. As shown in Figure 91B, with σ of 0.6 in ordinary exposure, a gate pattern can be resolved in a defocus range of 0±0.4 micron, and waviness of line pattern portion is removed. The exposure amount ratio between ordinary exposure and periodic pattern exposure was 1.5:1 ("ordinary exposure" vs. "periodic pattern exposure").

As shown in Figure 92A, if σ of ordinary exposure is as large as 0.8, reproducibility of a complicated pattern is improved. The exposure amount ratio between ordinary exposure and periodic pattern exposure was 2:1 ("ordinary pattern exposure" vs. "periodic pattern exposure"). Preferably, for ordinary pattern exposure, the exposure amount may be twice or more of that of the periodic pattern exposure.

Figure 92B shows two-dimensional intensity distribution where ordinary exposure was made in accordance with ring-like illumination method, the intensity being illustrated while taking the illuminances from 0.6 at the ring inside to 0.8 at the outside as 1 and taking the illuminances less than 0.6 at the inside of the ring as 0. The exposure amount ratio between ordinary exposure and periodic pattern exposure was 2.5:1 ("ordinary exposure" vs. "periodic pattern exposure").

With ring-like illumination, the reproducibility of complicated shape becomes better as compared with a case of σ = 0.8, and also the depth is enlarged. A good image was produced with defocus not greater than ±0.4 micron.

As described above, a fine circuit pattern can be produced in accordance with dual exposure using periodic pattern exposure. Due to low light intensity and low contrast, usually a fine pattern of ordinary exposure pattern is not resolved. However, by combining and superposing it with periodic pattern exposure of high contrast, contrast is enhanced and therefore a fine pattern can be resolved.

On the other hand, as regards a large pattern larger than the resolution of ordinary exposure pattern, the intensity of periodic pattern exposure is superposed thereon and thus contrast is enriched. Therefore, with a width corresponding to a multiple of the linewidth of the periodic pattern exposure, an image of sharp edge can be produced. Thus, in accordance with the exposure method of this embodiment, a circuit pattern having a small linewidth as 0.12 micron can be produced by use of a projection exposure apparatus having an illumination optical system in which the illumination condition such as σ or light quantity ratio, for example, is made changeable.

As regards the light quantity ratio between the periodic pattern exposure and the ordinary exposure, an optimum value depending on the combination of illumination conditions, was determined in accordance with the formulae mentioned hereinbefore.

[Illumination Condition 1]

Periodic pattern exposure was made with σ = 0.3, while ordinary pattern exposure was made with σ = 0.3.

The exposure amount distribution provided by periodic pattern exposure shown at bottom of Figure 90(A) and the exposure amount distribution (best focus) provided by ordinary projection exposure shown at bottom of Figure 90 (B) are as follows.

$$I_0 = 0.80$$

$$I_1 = 0.23$$

$$a = 1.31$$

$$b = 0.34$$

$$c = 0.61$$

$$d = 0.09$$

$$k = 1.0$$

This is optimum. Then,

$$a' = 2.11$$

$$a'' = 1.54$$

$$b' = 1.21$$

$$c' = 0.89$$

and

$$d' = 0.32$$

are obtained. For comparison, the maximum of a' may be standardized with respect to 1, and the following may result:

$$a' = 1.0$$

$$a'' = 0.73$$

$$b' = 0.57$$

$$c' = 0.42$$

$$d' = 0.15$$

$$I_0 = 0.38$$

[Illumination Condition 2]

Periodic pattern exposure was made with $\sigma = 0.3$, while ordinary pattern exposure was made with $\sigma = 0.6$.

$$I_0 = 0.80$$

$$I_1 = 0.23$$

$$a = 1.25$$

$$b = 0.44$$

$$c = 0.53$$

$$d = 0.13$$

$$k = 1.5$$

This is optimum. Then,

$$a' = 2.68$$

$$a'' = 2.11$$

$$b' = 1.46$$

$$c' = 1.03$$

and

$$d' = 0.43$$

are obtained. For comparison, the maximum of a' may be standardized with respect to 1, and the following may result:

$$a' = 1.0$$

$$a'' = 0.79$$

$$b' = 0.55$$

$$c' = 0.38$$

$$d' = 0.16$$

$$I_0 = 0.30$$

[Illumination Condition 3]

Periodic pattern exposure was made with $\sigma = 0.3$, while ordinary pattern exposure was made with $\sigma = 0.8$.

$$I_0 = 0.80$$

$$I_1 = 0.23$$

$$a = 1.20$$

$$b = 0.48$$

$$c = 0.47$$

$$d = 0.16$$

$$k = 2.0$$

This is optimum. Then,

$$a' = 3.20$$

$$a'' = 2.63$$

$$b' = 1.76$$

$$c' = 1.17$$

and

$$d' = 0.55$$

are obtained. The maximum of a' may be standardized with respect to 1, and the following may result:

$$a' = 1.0$$

$$a'' = 0.82$$

$$b' = 0.55$$

$$c' = 0.37$$

$$d' = 0.17$$

$$I_0 = 0.25$$

[Illumination Condition 4]

Periodic pattern exposure was made with $\sigma = 0.3$, while ordinary pattern exposure was made with $\sigma = 0.8$ in ring-like illumination. The illuminance distribution at the inside (ring inside) not greater than 0.6 was zero.

$$I_0 = 0.80$$

$$I_1 = 0.23$$

$$a = 1.10$$

$$b = 0.47$$

$$c = 0.36$$

$$d = 0.19$$

$$k = 2.5$$

This is optimum. Then,

$$a' = 3.55$$

$$a'' = 2.98$$

$$b' = 1.98$$

$$c' = 1.13$$

and

$$d' = 0.71$$

are obtained. The maximum of a' may be standardized with respect to 1, and the following may result:

$$a' = 1.0$$

$$a'' = 0.84$$

$$b' = 0.56$$

$$c' = 0.32$$

$$d' = 0.20$$

$$I_0 = 0.23$$

In the foregoing examples, the resist threshold is 1.5 with a largest exposure amount of 3. Standardizing it with respect to the largest exposure amount, the resist threshold is 0.5.

Examining the thus standardized exposure amount distribution, it is seen that values a', a'' and b' are larger than the standardized resist threshold 0.5 while values c', d' and $I_0$ are smaller than the threshold.

After development process, a portion with its exposure amount larger than the resist threshold remains. Therefore, only a portion with exposure amounts of a' and b' remain after the developing process. Thus, the gray portion at bottom of Figure 90(C) corresponds to the shape remaining after the developing process.

Generally, for exposure of an ordinary exposure pattern, an exposure amount of about twice the exposure amount for exposure of a periodic pattern is proper. There is an optimum exposure amount ratio depending upon the combination of illumination condition for exposure of ordinary exposure pattern and illumination condition for exposure of periodic pattern. It can be determined in accordance with the formulae described hereinbefore.

Calculating various combinations of illumination conditions on the basis of the above-described formulae, it has been confirmed that, in a case where σ is 0.3 for periodic pattern exposure and where the illumination condition σ for ordinary pattern exposure is smaller than 0.8, a good result is obtainable with an exposure amount not greater than twice the exposure amount for periodic pattern exposure.

If σ = 0.3 for periodic pattern and the illumination condition for ordinary pattern exposure is based on ring-like illumination, and if the width of ring is small, the exposure amount for ordinary pattern may preferably be not smaller than twice of the exposure amount for periodic pattern exposure.

If the illumination condition σ for periodic pattern exposure is smaller than 0.3, the exposure amount for ordinary pattern exposure may preferably be twice or more of the exposure amount for periodic pattern exposure.

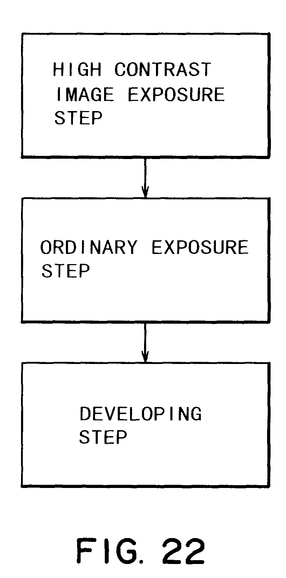

Referring to Figures 22 - 26H, an exposure method according to another embodiment of the present invention will be described.

Figure 22 is a flow chart for explaining the exposure method according to this embodiment. The flow chart of Figure 22 illustrates processes and flow of a high-contrast image exposure step (of the exposure method of the present invention), an ordinary or standard exposure step (which may be performed by projection exposure, for example), and a developing step. In Figure 22, the sequence of the high-contrast image exposure and ordinary exposure may be reversed, or they may be performed simultaneously. If one of these exposure processes includes plural exposures (i. e., multiple exposures more than twice), the high-contrast image exposure and the ordinary exposure may be performed alternately. Between these exposure processes, a step for precise alignment may intervene, although not shown in the drawing.

When the procedure shown in Figure 22 is to be done while performing the high-contrast image exposure by using a phase shift mask having no light blocking portion, first a resist of a wafer is exposed with a mask M such as in Figure 23A, by which a high contrast image can be printed. Denoted in this drawing at 1 is a substrate made of quartz, and denoted at 2 is a phase shifter made of quartz.

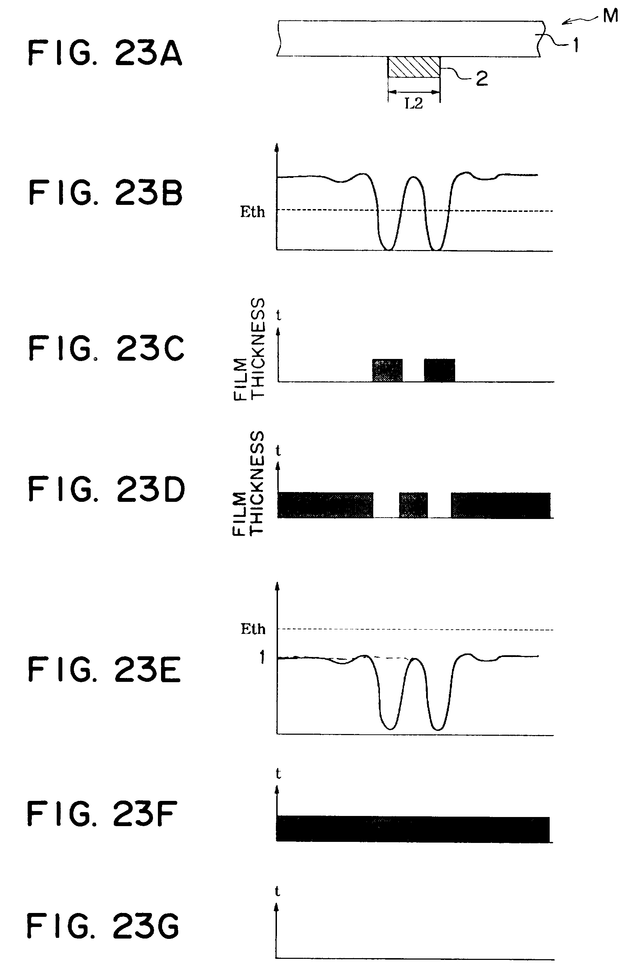

Figure 23A shows an example of phase type mask M having a function for applying a phase difference to lights which pass through two adjacent regions, without a light blocking portion. It has a phase shifter 2 of a thickness effective to produce a change of phase by 180 deg. (±30 deg.) in the light passing there, as compared with light passing another region around it (mask pattern). Figure 23B shows exposure amount distribution produced by exposing the resist by projecting the pattern 2 of the phase shift mask M of Figure 23A with use of a projection exposure apparatus such as shown in Figure 21, for example. If the phase shifter 2 is superposed on the exposure amount distribution on the wafer of Figure 23B while taking into account the reduction magnification of the projection optical system, the exposure amount distribution is a distribution having a maximum at the center of the phase shifter 2 and having minimums at positions corresponding to the edges of the phase shifter 2. If the linewidth $L_2$ of the phase shifter is close to the resolution limit as determined by NA of the projection optical system, the exposure amount distribution at the central portion having the maximum value is a distribution close to a sine wave, as shown in Figure 23B. On the other hand, there are small decreases at the opposite sides of the whole exposure amount distribution, which correspond to the intensity distribution of subsequent period.

When the resist having been exposed only with the pattern of the phase shifter 2 is developed and if the wafer resist threshold $E_{th}$ is set as shown in Figure 23B, a resist pattern having two linear protrusions such as shown in Figure 23C can be produced with use of a positive type resist, while a resist pattern having two linear grooves such as shown in Figure 23D can be produced.

In this embodiment, however, the exposure sensitivity setting (exposure threshold $E_{th}$) shown in Figure 23B is not used but, as shown in Figure 23E, the resist exposure threshold $E_{th}$ for the wafer (photosensitive substrate) is set larger than 1 when the center exposure amount in the high contrast image exposure is taken as 1. In this case, the exposure pattern (exposure amount distribution) provided only by exposure with the phase shifter 2 pattern of Figure 23A has insufficient exposure amount and, therefore, as a result of development, no zero-thickness portion is produced though there is small film thickness variation. Consequently, no lithography pattern (surface level difference pattern) is formed on the wafer. This can be regarded as disappearance of pattern.

Figure 23F shows the result of development in a case where a positive type resist is used in this example, and Figure 23G shows the result in a case where a negative type resist is used.

An important feature of this embodiment resides in that multiple exposure is performed by which (i) an exposure pattern of high resolution and high contrast which might disappear only through the exposure thereof and (ii) an exposure pattern of arbitrary shape having plural patterns of different linewidths (including a pattern of low contrast and of a size smaller than the resolution of an ordinary projection exposure apparatus so that it can not be resolved by exposure thereof), are mixed with each other, and, as a result of this, only a desired region of the resist is exposed with exposure amount not less than the resist exposure threshold $E_{th}$, such that a desired lithography pattern corresponding to the exposure pattern (mask pattern) of desired shape described above is finally produced.

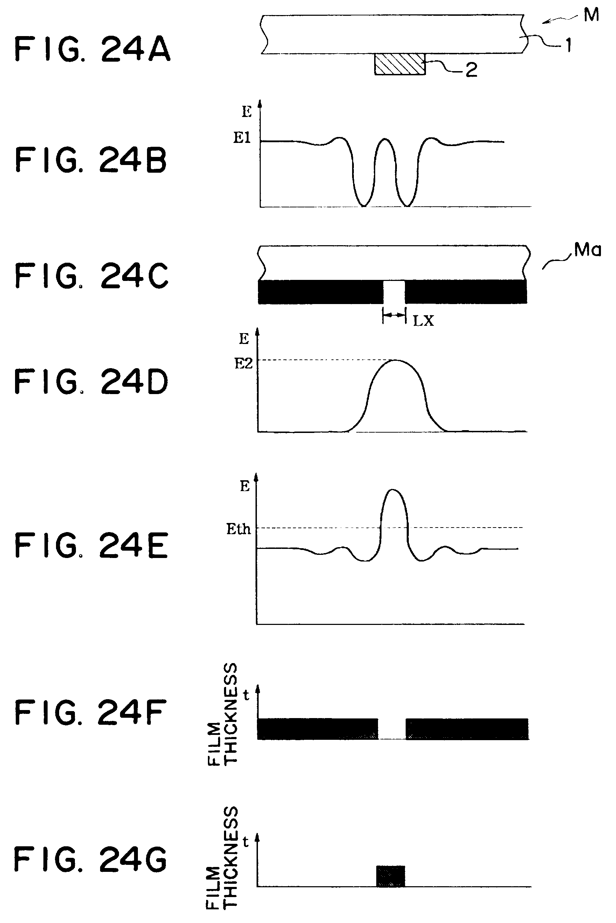

Referring to Figures 24A - 24G, an exposure method for an isolated line pattern (image) will be described. Figure 24A shows a phase type mask M having a mask pattern such as shown in Figure 23A, and Figure 24B shows exposure amount distribution on a wafer resist provided by projection exposure using this phase type mask.

Figure 24C shows a mask Ma having a circuit pattern to be used for projection exposure corresponding to the ordinary exposure step in Figure 22. Since this circuit pattern of the mask Ma is a very fine pattern smaller than the resolution of the projection exposure apparatus, the pattern of linewidth $L_X$ can not be resolved and, therefore, the produced intensity distribution of the pattern image formed on the wafer is blurred and expanded, as shown in Figure 24D. The contrast is low. Through exposure with such low contrast image, the resultant exposure distribution on the resist will be such as shown in Figure 24D. Even if the exposure threshold $E_{th}$ is lower than the exposure amount $E_2$, a resist pattern with fine protrusions or grooves of a linewidth corresponding to the linewidth $L_X$ of the mask Ma can not be produced.

In this embodiment, the fine pattern of the mask Ma has a linewidth of about a half of the linewidth (resolution) which can be resolved by the projection exposure apparatus.

The linewidth of the pattern of the mask Ma may be in a range of 1/2 - 1/4 of the resolution of the projection exposure apparatus.

When ordinary exposure for exposing a resist with a fine pattern of the mask Ma of Figure 24C, is performed after the exposure with high contrast image using the phase type mask M of Figure 24A, superposedly to the same region on the same resist by using the same exposure wavelength and by using a separate mask, without intervention of development process, the total exposure amount distribution on that region of the resist provided by such dual exposure will be such as shown in Figure 24E where the distributions of Figure 24B and 24D are combined. Here, the ratio between the exposure amount $E_1$ by exposure with the high contrast image of the phase shifter 2 of the mask M and the exposure amount $E_2$ by ordinary exposure with the pattern of the mask Ma is set to 1:1. Also, the resist exposure threshold $E_{th}$ is set in the range between the exposure amount $E_1$ (=1) and the sum (=2) of the exposure amount $E_1$ and the exposure amount $E_2$.

Therefore, a lithography pattern such as shown in Figure 24F can be produced when a positive type resist is used, while a lithography pattern such as shown in Figure 24G can be produced when a negative type resist is used. In this procedure, the center of the exposure pattern by the phase type mask M of Figure 24A and the maximum value position (peak) of the exposure pattern by the pattern of the mask Ma of Figure 24C should be placed in registration with with each other, upon the resist.

The isolated line lithography pattern shown in Figure 24F or 24G and provided by the dual exposure method of this embodiment, has its resolution determined by the exposure with the phase type mask. Also, there is no unnecessary pattern. Thus, a pattern of very small linewidth above the resolution of ordinary projection exposure is accomplished, by this dual exposure.

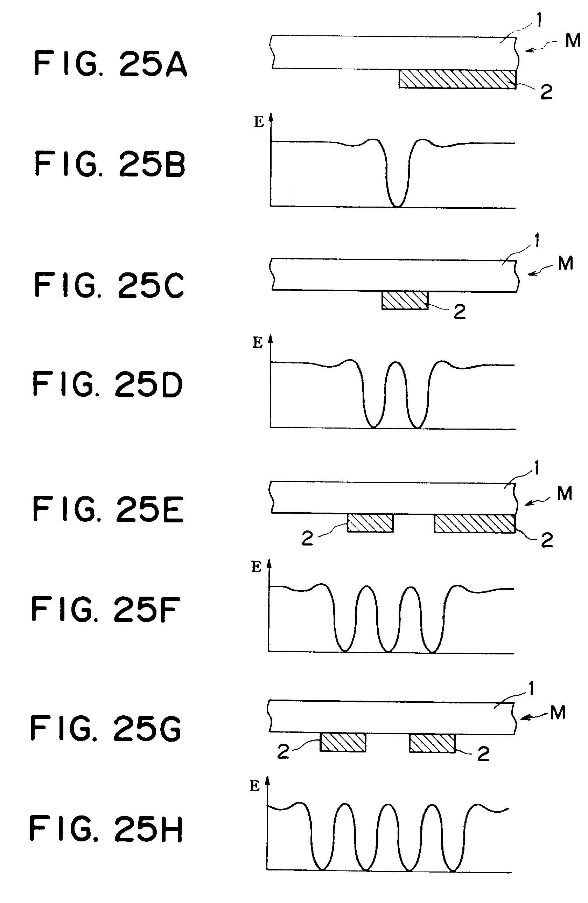

Referring to Figures 25A - 25H, examples of structure of phase shifter when a high contrast image (high contrast exposure pattern) is to be produced by use of a phase type mask M as well as exposure amount distributions corresponding to these examples and to be provided on a wafer (resist) will be described. In these drawings, areas with hatching denote phase shifters.

Figure 25A is a sectional view of a mask with a single edge only. It provides an exposure amount distribution on a wafer, such as shown in Figure 25B. This corresponds to a pattern of single black stripe. Figure 25C shows the sectional structure of a mask M with an isolated pattern as described above. It functions to provide an exposure distribution on a wafer resist, such as shown in Figure 25D, which corresponds to a pattern with two black stripes and a single white stripe between them. Figure 25E is a sectional view of the structure of a mask M having phase shifters effective to produce an exposure amount distribution corresponding to a pattern with three black stripes and two white stripes between them. An exposure amount distribution such as shown in Figure 25F is produced on the wafer resist. Figure 25G is a case where the number is enlarged, and it shows the sectional structure of a mask M effective to produce an exposure amount distribution corresponding to a pattern having four black stripes and three white stripes between them. Figure 25H shows an exposure amount distribution corresponding to this.

In this embodiment, a resist of high $\gamma$ is used for the wafer and the wafer resist is exposed with a high contrast image of the pattern of phase shifter of a phase mask M. After this, the same position on the resist having been exposed with the high contrast image is again exposed with a mask pattern having plural patterns of different linewidths (including a line-and-space pattern of a very small linewidth not resolvable) in accordance with ordinary exposure process and by using the same exposure wavelength. The wafer thus dual exposed is then treated by a developing process, at a predetermined exposure threshold $E_{th}$, whereby a circuit pattern having a small linewidth pattern corresponding to the mask pattern is produced. It is to be noted that the largest exposure amounts in exposure amount distributions of Figures 24B and 24D are less than the exposure threshold.

The principle of dual exposure method in this embodiment described above can be summarized as follows.

(1) An exposure pattern formed in a region by exposure with a high contrast image at a maximum exposure amount not greater than the exposure threshold $E_{th}$, to which region the ordinary exposure is not performed, disappears as a result of development.

(2) As regards the exposure pattern region (exposure region) of ordinary exposure in which an exposure amount not greater than the resist exposure threshold $E_{th}$ is applied to the resist, an exposure pattern having resolution the same as the exposure pattern provided by the high contrast image exposure, which is determined by the combination of exposure patterns by respective ordinary exposure and high contrast image exposure, can be formed in that region.

(3) As regards the exposure pattern region (exposure region) of ordinary exposure in which an exposure amount not less than the resist exposure threshold $E_{th}$ is applied to a resist, an exposure pattern having the same resolution as the exposure pattern by ordinary exposure which is determined by the exposure patterns by respective ordinary exposure and periodic pattern exposure, can be formed in that region.

Additionally, there is a further advantage in the dual exposure method of this embodiment that, with respect to an exposure pattern of highest resolution, a depth of focus remarkably larger than that by ordinary exposure can be provided.

As regards the order of high contrast image exposure and ordinary exposure using a mask pattern image including a low contrast image and a high contrast image, while the former is made first in the foregoing description, the order may be reversed or they may be performed simultaneously.

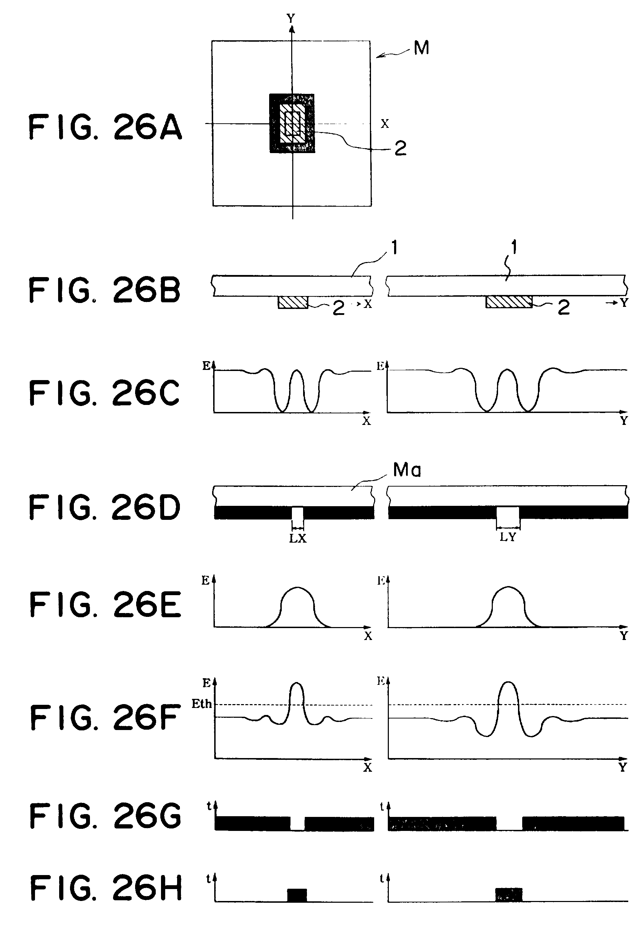

Next, an embodiment for producing a two-dimensional isolated pattern such as contact holes upon a wafer, will be described. Figures 26A - 26H illustrate the manner of forming such two-dimensional isolated pattern.

Figure 26A is a plan view of a phase type mask M for forming a high contrast image as a ground, and a corresponding exposure amount distribution on a wafer. A portion with hatching as denoted at 2 in the drawing corresponds to a phase shifter 2 for shifting the phase of light passing therethrough by 180 deg. as compared with light passing through another region. Around the edge of the phase shifter 2 where the phase shift occurs, the exposure amount decreases. The decreased exposure amount region outside the phase shifter edge is depicted by a gray screen, while the decreased exposure amount region inside the phase shifter edge is illustrated by a square solid line on the mask in superposition.

Figures 26B - 26H show sections of a portion of a phase type mask M effective to produce a high contrast image and of a portion of a mask Ma having a circuit pattern with plural patterns of different linewidths effective to produce a low contrast image and a high contrast image, as well as corresponding exposure amount distributions, wherein those related to X-axis direction are shown at the left-hand side while those related to Y-axis direction are shown at the right-hand side. More specifically, Figure 26B shows sections of the mask M along X direction and Y direction, respectively. Figure 26C shows exposure amount distribution upon the resist having been exposed with a high contrast image of the mask M, with respect to the X-axis and Y-axis sections, respectively. Since the phase shifter (pattern) 2 of the mask M has a width in Y-axis direction larger than the width in X-axis direction thereof, the exposure amount distribution in the Y-axis section has a shape similar to the shape of the exposure amount distribution in the X-axis section if the latter is expanded.

Figure 26D shows sections of the opening of the mask Ma to be projected in ordinary exposure, with respect to X-axis and Y-axis directions, and this opening has sizes $L_X$ and $L_Y$. The sizes $L_X$ and $L_Y$ are smaller than the resolution of the exposure apparatus and, therefore, they are not resolved only by ordinary exposure. Thus, the image of this opening of the pattern Ma is blurred, and the exposure amount distribution on the resist is expanded both in X-axis section and Y-axis section, as shown in Figure 26E. The total exposure amount distribution corresponding to accumulation of exposure amount distributions provided by exposures using the two masks M and Ma, corresponds to combination of distribution of Figure 26C and distribution of Figure 26E, and it is such as shown in Figure 26F. If the exposure threshold $E_{th}$ is set as shown in Figure 26F, a resist pattern after development process will be such as shown in Figure 26G, in the case of positive type resist. The resist pattern after development process will be such as shown in Figure 26H, in the case of negative type resist. In these cases, a very fine isolated pattern not attainable with ordinary projection exposure can be produced. The maximum exposure amounts in exposure amount distributions of Figures 26C and 26E are lower than the exposure threshold $E_{th}$.

A further embodiment of the present invention will be described. This embodiment is directed to a gate pattern shown in Figure 12, for example, as a circuit pattern (lithography pattern) to be produced by exposure.

The gate pattern shown in Figure 12 will be described here again. The gate pattern of Figure 12 has a smallest linewidth of 0.1 micron in a lateral direction, i.e., a direction A-A' in the drawing, but it has a smallest linewidth of 0.2 micron or more in the longitudinal direction. In accordance with this embodiment of the present invention, as regards a two-dimensional pattern with respect to which high resolution is required only in one-dimensional direction (direction A-A'), high contrast image exposure may be performed only with respect to the one-dimensional direction in which high resolution is required.

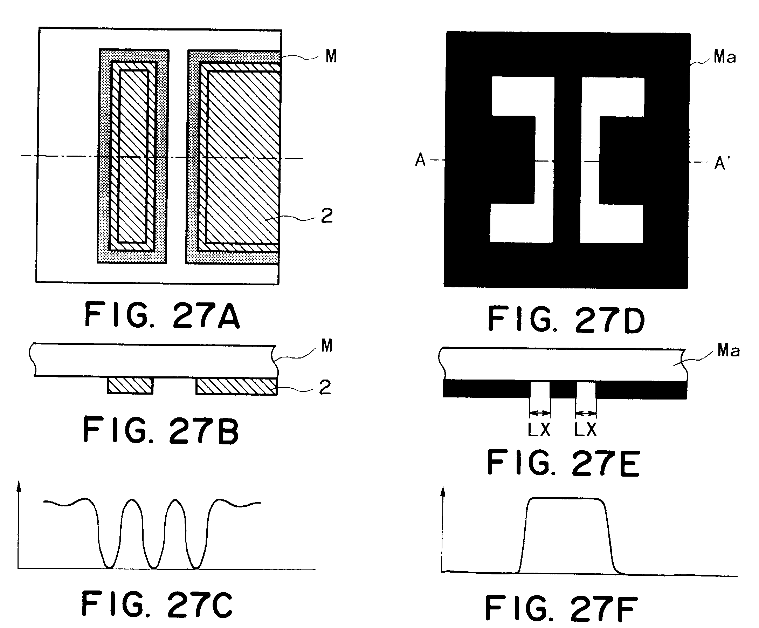

Referring to Figures 27A - 27G, 28A - 28C and 29, the dual exposure method for printing a high contrast image superposedly upon an opening (white blank in the drawings) of the gate pattern, will be explained.

First, exposure of a resist with a high contrast image for forming an exposure pattern, for applying large exposure amount to an exposure pattern for gate pattern, as a ground, will be described.

Figures 27A, 27B and 27C show the exposure process of high contrast image, and Figures 27D, 27E and 27F show the exposure process of gate pattern.

Figure 27A is a plan view of a phase type mask M for forming a high contrast image, and shows exposure amount distribution to be provided when the resist is exposed therewith. The portions 2 with hatching correspond to a phase shifter for changing the phase of light passing therethrough by 180 deg. as compared with light passing through a different region. About the edge of the phase shifter where the phase shifts, the exposure amount decreases. The decreased exposure amount region outside the phase shifter edge is depicted by a gray screen, while the decreased exposure amount region inside the phase shifter edge is illustrated by a square solid line on the mask in superposition. Figure 27B is a sectional view of the phase shift mask M, and Figure 27C shows exposure amount distribution produced by exposing the resist with the high contrast image of the mask M.

Figure 27D shows a mask Ma having a gate pattern to be used in ordinary exposure. Figure 27E is a sectional view, taken along a line A-A' at the center of Figure 27D. The widths $L_X$ of two openings of the mask Ma in Figure 27E are not resolved only by a single projection exposure process, and images of these two openings are blurred. Thus, the exposure amount distribution on the resist provided by the projection exposure with the mask Ma is expanded, as shown in Figure 27F.

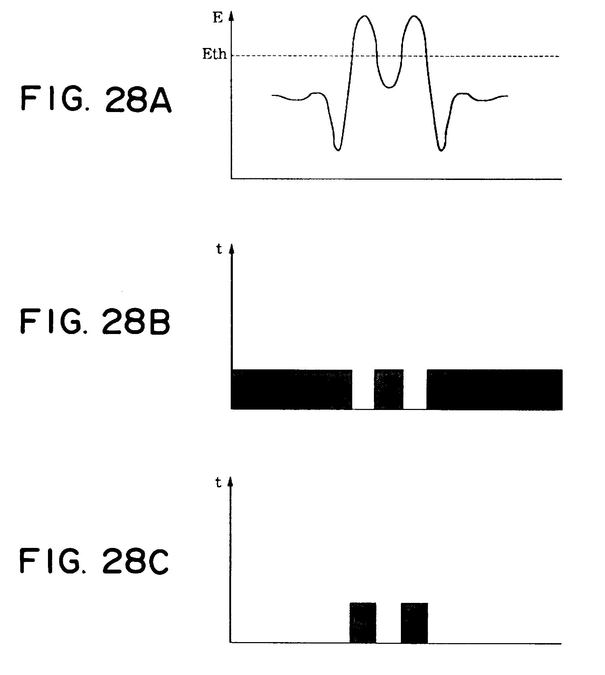

However, the total exposure amount distribution corresponding to combined exposure amounts of mask M and mask Ma, resulting from the dual exposure, will be such as shown in Figure 28A. If the resist exposure threshold $E_{th}$ is set as shown in Figure 28A, a resist pattern after development process when a positive type resist is used will be such as shown in Figure 28B. The highest exposure amounts in exposure amount distributions of Figures 27C and 27E are lower than the exposure threshold $E_{th}$.

A resist pattern after development process if a negative type resist is used will be such as shown in Figure 28C.

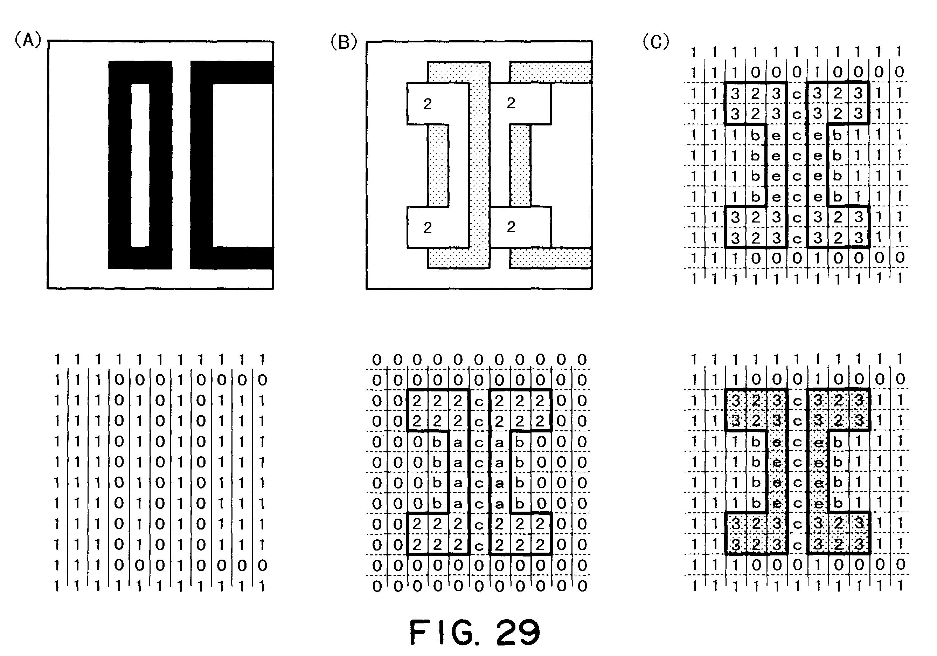

While in the foregoing the dual exposure procedure has been described particularly with reference to a smallest linewidth pattern which is at a central portion of a gate pattern, details of dual exposure with reference to the whole of gate pattern will be described below, in conjunction with Figure 29.

Figure 29 at (A) shows an exposure pattern (exposure amount distribution) produced by high contrast image exposure which is based on projection exposure of the mask M. This exposure pattern has a period of 0.2 micron, and it corresponds to a line-and-space (L&S) pattern of 0.1 micron linewidth. Numerical values at the bottom of Figure 29 denote exposure amounts on a resist.

In this embodiment, projection exposure of a gate pattern (such as depicted by a white blank at (B) of Figure 29) is accomplished by ordinary exposure (for example, an exposure process to be made by the exposure apparatus of Figure 21 with large σ partial coherent illumination to the mask), which is to be performed after the high contrast image exposure described above.

Figure 29 at (B) illustrates the relative positional relation between an exposure pattern defined by the gate pattern of the mask Ma and an exposure pattern defined by the mask M, as well as the exposure amount provided upon the mask in the gate pattern projection exposure. At the bottom of Figure 29(B), there is illustrated exposure amounts on a wafer resist provided by the gate pattern projection exposure, the exposure amounts being mapped with respect to lateral and longitudinal resolution of 0.1 micron pitch.

The smallest linewidth portion (pattern image) of the image provided by the gate pattern of the mask Ma is not resolved and is expanded, so that the contrast is low. Thus, exposure amount levels at points in this portion are lowered. Here, the central portion of the pattern image and opposite side portions outside it are denoted by $\underline{a}$ and b, and the portion between pattern images where blurred images from opposite sides overlap is denoted by c. Then, exposure amounts at these portions have relations that $1<a<2$, $0<b<1$ and $0<c<1$, that is, it is large at the center and low at the sides. The ratio of exposure amounts to be applied to the resist through the exposures using the masks M and Ma is 1:2 ("exposure by high contrast image of mask M" vs. "exposure by gate pattern of mask Ma").

Next, the manner of forming a fine gate pattern shown in Figure 12 by dual exposure based on high contrast image exposure and ordinary exposure of a gate pattern having a pattern not resolvable due to low contrast, will be described. In this embodiment, there is no developing process intervening between the high contrast image exposure and the ordinary exposure using a gate pattern image. Also, these exposures use the same exposure wavelength. Thus, in the region in which exposure patterns of these exposures overlap, the exposure amounts are accumulated, and the cumulative exposure amount defines a separate exposure pattern (exposure amount distribution).

Figure 29 at (C) illustrates an exposure pattern (exposure amount distribution) resulting from accumulation of the exposure pattern at Figure 29(A) and the exposure pattern at Figure 29(B). The exposure amount at regions denoted by e is equal to $1+a$ which is larger than 2 and smaller than 3. Illustrated by gray at bottom of Figure 29(C) is a lithography pattern produced as a result of developing process made to this exposure pattern. In this embodiment, a resist of exposure threshold $E_{th}$ larger than 1 and smaller than 2 is used for the wafer. Therefore, only the region exposed with exposure amounts greater than 1 appears as a pattern, after the development process.

The size and shape of the pattern depicted by gray in Figure 29 at (C) corresponds to those of the gate pattern of Figure 12. Thus, in accordance with the exposure method of this embodiment of the present invention, a circuit pattern having a very small linewidth of 0.1 micron, for example, can be produced by use of a projection exposure apparatus.

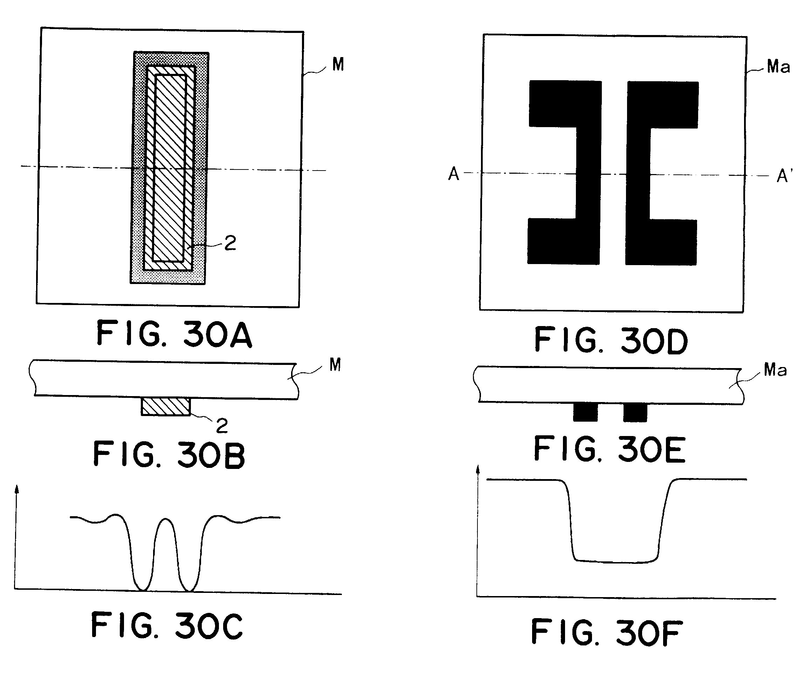

Another embodiment will be described below with reference to Figures 30A - 30F, 31A - 31C and 32. In this embodiment, a high contrast image as a ground is projected on a resist so that an exposure pattern for applying a small exposure amount to a solid exposure pattern of gate pattern is formed.

Figures 30A, 30B and 30C show the exposure process of high contrast image, and Figures 30D, 30E and 30F show the exposure process of gate pattern.

Figure 30A is a plan view of a phase type mask M for forming a high contrast image, and shows exposure amount distribution to be provided when the resist is exposed therewith. The portions 2 with hatching correspond to a phase shifter for changing the phase of light passing therethrough by 180 deg. as compared with light passing through a different region. About the edge of the phase shifter where the phase shifts, the exposure amount decreases. The decreased exposure amount region outside the phase shifter edge is depicted by a gray screen, while the decreased exposure amount region inside the phase shifter edge is illustrated by a square solid line on the mask in superposition. Figure 30B is a sectional view of the phase shift mask M, and Figure 30C shows exposure amount distribution produced by exposing the resist with the high contrast image of the mask M.

Figure 30D shows a mask Ma having a gate pattern to be used in ordinary exposure. Figure 30E is a sectional view, taken along a line A-A' at the center of Figure 30D. The pattern of two very narrow lines at the center of the mask Ma is not resolved only by a single projection exposure process, and its image is blurred and the contrast is lowered. Thus, the exposure amount distribution on the resist provided by this image expanded, as shown in Figure 30F.

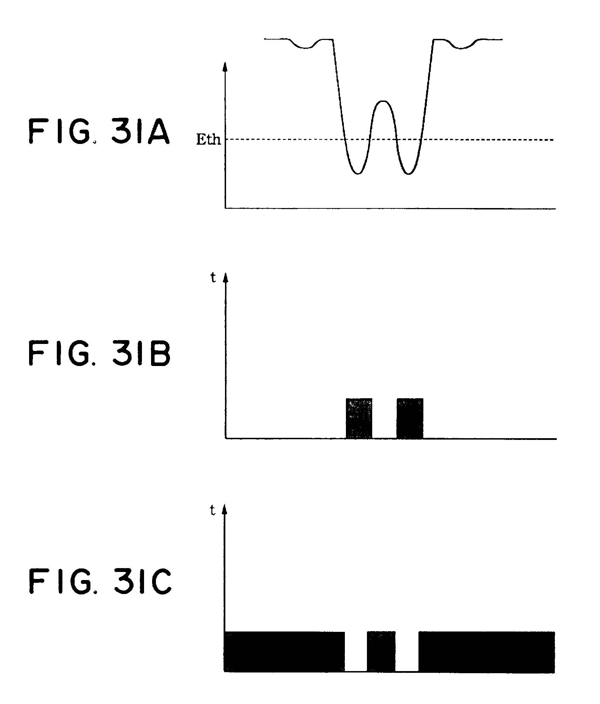

The total exposure amount distribution on the resist provided by dual exposure based on high contrast image exposure through projection of the phase shifter of the mask M and ordinary exposure through projection of the gate pattern image of the mask Ma, will be such as shown in Figure 31A. If the resist exposure threshold $E_{th}$ is set as shown in Figure 31A, a resist pattern after development process when a positive type resist is used will be such as shown in Figure 31B. A resist pattern after development process if a negative type resist is used will be such as shown in Figure 31C.

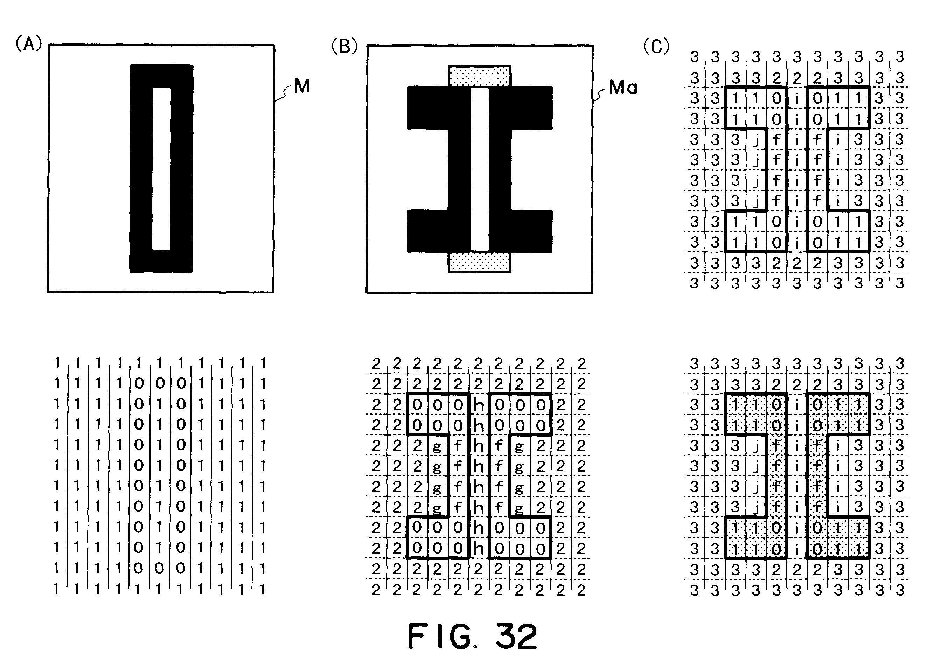

While in the foregoing the exposure procedure has been described particularly with reference to the central portion of a gate pattern, details of dual exposure procedure with reference to the whole of gate pattern will be described below, in conjunction with Figure 32.

In this embodiment, the high contrast image or the exposure pattern provided thereby has a period of 0.2 micron, and this image or pattern corresponds to a line-and-space (L&S) pattern of 0.1 micron linewidth. Numerical values at the bottom of Figure 32 denote exposure amounts on a resist.

In this embodiment, projection exposure of a gate pattern image of the mask Ma (e.g., by projection exposure of the mask Ma through the apparatus of Figure 21 and through large σ partial coherent illumination) is performed after (or simultaneously with) the projection exposure of the high contrast image of the mask M (e.g., by projection exposure of the mask M through the apparatus of Figure 21 and through partial coherent illumination), by which exposure of the gate pattern such as shown in Figure 32 at (B) is accomplished.

Figure 32 at (B) illustrates the relative positional relation between the high contrast image pattern defined by the mask M and the gate pattern image defined by the mask Ma. At the bottom of Figure 32(B), there is shown the exposure amounts on a wafer resist provided by a single projection exposure of the gate pattern image of the mask Ma, the exposure amounts being mapped with respect to lateral and longitudinal resolution of 0.1 micron pitch.

The smallest linewidth portion of exposure pattern provided by projection exposure of this gate pattern is not resolved and is expanded. Thus, the exposure amount levels at points in this portion are lowered, and the contrast decreases. As regards exposure amounts in respective regions of this exposure pattern, roughly stating, it is small at the central portion of the pattern while it is large at the opposite side portions. Here the exposure amounts at the central portion and the side portions are denoted by f and g, respectively, and the exposure amount at the center where blurred images coming from the opposite sides overlap is denoted by h, then there are relations 0<f<1, 1<g<2, and 1<h<2. Thus, the exposure pattern provided by a gate pattern image having a linewidth not resolvable produces a multiple value exposure amount distribution having different exposure amounts in different regions.

The ratio of exposure amounts upon the wafer resist applied through the exposures using the masks M and Ma is 1:2 ("exposure by high contrast image of mask M" vs. "exposure by gate pattern image of mask Ma").

Next, the manner of forming a fine circuit pattern shown in Figure 14 by dual exposure based on high contrast image exposure and projection exposure of a gate pattern image as described above, will be explained in detail. In this embodiment, there is no developing process intervening between the high contrast image exposure and the gate pattern image exposure. Thus, in the region in which exposure patterns of these exposure processes overlap, the exposure amounts are accumulated, and the cumulative exposure amount defines a separate exposure pattern (exposure amount distribution).

Figure 32 at (C) illustrates an exposure pattern (exposure amount distribution) resulting from accumulation of the exposure pattern at Figure 32(A) and the exposure pattern at Figure 32(B). The exposure amounts at regions denoted by i and j are equal to 1+l and 1+j, respectively, which are larger than 2 and smaller than 3.

Illustrated by gray at bottom of Figure 32(C) is a lithography pattern produced as a result of developing process made to this exposure pattern. In this embodiment, a resist of exposure threshold $E_{th}$ larger than 1 and smaller than 2 is used for the wafer. Therefore, only the region exposed with exposure amounts smaller than 2 appears as a pattern, after the development process.

The size and shape of the pattern depicted by gray in Figure 32 at (C) corresponds to those of the gate pattern of Figure 14. Thus, in accordance with the exposure method of this embodiment of the present invention, a circuit pattern having a very small linewidth of 0.1 micron, for example, can be produced by use of a projection exposure apparatus.

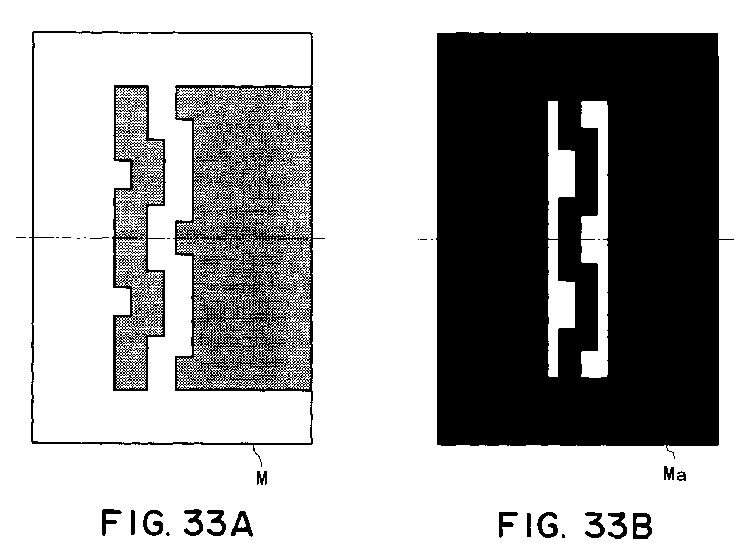

Another embodiment of the present invention applied to a circuit pattern of different shape, will now be described. Figure 33B shows the shape of such circuit pattern to be processed by this embodiment, and it comprises a pair of patterns having a wide linewidth portion of 0.2 micron which is twice in width of its minimum linewidth. These paired patterns are disposed with a gap of 0.1 micron.

This embodiment will be described with reference to Figures 33A, 33B, 34A - 34F and 35A - 35E and with respect to a case wherein, by an exposure pattern to be defined with a high contrast image, a large exposure amount is applied to an exposure pattern defined by a circuit pattern image having a portion for forming a low contrast image.

Figure 33A shows the pattern shape as a phase type mask M for forming a high contrast image, to be used for dual exposure in this embodiment, is viewed from the above. Figure 33B illustrates the pattern shape as a mask pattern Ma for forming a circuit pattern image (including a low contrast image) to be used for dual exposure in this embodiment, is viewed from the above.

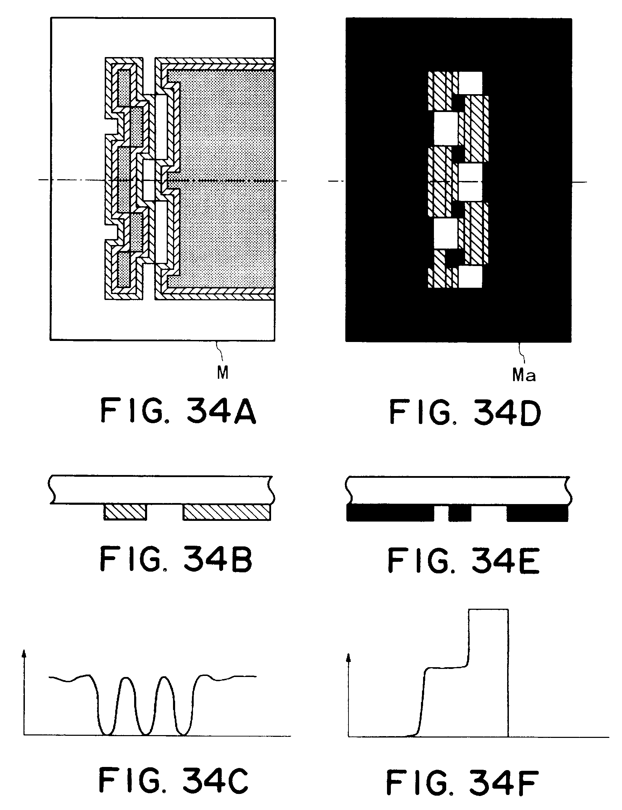

Figures 34A - 34F illustrate the processes of projection exposure using the masks M and Ma. More specifically, Figures 34A, 34B and 34C show the exposure process for forming a high contrast image by using the mask M, and Figures 34D, 34E and 34F show the exposure process with a pattern image comprising mixture of high and low contrast images.

Figure 34A is a plan view of a phase type mask M for forming a high contrast image. The portions with hatching have a function changing the phase of light passing therethrough by 180 deg. as compared with light passing through a different region. Figure 34B is a sectional view of the mask M. Figure 34C shows the exposure amount distribution on a resist as the pattern image of the mask M is projected thereon.

Figure 34D is a plan view of a mask Ma for forming a circuit pattern image, and it schematically illustrates exposure amount distribution, with blur in projection exposure being taken into account. The white blank in Figure 34D corresponds to a large exposure amount region. The hatched area corresponds to a region being expanded by blurring and having lowered light quantity. Figure 34E is a sectional view of the center of the mask Ma. This circuit pattern image is not resolved only by a single projection exposure of the mask Ma, and its image is blurred and the contrast is lowered. Thus, the exposure amount distribution on the resist provided by this image expanded, as shown in Figure 34F.

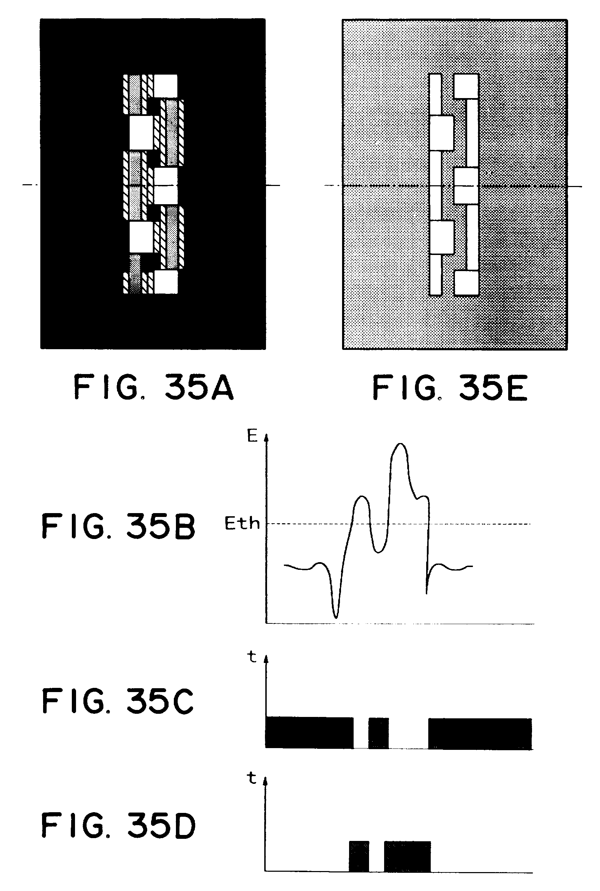

The total exposure amount distribution on the resist provided by dual exposure based on projection exposure of the high contrast image using the mask M and projection exposure of the circuit pattern image using the mask Ma, may be schematically shown as in Figure 35A. Figure 35B shows the exposure amount distribution at the central portion. If the resist exposure threshold $E_{th}$ is set as shown in Figure 35B, a resist pattern after development process when a positive type resist is used will be such as shown in Figure 35C. A resist pattern after development process if a negative type resist is used will be such as shown in Figure 35D.

Figure 35E is a plan view, showing the resultant resist pattern. Thus, a desired circuit pattern can be produced. The dual exposure procedure described above can be performed by using an exposure apparatus such as shown in Figure 20 or 21, for example. In that occasion, the same exposure wavelength may be used in respective exposures. The same exposure wavelength may be used similarly in embodiments to be described below.

Next, the light quantity ratio in the dual exposure procedure, between the exposure with high contrast image (hereinafter, to be represented by periodic pattern) and the exposure with circuit pattern image, as well as the contrast of exposure pattern to be produced by the dual exposure, will be described in detail.

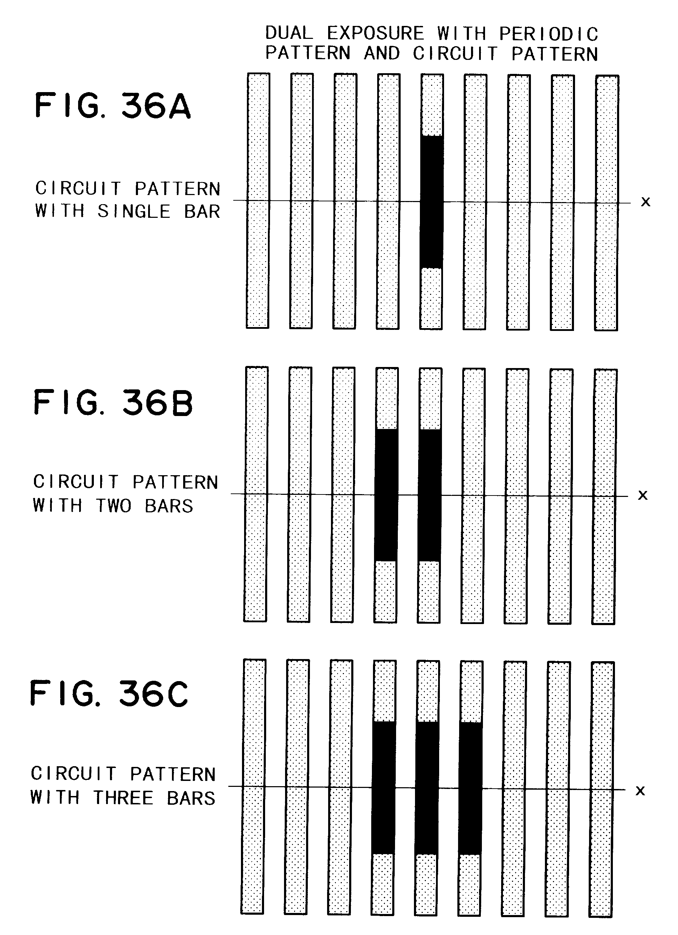

Figures 36A - 36C illustrate relative positional relation in the dual exposure process, in which the exposure pattern comprising a periodic pattern, to be produced by double-beam interference exposure is depicted by gray, while the exposure pattern comprising a circuit pattern, to be produced by a single projection exposure is depicted by solid or black painting. The gray exposure pattern corresponds to a high contrast portion as defined by exposure with high contrast image, while the black painted exposure pattern corresponds to a low contrast portion as defined by a low contrast image (circuit pattern image). In this case, the circuit pattern comprises a bar pattern. Figure 36A shows a case of a pattern of single bar, Figure 36B shows a case of a pattern of two bars, and Figure 36C shows a case of a pattern having three bars.

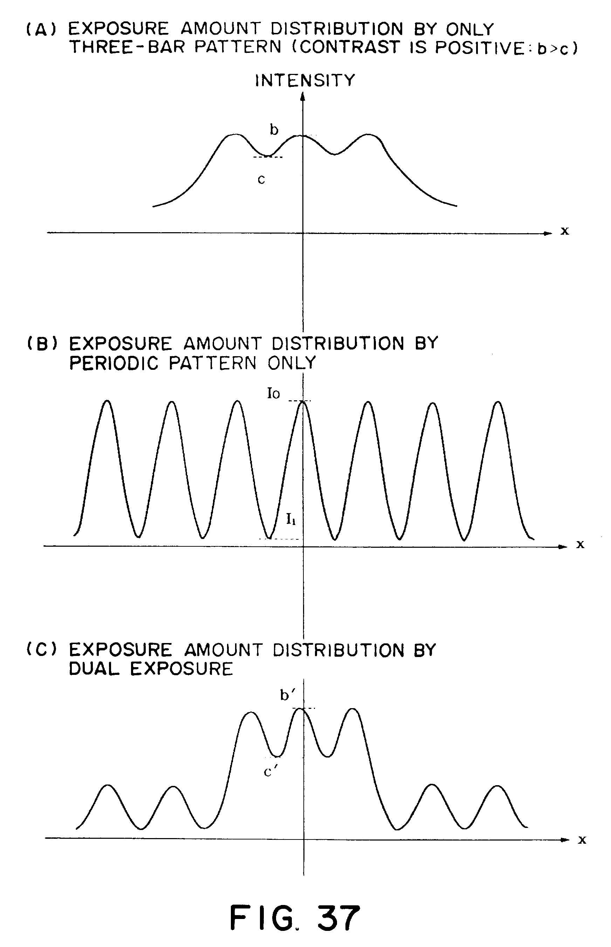

Figure 37 at (A) shows exposure amount distribution in X-axis section, to be applied to a resist with an image of the three-bar pattern of Figure 36C. The contrast A of the exposure amount distribution (image) of Figure 37(A) is expressed by:

$$A = (b-c)/(b+c) \qquad (1)$$

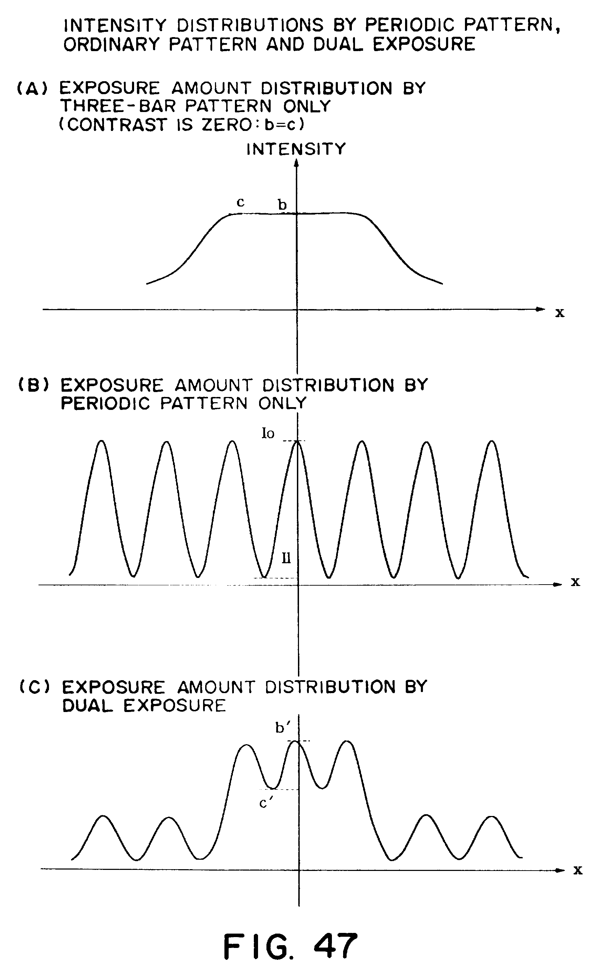

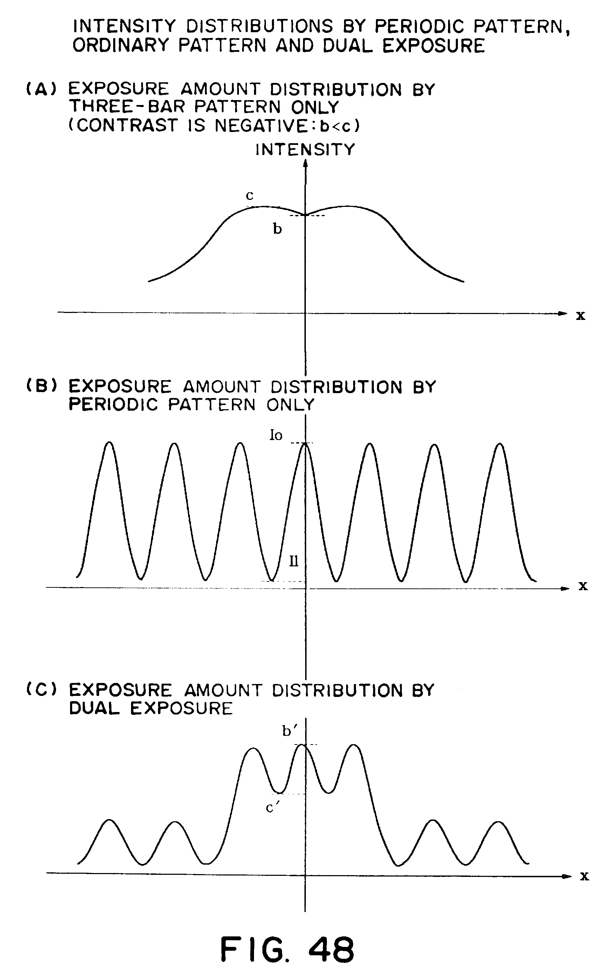

If $b < c$, the contrast becomes negative (see Figure 48). If $b = c$, the contrast is zero (see Figure 47).

The three-bar pattern shown in Figure 37(A) is a pattern of low contrast and not resolvable, similarly to what has been fully described hereinbefore. By performing dual exposure procedure in combination with the periodic pattern, forming a high contrast image exposure amount distribution (image) shown in Figure 37 at (B), an exposure amount distribution of Figure 37 at (C) providing a pattern of high contrast and being resolvable, can be produced.

If the exposure amount ratio between the exposure process using a three-bar pattern (circuit pattern) and the exposure process using a periodic pattern (high contrast image) is 1:k, then there are relations below:

$$\begin{cases} b' = k \times b + I_0 \\ c' = k \times c + I_1 \end{cases}$$

The contrast A' of exposure amount distribution provided by dual exposure in this case, will be given by:

$$\begin{aligned} A' &= (b'-c')/(b'+c') \\ &= [(k \times b + I_0) - (k \times c + I_1)]/[(k \times b + I_0) + (k \times c + I_1)] \\ &= [k(b-c) + (I_0 - I_1)]/[k(b+c) + (I_0 + I_1)] \qquad \ldots(2) \end{aligned}$$

Here, from the level of contrast resolvable by the resist (i.e., contrast threshold), the light quantity ratio k can be determined.

If for example the contrast threshold of the resist used is $I_c$, the light quantity ratio k may be determined to satisfy the following relation:

$$[k(b-c) + (I_0 - I_1)]/[k(b+c) + (I_0 + I_1)] > I_c$$

In use of the same mask pattern through the same projection exposure apparatus, values b and c are determined by the illumination condition for the mask illumination, and values $I_0$ and $I_1$ are determined by the periodic pattern forming method.

The contrast A' of the exposure amount distribution after the dual exposure has been changed by A'-A, from the contrast A provided by a single exposure of ordinary circuit pattern. The amount of this change is given from equations (1) and (2), as follows.

$$\begin{aligned} A' - A &= [k(b-c) + (I_0 - I_1)]/[k(b+c) + (I_0 + I_1)] \\ &\quad - (b-c)/(b+c) \\ &= \{(I_0 + I_1)/[k(b+c) + (I_0 + I_1)]\} \\ &\quad \times [(I_0 - I_1)/(I_0 + I_1) - (b-c)/(b+c)] \\ &\qquad \qquad \ldots(3) \end{aligned}$$

Here, there is a relation:

$$(I_0-I_1)/[k(b+c)+(I_0+I_1)] > 0$$

Also,

$$(I_0-I)/(I_0+I_1)$$

in equation (3) is the contrast of periodic pattern image in the double-beam interference exposure or of the exposure amount distribution provided thereby. Similarly,

$$(b-c)/(b+c)$$

in equation (3) is the contrast of the circuit pattern image or of the exposure amount distribution provided thereby. Within the very small linewidth region less than the resolution limit, the contrast by the double-beam interference exposure is higher than that of the circuit pattern image exposure. Therefore,

$$(I_0-I_1)/(I_0+I_1) - (b-c)/(b+c) > 0$$

Namely, A'-A > 0, which clearly means that the contrast of exposure amount distribution increases as a result of dual exposure.

Here, the light quantity ratio k in the case of dual exposure shown in Figure 36C will be considered.

A highest performance resist material among currently available resist materials is resolvable at 40% contrast (namely, the contrast threshold is 40%). The condition for k with which 40% contrast is attainable may be determined on the basis of A', as follows.

Usually, a mask pattern has a transmission factor of 1 at its pattern portion, and a transmission factor of 0 at its background (although there is a mask pattern with transmission factor 0 at its pattern portion and transmission factor 2 at its background). The transmission factor at the background may not always be zero, and a halftone type in which the phase is inverted by 180 deg. to provide a few percent transmission factor (it may be not greater than 10% in many cases) may be used. Such halftone mask will be described later.

A projection optical system had a wafer side numerical aperture NA of 0.60. For exposure wavelength, laser light of KrF excimer laser ($\lambda = 248$ nm) was used. A three-bar pattern on the mask had a width 0.12 micron the same as that of a periodic pattern. A periodic pattern image such as shown in Figure 36C was formed by illuminating a Levenson type phase shift mask under illumination condition of $\sigma = 0.2$ and by projecting the same. The periodic pattern image produced an exposure amount distribution on the resist, as follows (see Figure 37(B)).

$$\begin{cases} I_0 = 0.95 \\ I_1 = 0.06 \end{cases}$$

A three-bar pattern image such as shown in Figure 36C was formed on the basis of ring-like illumination method under the illumination condition that it provides illuminance with the range of $\sigma = 0.8$ to $\sigma = 0.53$ but provides no illuminance with $\sigma$ less than 0.53. The three-bar pattern image produced an exposure amount distribution on the resist, as follows (see Figure 37(A)).

$$\begin{cases} b = 0.57 \\ c = 0.45 \end{cases}$$

Since the contrast A defined only by the projection exposure of the three-bar pattern is 12%, as follows,

$$A = (b-c)/(b+c) = 0.12$$

it is not resolvable.

In order to provide contrast A" of 40% or more after dual exposure based on the periodic pattern image and the three-bar pattern image, the following relation should be satisfied:

$$A' = [k(b-c)+(I_0-I_1)]/[k(b+c)+(I_0+I_1)] \geqq 0.4$$

By substituting values $I_0$, $I_1$, b and c described above into this equation, k can be determined as follows.

$$k = 1.67$$

It is seen from the above that, in order to provide contrast A' of 40% or more after the dual exposure, the light quantity ratio k of 1.67 should be set.

Using k = 1.67, the contrast of exposure amount distribution in the cases of pattern images of Figures 36A and 36B may be calculated as follows. For dual exposure of a single-bar pattern in Figure 36A, the lowest intensity level c may be one which corresponds to the intensity level at a position spaced from the X position of the highest intensity level b by a distance corresponding to the linewidth.

$$\begin{cases} b = 0.5 \\ c = 0.23 \end{cases} \qquad \begin{cases} I_0 = 0.95 \\ I_1 = 0.06 \end{cases}$$

$$A = 0.37$$

$$A' = 0.60$$

It is seen from the above that, as a result of dual exposure, the contrast was increased from 37% contrast by the projection exposure of a single-bar pattern to 60% contrast.

The results of calculation in the case of a double-bar pattern in Figure Figure 36B are as follows.

$$\begin{cases} b = 0.52 \\ c = 0.43 \end{cases} \qquad \begin{cases} I_0 = 0.95 \\ I_1 = 0.06 \end{cases}$$

$$A = 0.09$$

$$A' = 0.41$$

It is seen from the above that, as a result of dual exposure, the contrast was increased from 9% contrast by the projection exposure of a single-bar pattern to 41% contrast.

As described above, in regard to isolated and periodic patterns having one, two and three bars, for example, as a result of dual exposure procedure, in every case the contrast increases to 40% or more so that the pattern can be resolved with a 40% resist.

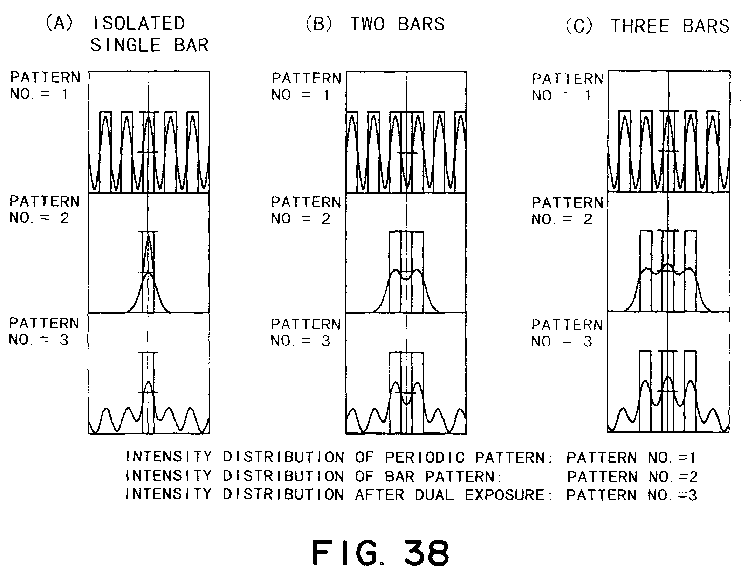

As described hereinbefore, in accordance with dual exposure based on projection exposure of ordinary circuit pattern image and projection exposure of a periodic pattern image, providing a high contrast image, the contrast of exposure amount distribution of a very fine pattern image less than the resolution limit (i.e., usually unresolvable) can be improved significantly. By setting the light quantity ratio k appropriately by suitably setting the illumination condition for the circuit pattern and the illumination condition for the periodic pattern, an exposure amount distribution (the one after dual exposure) with which the contrast level that can be resolved by a resist used can be accomplished. Figure 38 shows the results.

The projection optical system had NA = 0.60, and a KrF excimer laser was used as a light source. The exposure wavelength was $\lambda$ = 248 nm.

At (A), (B) and (C) of Figure 38, the topmost portion shows intensity distribution (exposure amount distribution) of a periodic pattern image, the middle portion shows intensity distribution (exposure amount distribution) of a bar pattern image, and the lowermost portion shows intensity distribution (exposure amount distribution) of a combined image after the dual exposure. The bar patterns used comprises a single-bar linear pattern, a double-bar linear pattern and a triple-bar linear pattern, respectively, each having a bar linewidth of 0.12 micron. In the illustrated intensity distributions, each portion depicted by a rectangular line corresponds to the intensity distribution of the bar pattern upon the corresponding mask. In each of the intensity distributions after the dual exposure, shown at the bottom portions, the contrast is improved as compared with the intensity distribution of the bar pattern at the middle portion, and the intensity peak is high and, also, it is at the center of the mask pattern. Thus, the pitch of the pattern is substantially the same as the pitch of the mask pattern.

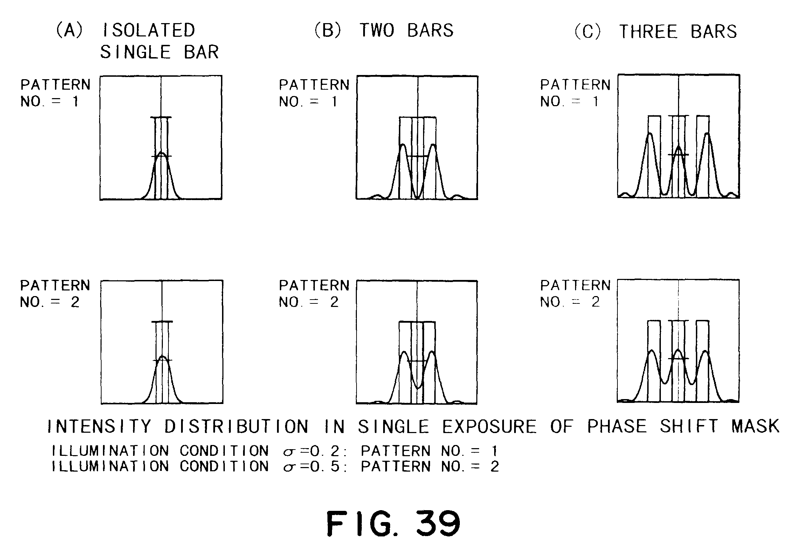

Figure 39 is similar to Figure 38 and shows intensity distributions (exposure amount distributions) of pattern images produced by a single exposure of Levenson type phase shift masks having similar bar patterns as of those of Figure 38 and having phases of adjacent bars mutually inverted. There are shown in Figure 39 two cases of $\sigma$ = 0.2 and $\sigma$ = 0.5, respectively. In the example of single-bar pattern at (A) of Figure 39, no adjacent pattern is there, and this corresponds to a single-bar pattern of an ordinary mask.

In the examples two-bar and three-bar patterns at (B) and (C) of Figure 39, since the phases of adjacent patterns are mutually inverted, a high contrast is produced. The contrast improvement effect is large with small $\sigma$ ($\sigma$ = 0.2) (more coherent illumination) as compared with the case of $\sigma$ = 0.5. However, at the opposite ends of the pattern, there is no adjacent pattern of inverted phase and, therefore, the image intensity there differs from that of the central portion. Particularly, in the case of $\sigma$ = 0.2, there is produced a large intensity peak difference between the central portion and the opposite end portions. With large $\sigma$ ($\sigma$ = 0.5), while the contrast lowers slightly, there is no intensity peak difference with respect to the opposite ends. In any of these cases, since the image blurs at the opposite ends, the bottom of the intensity distribution is expanded, such that the intensity peak position displaces from the center of the mask. The pitch of the pattern is not equal to the pith of the mask pattern.

Next, defocus characteristic of the contrast of exposure amount distribution to be provided by the dual exposure, will be described.

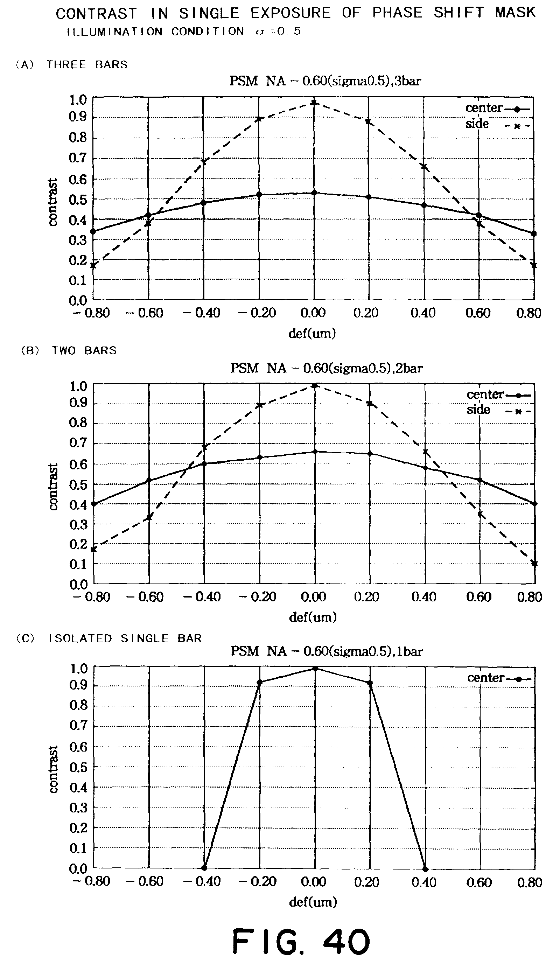

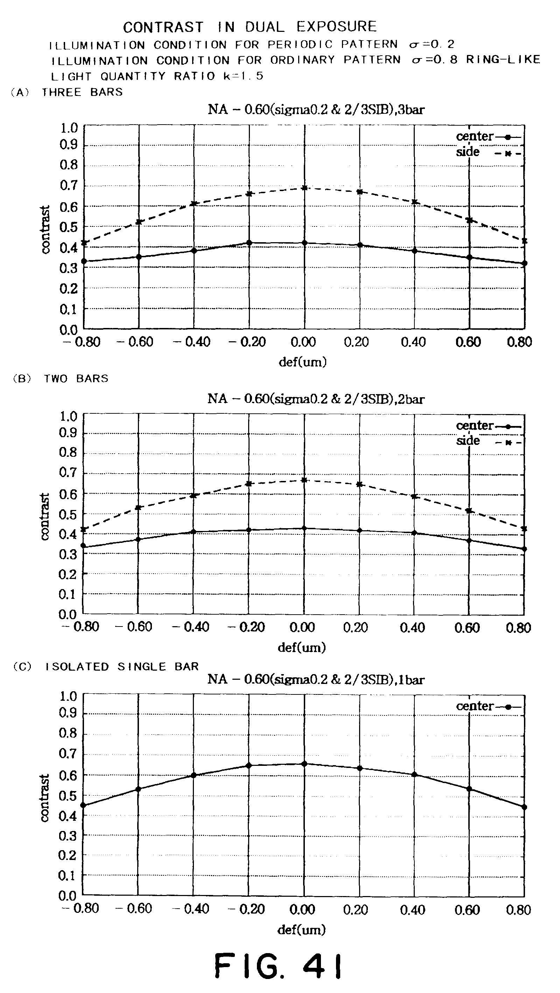

Figures 40 and 41 illustrate changes in contrast with defocus, in a case of single exposure of a phase shift mask and in a case of dual exposure.

As regards a circuit pattern, three types of bar patterns having a single linear bar, two linear bars and three linear bars, respectively, each having a linewidth 0.12 micron, were used. In Figures 40 and 41, solid lines each depicts contrast at the bar center. Broken lines each depicts contrast at the edge, that is, the contrast as calculated from the intensity peak at the outermost bar and the intensity at the position (no bar is present) spaced by a distance corresponding to the linewidth.

Figure 40 illustrates changes in contrast with defocus, in the exposure amount distribution as provided by a single exposure using the phase shift mask. The illumination condition was $\sigma$ = 0.5.

Figure 41 illustrates changes in contrast with defocus, in the exposure amount distribution provided by the dual exposure. As regards the illumination condition, for projection exposure of a bar pattern which would result in low contrast image, the illumination was made on the basis of ring-like illumination method using $\sigma$ = 0.8 to 0.53, with no illuminance inside $\sigma$ = 0.53. For projection exposure for forming a high contrast image, small $\sigma$ ($\sigma$ = 0.2) partial coherent illumination was used. The light quantity ratio between these exposure processes was 1.5. The projection optical system had NA = 0.6, and the exposure wavelength was 248 nm.

As regards the contrast at the bar center as depicted by solid lines in Figure 40, with decrease of periodicity from three bars to two bars and to one bar, the contrast becomes higher with best focus but it is lowered more with increase of defocus. In other words, the depth of focus becomes smaller with decrease of periodicity.

Further, there is a large difference between the contrast at the bar center (solid line) and the contrast at the edge (broken line). The depth of focus for providing 40% contrast and 30% contrast, if smaller one of the focus depths at the bar center and at the edge thereof is taken, will be such as follows.

For 40% contrast focus depth will be:

1.2 micron (three-bar pattern)
1.1 micron (two-bar pattern)
0.6 micron (single-bar pattern)

For 30% contrast focus depth will be:

1.4 micron (three-bar pattern)
1.3 micron (two-bar pattern)
0.7 micron (single-bar pattern)

On the other hand, the contrast levels at the bar centers are relatively low, but there is small differences among contrasts of the three-bar, two- bar and single-bar patterns. Decrease of contrast with defocus is small even if the periodicity becomes small. Further, the difference between the contrast at the bar center (solid line) and the contrast at the edge (broken line) is small.

For 40% contrast focus depth will be:

0.6 micron (three-bar pattern)
0.9 micron (two-bar pattern)
1.6 micron or more (single-bar pattern)

For 30% contrast focus depth will be:

1.6 micron or more (three-bar pattern)
1.6 micron or more (two-bar pattern)
1.6 micron or more (single-bar pattern)

Thus, as regards the 40% contrast depth, while substantially the same result as of the phase shift mask single exposure is obtainable, when the contrast proportion is slowed down to 35% or 30%, a larger depth is attainable with the dual exposure method. Further, since contrast can be changed by the ratio of light quantity, it can be set above the resist contrast threshold.

What is described above concerns a case where the bar pattern has a single linewidth. The following description will be made in regard to the linewidth linearity, and with reference to an example wherein a periodic pattern has a single linewidth but a bar pattern has mixture of different linewidths.

In this example, the projection optical system and the exposure wavelength were similar to those described above. Also, the illumination conditions for projection exposure of a periodic pattern and projection exposure of a bar pattern were similar to those described above. The periodic pattern had a fixed linewidth of 0.12 micron, as described above. As regards the bar pattern, a five-bar linear pattern, a two-bar linear pattern and a single-bar linear pattern, of linewidths from 0.1 to 0.16 microns were used.

To these patterns, an exposure amount slice level with which, for a sufficiently large linewidth (e.g., 0.36 micron in this example), the mask linewidth and the wafer linewidth are made equal to each other was determined. Then, experiments were made to examine errors of wafer side linewidths, corresponding to 0.1 micron to 0.16 micron, with respect to the mask side linewidths, under the same slice level. Also, for comparison, the linewidth linearity errors in single ordinary bar pattern exposure under the same illumination condition were examined.

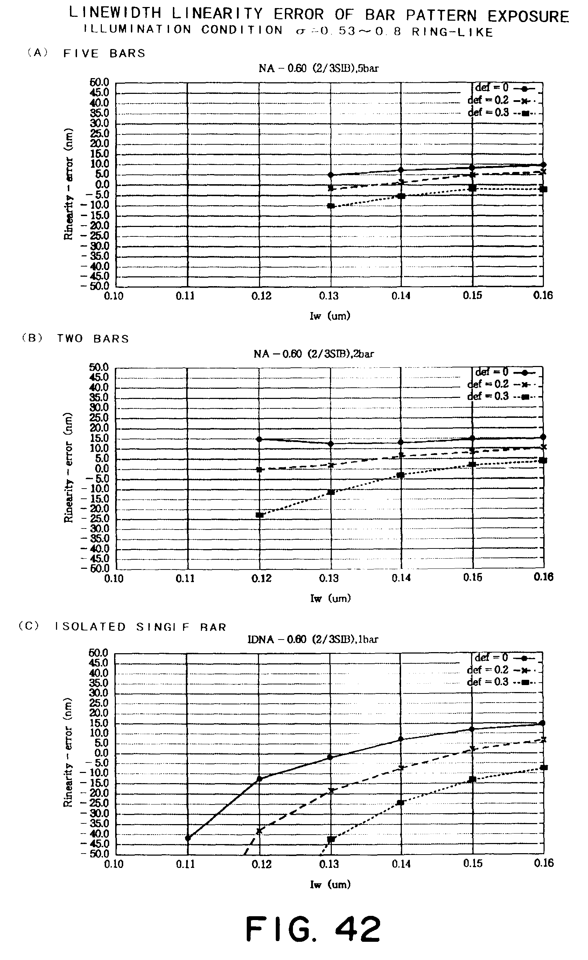

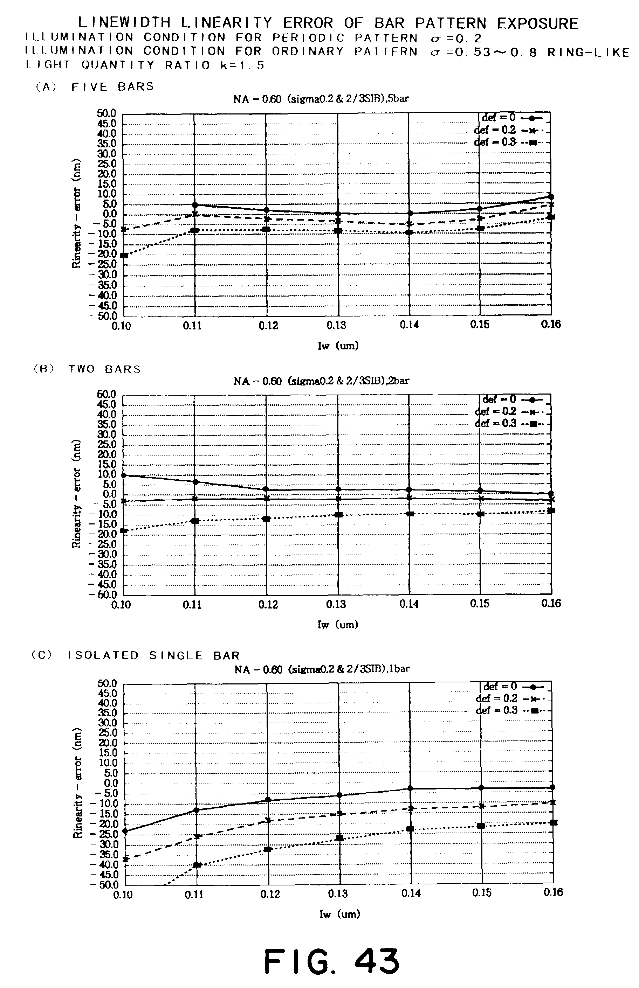

Figures 42 and 43 illustrate linewidth linearity errors, in relation to linewidths of 0.1 - 0.16 microns. These drawings show linewidth linearity errors with respect to cases of zero defocus and defocuses ±0.2 micron and ±0.3 micron. Figure 42 shows linewidth linearity errors in the ordinary exposure process. The illumination condition was ring-like illumination with $\sigma = 0.53 - 0.8$, and no illuminance inside $\sigma = 0.53$.

Figure 43 illustrates linewidth linearity errors in the dual exposure method. As regards illumination condition, for bar pattern exposure it was ring-like illumination with $\sigma = 0.53 - 0.8$ and no illuminance inside $\sigma = 0.53$. For periodic pattern exposure, it was small $\sigma$ partial coherent illumination, with $\sigma = 0.2$. These linewidths are smaller than the limit resolution and the contrast is low. However, even less than the resolvable contrast, if the exposure slice level was reached, it was calculated as linewidth.

In Figure 42, the portions where lines are discontinued are those region in which images are blurred and no pattern is formed. Even if a line is drawn there, resolvable contrast may not be reached.

In Figure 43, in each pattern case the limit resolution as linewidth reproducibility at respective defocuses is enhanced. Also, the linewidth error is smaller.

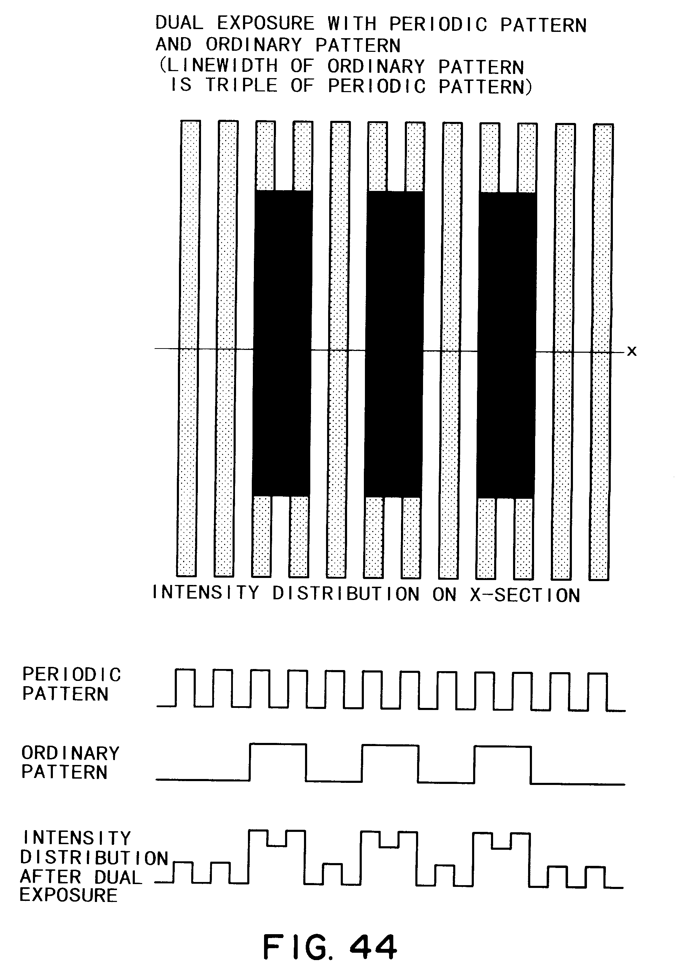

In the dual exposure method, as regards relatively large linewidths, the linewidth three times larger the periodic pattern has good reproducibility. This is because, as shown in Figure 44, the opposite edges of the pattern of the bar pattern coincide with the periodic pattern. The linewidth twice the periodic pattern has no good reproducibility.

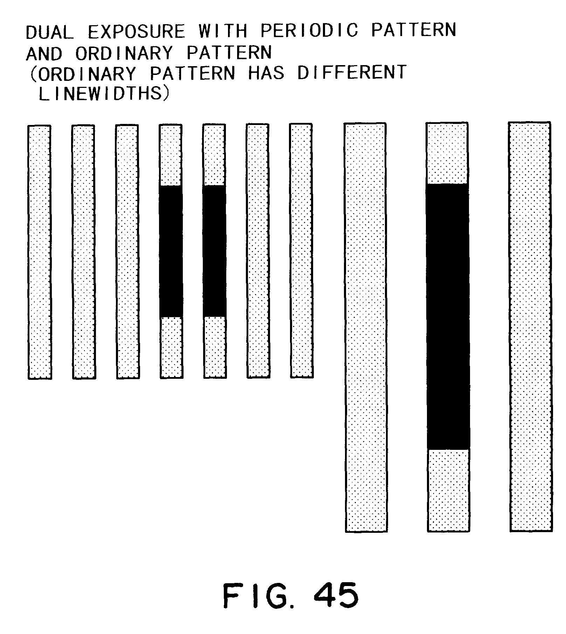

As regards the linewidth of bar pattern, if there are mixture of a smallest linewidth and a linewidth twice of that, for example, partially changing the pitch of the periodic pattern such as shown in Figure 45 is effective.

As regards the linewidth linearity error in the dual exposure method, while in Figure 43 the linewidth of the periodic pattern is fixed at 0.12 micron and the linewidth of bar pattern is changed, clearly the linewidth linearity error can be reduced by partially changing the pitch of periodic pattern to twice the linewidth in accordance with the bar pattern linewidth, as shown in Figure 45.

In a case where a single exposure is to be made by use of a Levenson type phase shift mask having a pattern the same as the bar pattern and having phases of adjacent bars mutually inverted, the linewidth linearity error at the center of the periodic pattern will be substantially equal to the linewidth linearity error in the case where the linewidth of bar pattern and the pitch of the periodic pattern in the dual exposure is made equal to twice the linewidth. Since however, as regards the edge of the periodic pattern or an isolated pattern, it becomes substantially equal to the linewidth linearity error in the ordinary exposure such as shown in Figure 42, it is seen that the dual exposure procedure has a superiority also with respect to the linewidth linearity error.

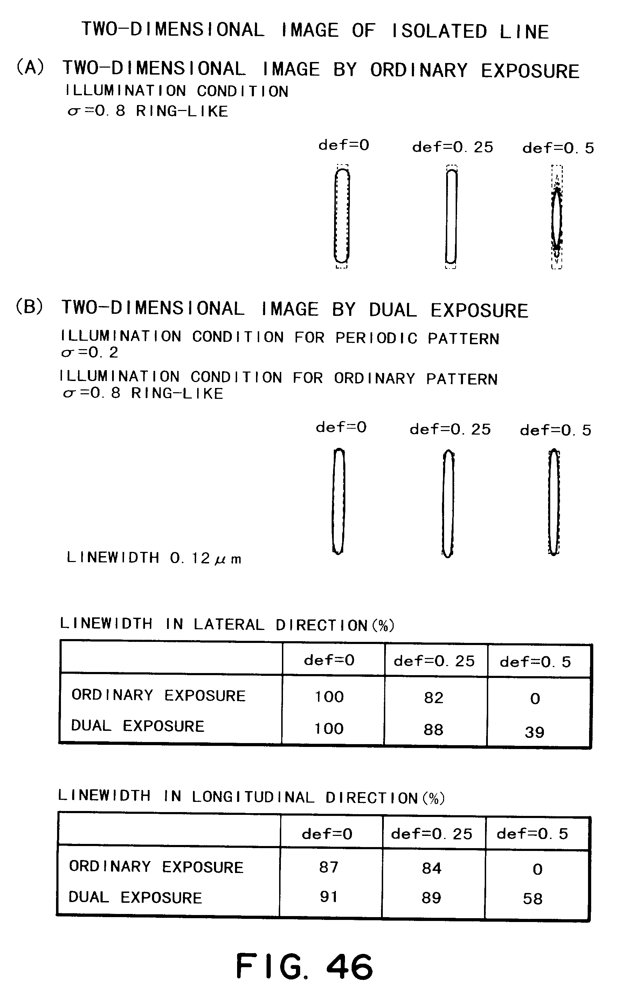

Figure 46 illustrates two-dimensional images which are results of projection exposure of an isolated line, through a single exposure and through dual exposure. Charts in the drawing show changes in linewidth with defocus as well as the length in longitudinal direction, being resolved with exposure amount with which the linewidth at best focus become equal to the mask linewidth, the numerals being in the ratio to the mask linewidth. The linewidth as the same as the mask linewidth is taken as 100%.

The result of dual exposure, as compared with the result of single bar-pattern projection exposure, is that the length in longitudinal direction becomes close to the mask linewidth also with the best focus. The linewidth change with defocus is smaller, and the depth of focus is enlarged.

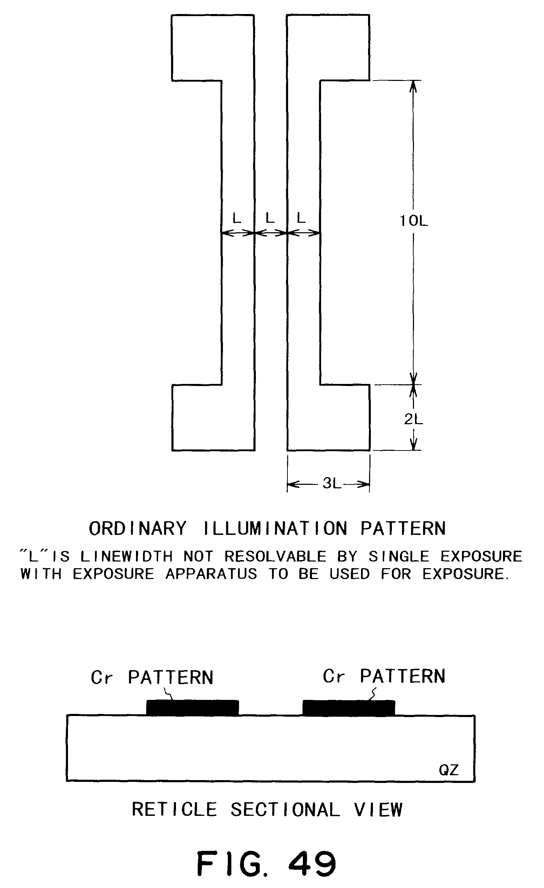

Referring now to Figures 49 - 52, another embodiment of the present invention will be described. This embodiment concerns a different example of mask (reticle) for forming a pattern which can not be resolved through a single exposure.

In dual exposure method procedure, there may be a case wherein, when an ordinary Cr film pattern such as shown in Figure 49 is used in projection exposure of a pattern image not resolvable by a single exposure using an ordinary exposure apparatus, the exposure amount in the portion superposedly exposed by dual exposure becomes excessive. In that case, film thickness reduction may occur in the resist pattern or contrast of the mask pattern image may become insufficient when defocus occurs. The depth of focus may therefore be shortened. Use of masks or reticle having three types of patterns, to be described below, will however be effective to produce a mask pattern image of high contrast as compared with the Cr film pattern of Figure 49, and to enlarge the depth of focus.

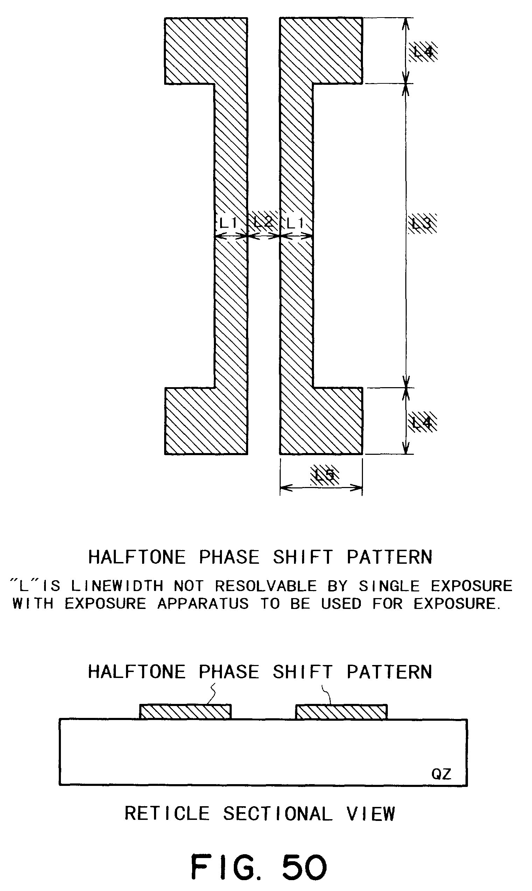

(1) Halftone Phase Shift Pattern (Figure 50)

Transmission factor: 2 - 10%.
Shifter material: Mo series, Cr series, other metal oxide or nitride.
Dimension: L1 - L5 determined appropriately.
Phase: 180 deg. phase difference between lights passing through the halftone portion and an adjacent portion.

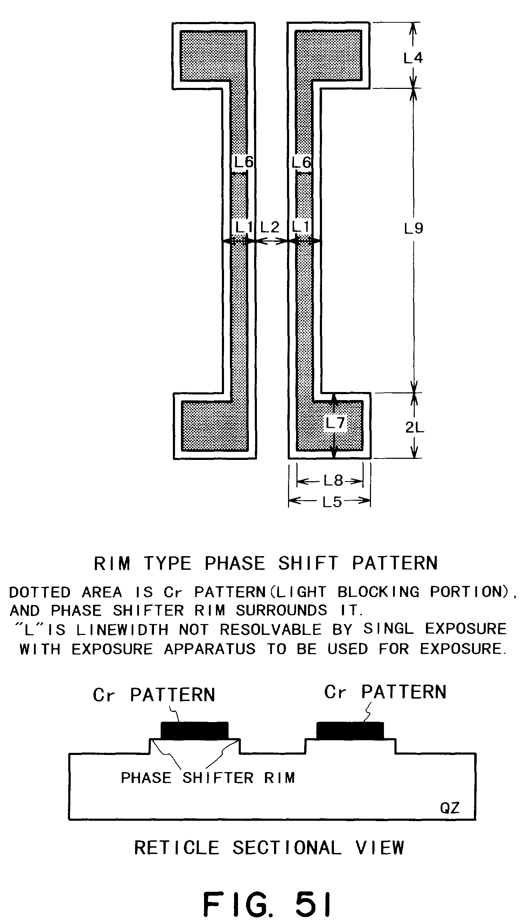

(2) Rim Type Phase Shift Pattern (Figure 51)

Dimension: L1 - L9 determined appropriately.
Phase: 180 deg. phase difference between lights passing through the rim portion and an adjacent portion.

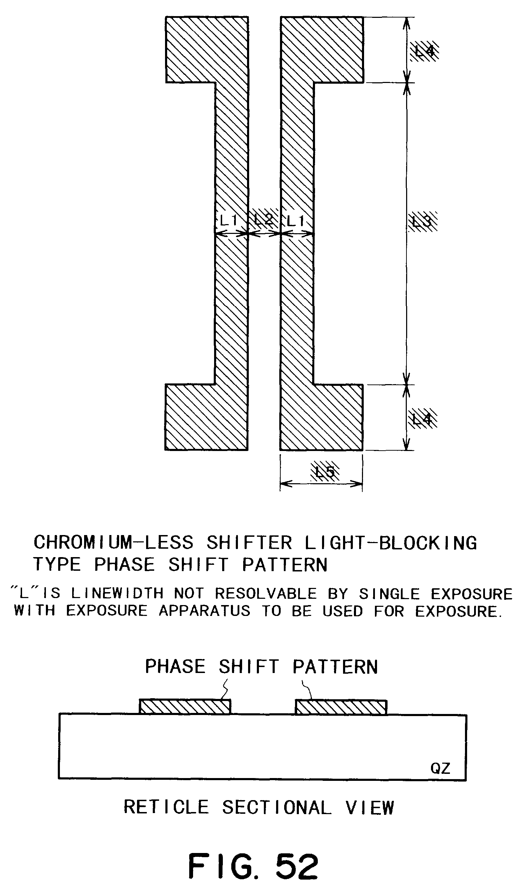

(3) Chromium-less Shifter Light Blocking Type Phase Shift Pattern (Figure 52)
This type is particularly effective to a very narrow linewidth pattern, as compared with the two types described above. In this type, in a narrow linewidth pattern, phase shift effects at the opposite edges of a phase shift pattern are combined with each other to produce a resist image as a single line pattern.

Dimension: L1 - L5 determined appropriately.
Phase: 180 deg. phase difference between lights passing through the pattern portion and an adjacent portion.

The exposure methods and exposure apparatuses described above may be suitably used for production of various devices such as semiconductor chips (e.g., IC or LSI), display devices (e.g., liquid crystal panel), detecting devices (e.g., magnetic head), or image pickup devices (e.g., CCD), for example.

The present invention is not limited to the forms of the embodiments described hereinbefore, and may modifications are possible within the scope of the invention. The number of exposures of high contrast image exposure and circuit pattern image exposure as well as the number of stages of exposure amount may be changed appropriately, as described hereinbefore. Further, if necessary, superposition of exposures may be adjusted appropriately, with shift, for example. Such modification or adjustment will enhance the variation of circuit pattern to be produced.

The dual exposure method described above effectively improves the contrast of a fine pattern which is low in contrast and is not resolved only by conventional exposure, and it enables resolution of the same. Further, as compared with a single exposure of a pattern of Levenson type phase shift mask, the dual exposure method described above is much superior in respect to the linewidth reproducibility. Particularly, single exposure of a pattern of the Levenson type phase shift mask is not effective to a pattern having no periodicity, and there is a limitation to pattern disposition due to phase inversion. To the contrary, in this dual exposure method, a pattern having no periodicity or a pattern having a complicated shape can be produced. Further, as compared with the method disclosed in U.S. Patent No. 5,415,835 or Japanese Laid-Open Patent Application, Laid-Open No. 253649/1995, the dual exposure method of the present invention enables a pattern of more complicated shape.

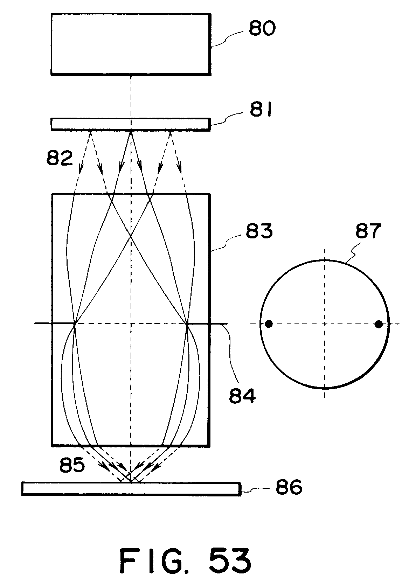

Figure 53 is a schematic view of an exposure apparatus which is usable in the present invention for forming a high-contrast two-dimensional periodic pattern (which may be called a check pattern). In this embodiment, double-beam interference is performed in a set or in two sets (four-beam interference) simultaneously, with respect to two orthogonal directions, such that a check pattern is formed on a photosensitive substrate by a single projection exposure. The thus produced check pattern (periodic pattern) and a circuit pattern (ordinary pattern) such as a gate pattern are superposed, by dual exposure. By setting the threshold of the photosensitive substrate, as will be described later, a desired pattern is produced.

For simplicity, Figure 53 illustrates the double-beam interference only with respect to one direction. Here, the words "multiple exposure" refers to performing exposure of a photosensitive substrate plural times by use of different patterns, without intervention of a developing process.

The exposure apparatus of Figure 53 will be described in detail. The exposure apparatus of Figure 53 includes a projection optical system of conventional type, which consists of an all dioptric system, for example. A system of NA = 0.6 or more with respect to a wavelength 248 nm, is currently available. Denoted in the drawing at 80 is an illumination system which is operable to perform coherent illumination and partial coherent illumination. Denoted at 81 is a mask, and denoted at 82 is object side exposure light. Denoted at 83 is a projection optical system, and denoted at 84 is an aperture stop. Denoted at 85 is image side exposure light, and denoted at 86 is a photosensitive substrate. Denoted at 87 is the position of light upon the pupil plane of the projection optical system 83.

The drawing schematically shows double-beam interference exposure with respect to one direction. The object side exposure light 82 and the image side exposure light 85 each comprises two parallel light fluxes. Actually, similar double-beam interference is provided with respect to a direction perpendicular to the sheet of the drawing.

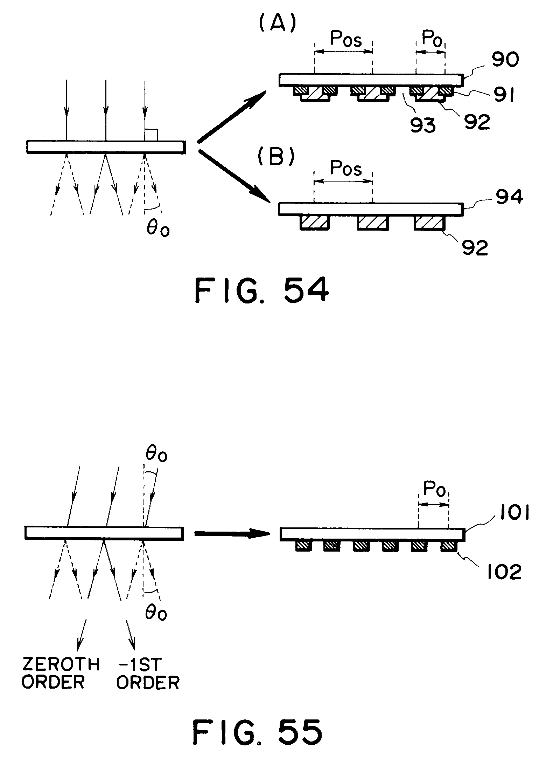

An embodiment for performing double-beam interference exposure by use of an ordinary projection exposure apparatus such as described above, will now be explained. First, description will be made on an example wherein the mask 81 and the illumination method therefor are set such as shown in Figure 54 or 55.

Figure 54 at (A) is a sectional view of a Levenson type phase shift mask 90 having a chromium light blocking portion 91 with a pitch in the perpendicular direction and the horizontal direction being set in accordance with equation (a1) below, and a shifter 92 with a pitch arranged in accordance with equation (a2) below.

$$P_0 = 2MR = M(\lambda/(2NA)) \tag{a1}$$

$$P_{0S} = 2P_0 = M(\lambda/NA) \tag{a2}$$

where R is resolution, M is magnification of the projection optical system 83, $\lambda$ is wavelength, and NA is the image side numerical aperture NA of the projection optical system 83.

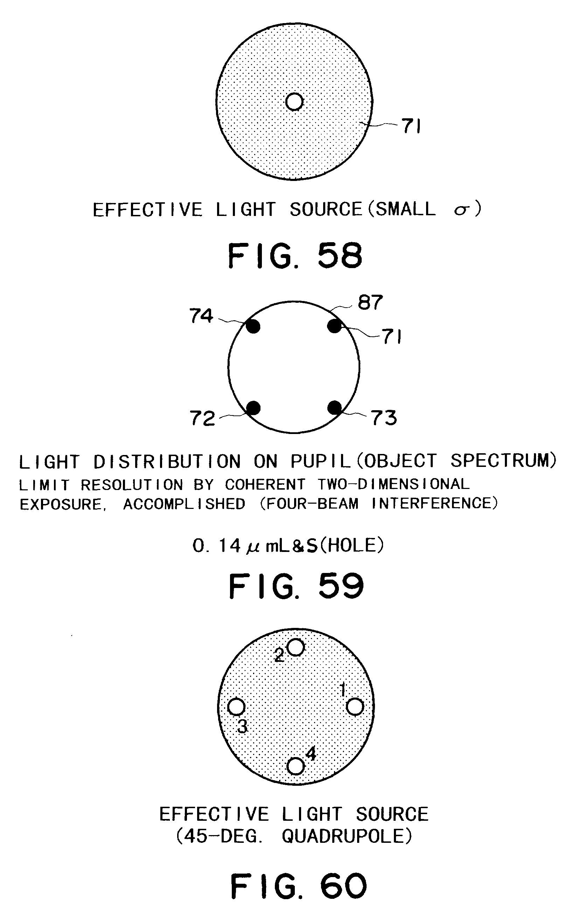

Both of phase shift masks shown at (A) and (B) of Figure 54 function so that, when the effective light source of the illumination system performs illumination with perpendicularly incident parallel light (coherence factor $\sigma = 0$), transmitted light rays in zeroth order diffraction direction, that is, in the perpendicular direction, cancel with each other because of the phase $\pi$ of adjacent transmission lights of the shifter, such that there is no zeroth order light from the mask. Positive and negative first order diffractive lights intensifying each other and defining 45 deg. with respect to the pattern array direction, are produced symmetrically with respect to the optical axis of the projection optical system. Diffractive light of second order or of orders higher it do not contribute to imaging, because of restriction by NA of the projection optical system. Figure 59 illustrates light intensity distribution upon the pupil plane 87, in this case.

In Figure 59, four lights 71, 72, 73 and 74 on the pupil plane 87 cause interference. By this, a check-like light intensity distribution (fine pattern) is produced on the photosensitive substrate 86.

Figure 60 is a schematic view of effective light sources in a case where a Levenson mask 90 is used and the illumination system is based on oblique incidence illumination. More specifically, the illumination system is based on quadrupole illumination in which four effective light sources are disposed in four directions of 0 deg., 90 deg., 180 deg.

and 270 deg., respectively.

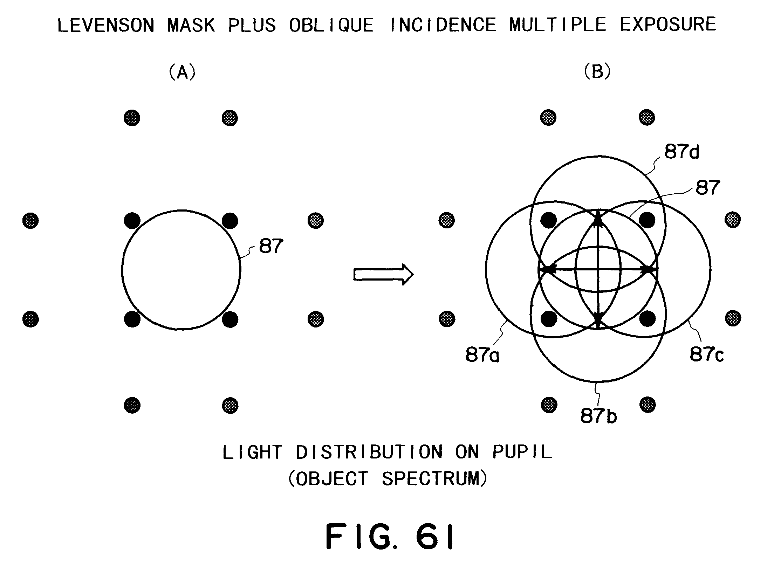

Figure 61 is a schematic view for explaining light intensity distribution on the pupil plane 87. The state shown at (A) of Figure 61 is that no diffractive light is formed inside the pupil plane 87 unless oblique incidence illumination is performed, so that no image is formed.

On the other hand, the stage shown at (B) of Figure 61 is that, due to oblique incidence illumination by the illumination system (using obliquely projected lights along four directions), positive and negative first order lights are incident upon the pupil (87a - 87d).

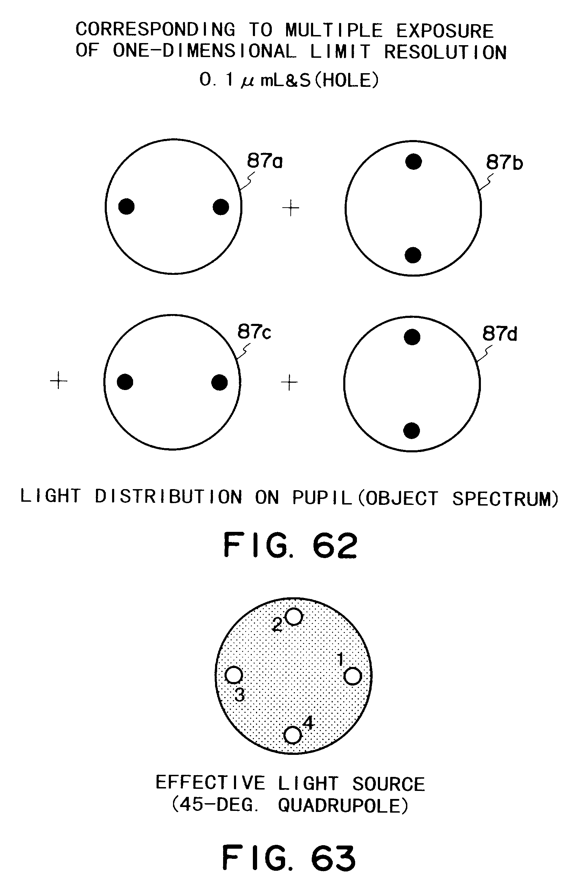

Figure 62 is a schematic view for explaining that the light intensity distribution on the pupil 87 shown in Figure 61 comprises combination of light intensity distributions upon four pupil planes denoted by 87a - 87d. On each of pupils 87a - 87d, there is double-beam interference caused by lights from light sources (painted circles).

More specifically, double-beam interference at 87a, double-beam interference at 87b, dual-beam interference at 87c and dual-beam interference at 87d are caused simultaneously. Superposed images of them are formed on the photosensitive substrate. Here, if, in the four-point illumination system effective light source, they are made mutually incoherent by an integrator such as a fly's eye lens, the produced is intensity superposition.

Next, an example using a mask such as shown in Figure 55 will be described. The mask of Figure 55 is an ordinary chromium mask, having a chromium light blocking portion 102 with its pitch in the horizontal direction and perpendicular direction being arranged in accordance with equation (a3), below, the same as equation (a1).

$$P_0 = 2MR = M(\lambda/(2NA)) \qquad (a3)$$

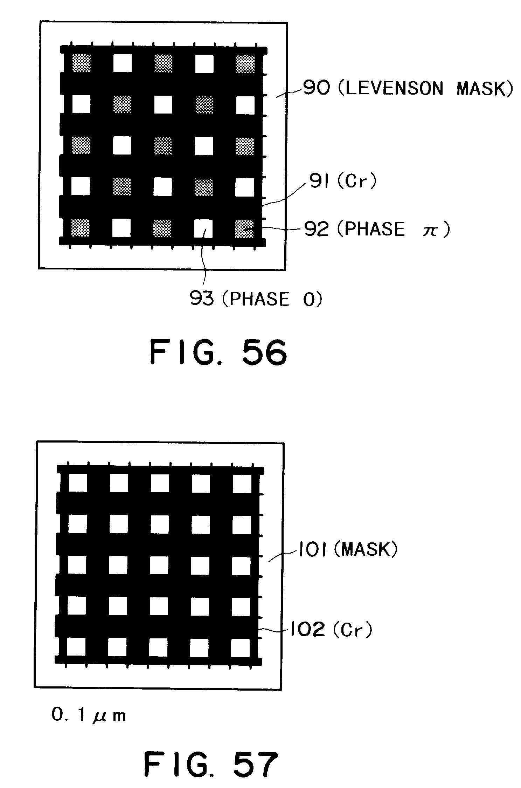

Figure 57 is a plan view of a main portion of the ordinary chromium mask 101 of Figure 55. In the mask of Figure 55, not based on phase shift method, the effective light sources of illumination system may be based on oblique incidence illumination with quadrupole in which four effective light sources are disposed at 0 deg., 90 deg., 180 deg. and 270 deg., as shown in Figure 63. The incident light in this case comprises parallel light having an angle $\theta_0$, where $\theta_0$ can be expressed by equation (a4) below.

$$\sin\theta_0 = M/NA \qquad (a4)$$

In response to such incident light, there are produced two lights passing through the mask 101, that is, zeroth order light advancing straight at the same angle $\theta_0$, and negative first order light advancing symmetrically with the zeroth order light with respect to the optical axis of the projection optical system, at an angle $-\theta_0$. These two lights pass through the pupil of the projection optical system, and they contribute to the imaging.

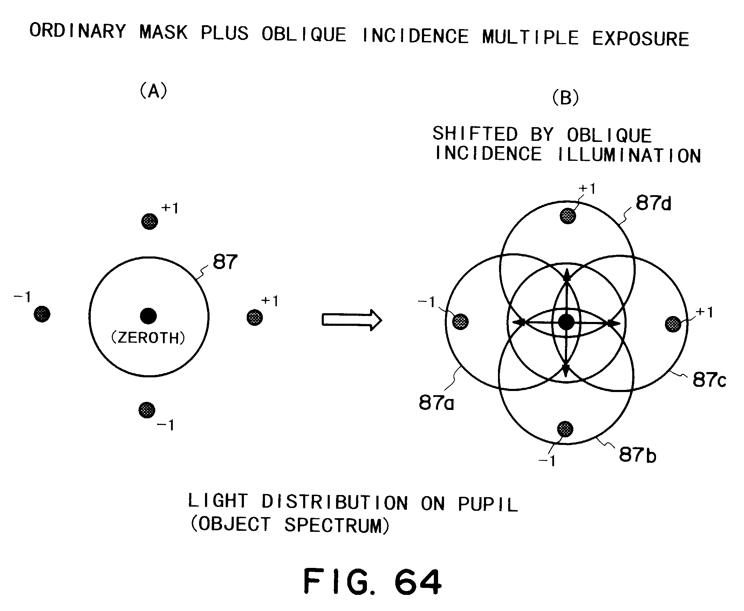

Figure 64 is a schematic view of light intensity distribution on the pupil 87, in this case. The state shown at (A) of Figure 64 is that, if the illumination system is set for perpendicular incidence illumination, only zeroth order light impinges on the pupil 87, such that no pattern image can be formed.

The state shown at (B) of Figure 64 is that, because of oblique incidence of lights along four directions (i.e., by means of oblique incidence lights in four directions), zeroth order lights and positive first order lights (or negative first order lights) are superposedly incident on the pupil plane (87a - 87d).

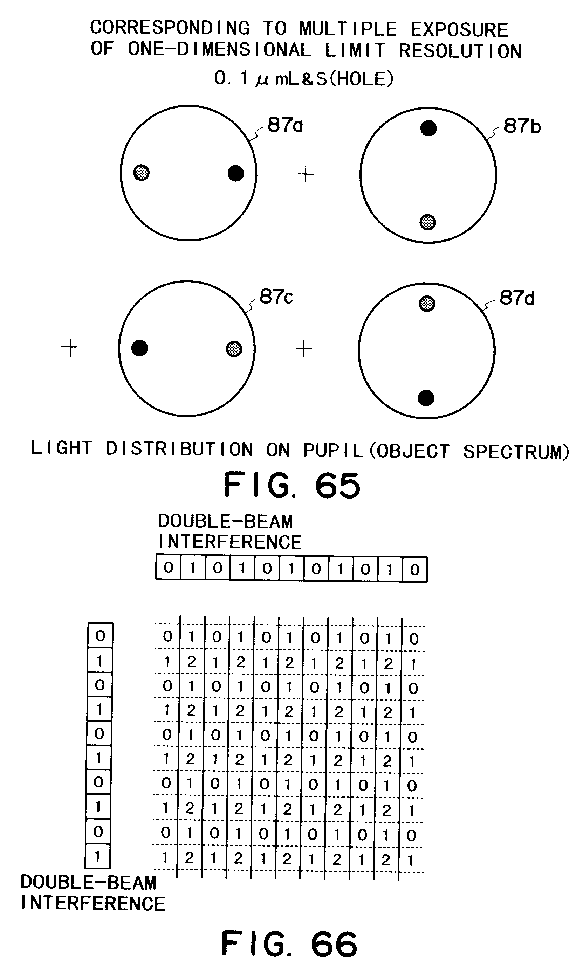

Figure 65 is a schematic view for explaining that the light intensity distribution on the pupil 87 shown in Figure 64(B) comprises combination of light intensity distributions upon four pupil planes denoted by 87a - 87d.

What is described above is an example of mask and illumination therefor for performing double-beam interference exposure by use of an ordinary projection exposure apparatus. By setting the components such as described above, a largest region of the NA of a projection optical system can be used.

In this embodiment, two-dimensional double-beam interference pattern exposure is performed by which a check-like pattern is produced. Figure 66 is a schematic view of an exposure pattern on a photosensitive substrate resulting from two-dimensional double-beam interference exposure of this embodiment, the exposure pattern being illustrated in the form of exposure amount map. In this embodiment, for an exposure pattern to be produced finally, the double-beam interference exposure is performed with the exposure amount of the same level with respect to the two directions.

In the exposure pattern shown in Figure 66, as a result of two times double-beam interference exposures, the exposure amount ranges by three stages from 0 to 2. To this exposure pattern, through ordinary exposure, a rough pattern of a size twice the minimum size in the interference exposure is superposed (dual exposure) with exposure amount of four stages from 0 to 3.

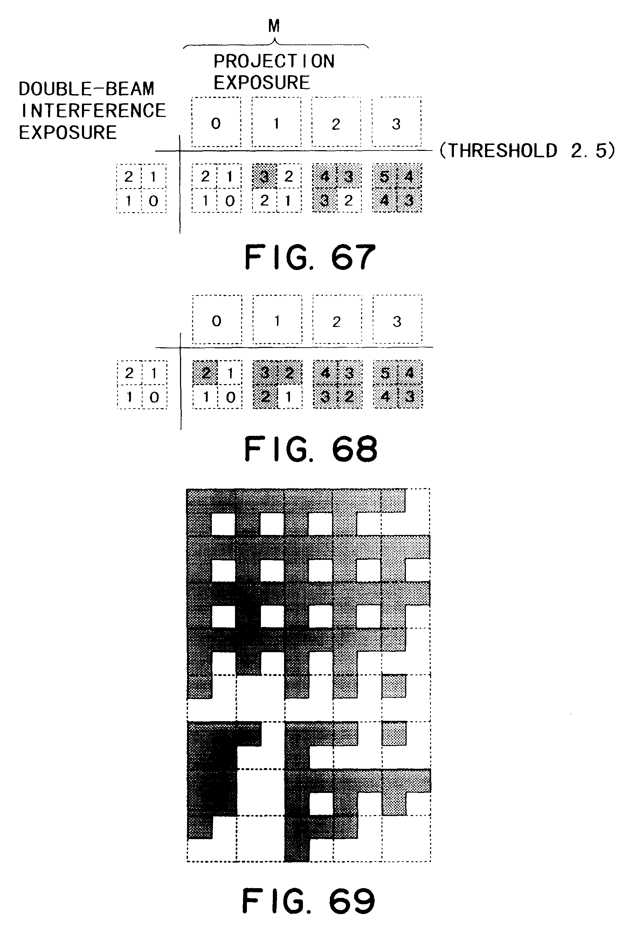

The exposure threshold of the photosensitive substrate may be set to be larger than 2 (the largest exposure amount in the double-beam interference exposure) and smaller than 3 (the largest exposure amount in projection exposure of ordinary pattern), as shown in Figure 67, that is 2.5, for example.

Figure 67 is a schematic view of an example of pattern which is obtainable by dual exposure based on double-beam interference exposure and projection exposure of ordinary pattern. Figure 67 schematically shows a mask M with an ordinary pattern having four stages of transmission factor.

The bottom portion of Figure 67 shows exposure amounts in the exposure pattern produced as a result of double-beam interference exposure of Figure 66 and of projection exposure with use of the mask M, applying exposure amounts of four stages (0, 1, 2 and 3). The regions with hatching represent portions above the exposure threshold, and these regions define a final exposure pattern in multiple exposure.

Figure 69 is a schematic view of an example of exposure pattern formed in accordance with to this embodiment. By changing the exposure amount in projection exposure in unit of block shown in Figure 67, a fine pattern can be produced in a wider area and in complicated shape.

Projection exposure with exposure amounts of four stages (0, 1, 2 and 3) such as described above may be performed in a single exposure by use of a halftone mask M having multiple transmission factors such as shown in Figure 67 and having phase difference corresponding to a multiple of $2\pi$.

Further, when the threshold is set to a level between 1 and 2, a pattern such as shown in Figure 68 can be produced only by the double-beam interference. It has four-stage transmission factors effective to provide four-stage exposure amounts, as shown in Figure 67. Among them, a block of 0% may be defined by chromium light blocking. The block of 100% may comprise quartz substrate only.

The blocks having 25% and 50% in transmission factor may be formed by vacuum deposition of a material or materials having a refractive index n and an absorption coefficient c, satisfying the following relation:

$$n/c = (m\lambda)/(-1nT)$$

where T is 0.25 or 0.50, m is an integer of 1 or 2, and $\lambda$ is the wavelength.

With the structure described above, at the boundary where the transmission factor changes, the quantity of phase shift becomes equal to a multiple of $2\pi$, and there occurs no change in exposure pattern due to the phase shift effect. Thus, by superposition with the double-beam interference exposure, a desired pattern such as shown in Figure 69 can be produced.

While in the foregoing examples description has been made to a transmission type halftone mask, the present invention is applicable to a reflection type halftone mask, with essentially the same structure.

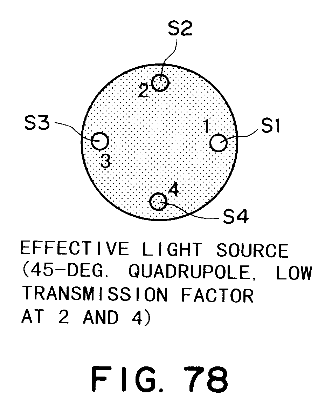

Figure 78 is a schematic view of an example where the illumination system is based on quadrupole illumination, wherein effective light sources S1 and S3 of the four effective light source have the same intensity while the light sources S2 and S4 have the same intensity but lower than the light sources S1 and S2.

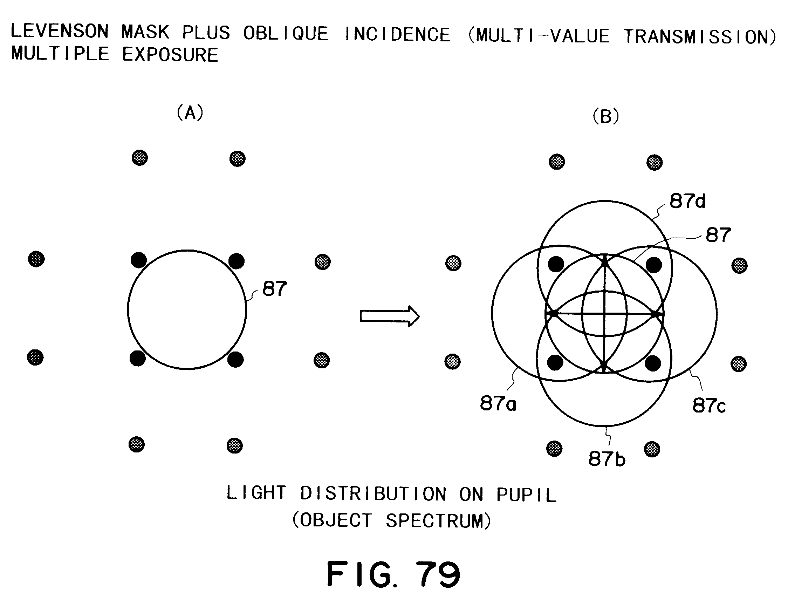

As regards the mask, a Levenson mask 90 may be used. Figure 79 at (A) is a schematic view for explaining light intensity distribution on the pupil 87, and it illustrates the state that no diffractive light is produced inside the pupil 87 so that no image is formed.

The state shown at (B) of Figure 79 is that the illumination system provides oblique incidence illumination (using obliquely projected lights along four directions) by which positive and negative first order diffractive lights are incident on the pupil (87a - 87d).

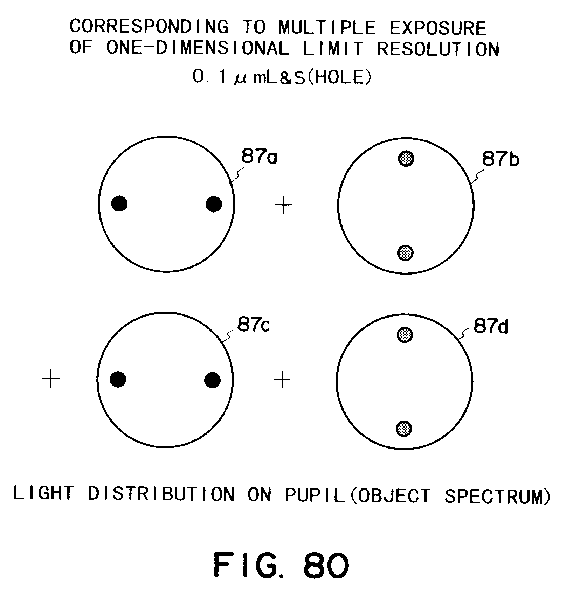

Figure 80 is a schematic view for explaining that the light intensity distribution on the pupil 87 of Figure 79 comprises combination of light intensity distributions upon four pupil planes denoted by 87a - 87d.

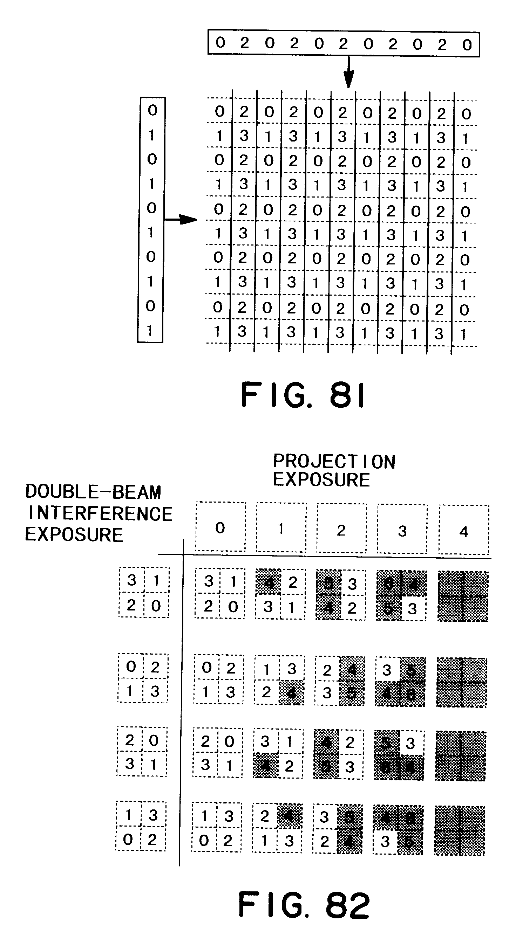

Figure 81 is a schematic view of an exposure pattern on a photosensitive substrate resulting from two-dimensional double-beam interference exposure of this embodiment, the exposure pattern being illustrated in the form of exposure amount map. In this embodiment, for an exposure pattern to be produced finally, the double-beam interference exposure is performed with the exposure amount of the same level with respect to the two directions.

In the exposure pattern shown in Figure 81, as a result of two times double-beam interference exposures, the exposure amount ranges by four stages from 0 to 3. To this exposure pattern, through ordinary projection exposure, a rough pattern is superposed (dual exposure) with exposure amount of five stages from 0 to 4.

The exposure threshold of the photosensitive substrate may be set to be larger than 3 (the largest exposure amount in the double-beam interference exposure) and smaller than 4 (the largest exposure amount in projection exposure of ordinary pattern), as shown in Figure 82.

Figure 82 is a schematic view of an example of pattern which is obtainable by dual exposure based on double-beam interference exposure and projection exposure of ordinary pattern. Figure 82 schematically shows a mask M with an ordinary pattern having five stages of transmission factor.

The bottom portion of Figure 82 shows exposure amounts in the exposure pattern produced as a result of double-beam interference exposure of Figure 81 and of projection exposure with use of the mask M, applying exposure amounts of five stages (0, 1, 2, 3 and 4). The regions with hatching represent portions above the exposure threshold, and these regions define a final exposure pattern in multiple exposure.

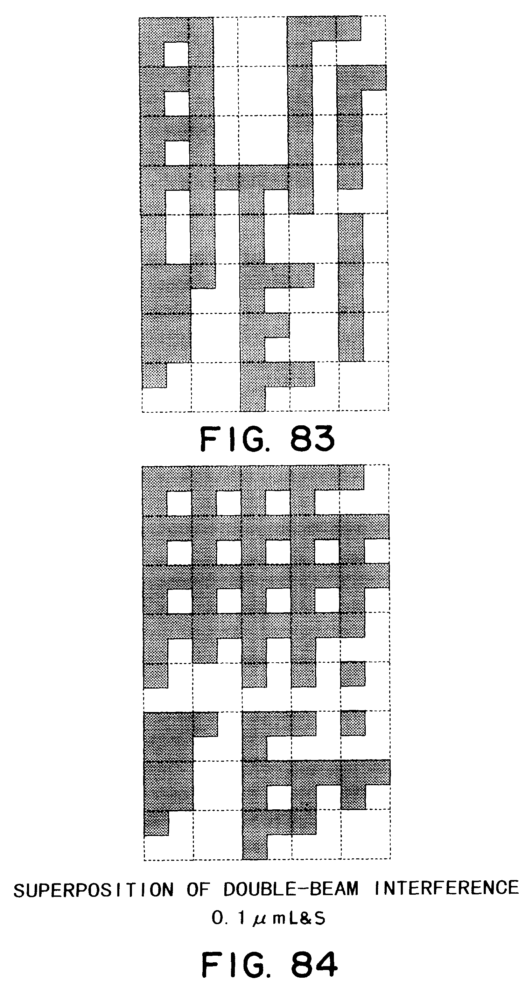

Figures 83 and 84 are schematic views of examples of exposure pattern formed in accordance with to this embodiment. By changing the exposure amount in projection exposure in unit of block shown in Figure 82, a fine pattern can be produced in a wider area and in complicated shape.

Projection exposure with exposure amounts of five stages (0, 1, 2, 3 and 4) such as described above may be performed in a single exposure by use of a halftone mask M of multiple values, such as shown in Figure 82.

As shown in Figure 82, it has five-stage transmission factors effective to provide five-stage exposure amounts. Among them, the 0% block may be defined by chromium light blocking. The 100% block may comprise quartz substrate only.

The blocks of 25%, 50% and 75% in transmission factor may be formed by vacuum deposition of a material or materials having a refractive index n and an absorption coefficient c, satisfying the following relation:

$$n/c = (m\lambda)/(-1nT)$$

where T is 0.25, 0.50 or 0.75, m is an integer of 1 or 2, and $\lambda$ is the wavelength.

With the structure described above, also at the boundary where the transmission factor changes, the quantity of phase shift becomes equal to a multiple of $2\pi$, and there occurs no change in exposure pattern due to the phase shift effect. Thus, by superposition with the double-beam interference exposure, a desired pattern such as shown in Figure 82 can be produced.

While in the foregoing examples description has been made to a transmission type halftone mask, the present invention is applicable to a reflection type halftone mask, with essentially the same structure.

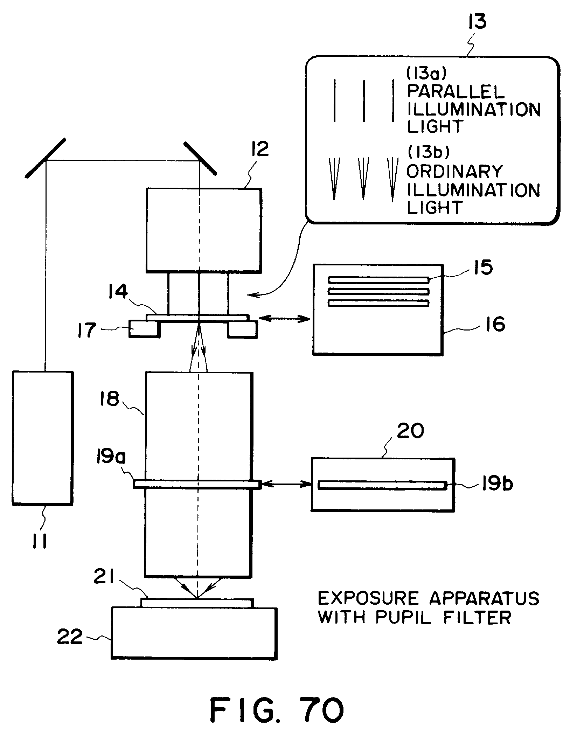

Referring now to Figure 70, an exposure apparatus according to another embodiment of the present invention for use with a chromium mask such as shown in Figure 55, will be described.

Figure 70 is a schematic view of an exposure apparatus according to an embodiment of the present invention. Denoted in the drawing at 11 is an exposure light source, and denoted at 12 is an illumination optical system. Schematic illustration at 13 shows illumination modes. Denoted at 14 is a chromium mask (Figure 19) to be used in this embodiment. Denoted at 15 are masks to be used interchangeably, and denoted at 16 is a mask changing mechanism. Denoted at 17 is a mask stage, and denoted at 18 is a projection optical system. Denoted at 19 is a pupil filter, and denoted at 20 is a filter changing mechanism. Denoted at 21 is a wafer, and denoted at 22 is a wafer stage.

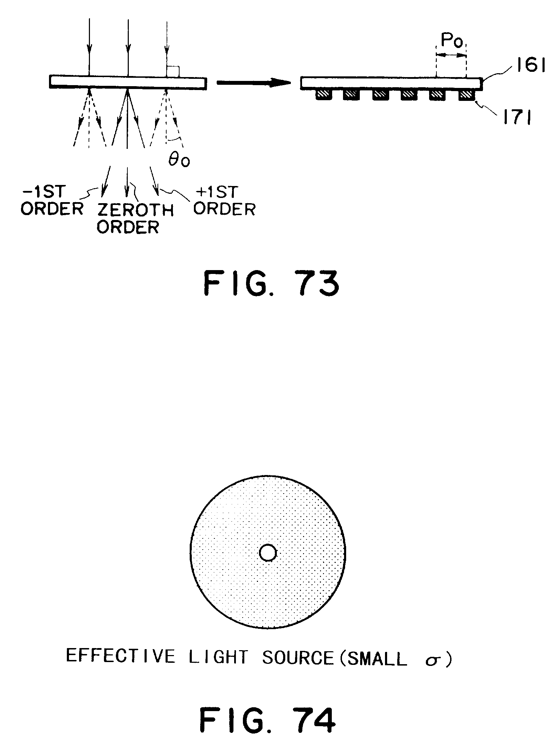

In this exposure apparatus, for double-beam interference exposure, the illumination optical system 12 is set to define an effective light source such as shown in Figure 74, so that as shown in Figure 70 at 13a the illumination performs coherent illumination (small $\sigma$ illumination using parallel or substantially parallel light impinging on the mask perpendicularly), while using a pupil filter 19a and while changing the mask to a double-beam interference mask 14 to be described later. For ordinary projection exposure, on the other hand, as shown in Figure 70 at 13b, the illumination is appropriately changed to partial coherent illumination while changing the pupil filter by another or retracting the same, appropriately, and changing the mask appropriately.

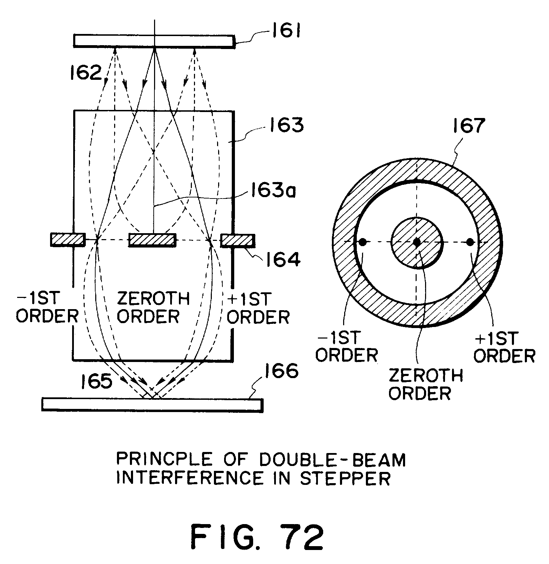

Referring to Figures 72 and 73, the principle of double-beam interference exposure to be made in the exposure apparatus of Figure 70 as well as the structure of double-beam interference mask, will be explained.

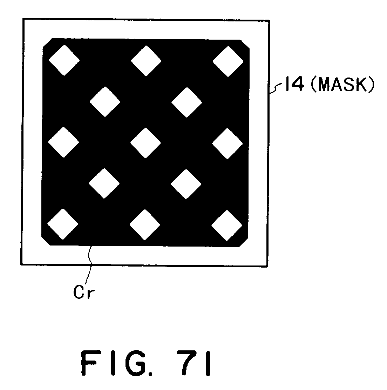

Figure 72 illustrates an exposure apparatus which includes a projection optical system of conventional type, consisting of an all refraction system, for example. A system of NA = 0.6 or more with respect to a wavelength 248 nm, is currently available. Denoted in the drawing at 161 is a double-beam interference mask having a pattern such as shown in Figure 71, for example. Denoted at 162 is object side exposure light. Denoted at 163 is a projection optical system, and denoted at 164 is an aperture stop. Denoted at 165 is image side exposure light, and denoted at 166 is a photosensitive substrate (wafer). Denoted at 167 is the position of light upon the pupil plane 164.

The drawing schematically shows double-beam interference exposure, and the object side exposure light 162 and the image side exposure light 165 each comprises two parallel light fluxes.

In this embodiment, in order to perform double-beam interference exposure with such ordinary projection exposure apparatus, the double-beam interference mask 161 and the illumination method are set such as shown in Figure 73. This will be described below, in detail.

Figure 73 is a sectional view of an example of double-beam interference mask having a two-dimensional periodic pattern with a chromium light blocking portion 171 of a pitch in the perpendicular direction and the horizontal direction being set in accordance with equation (b1) below.

$$P_0 = 4MR = M(\lambda/(NA)) \qquad (b1)$$

where R is resolution, $P_0$ is pitch of the periodic pattern on the mask 161, P is pitch of the periodic pattern on the photosensitive substrate 166, M is magnification of the projection optical system 163, $\lambda$ is wavelength, and NA is the image side numerical aperture NA of the projection optical system.

As shown in Figure 72, this embodiment uses substantially coherent illumination using substantially perpendicular light. Under such illumination, usually, there are three lights passing through the mask 161, that is, zeroth order light advancing straight, negative first order light and positive first order light advancing at angles $-\theta_0$ and $+\theta_0$, respectively, about the zeroth order light symmetrically with respect to the optical axis 163a of the projection optical system. These lights goes through the projection optical system 163, and they contribute to the imaging. In this embodiment, however, a mountable/demountable pupil filter (aperture stop) is disposed adjacent the pupil of the projection optical system to remove the zeroth order light, such that the same does not contribute to the imaging. As regards the pupil filter 164, one having a function for controlling transmissive amplitude or the phase of transmitted light may be used.

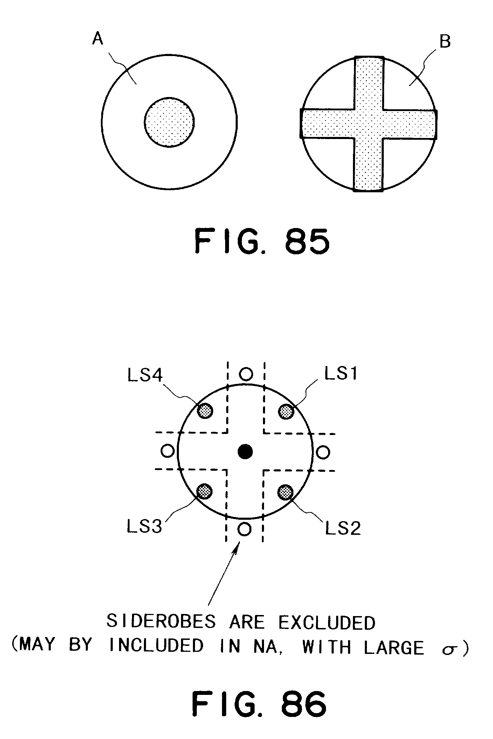

Example of such pupil filter 164 may be a filter A shown in Figure 85, having a light blocking area at the optical axis central portion, or a filter B having a light blocking area of cross-shape, though the filter B may be preferable.

An alternative is a filter such as shown in Figure 86 wherein only four effective light sources LS1 - LS4 can be transmitted.

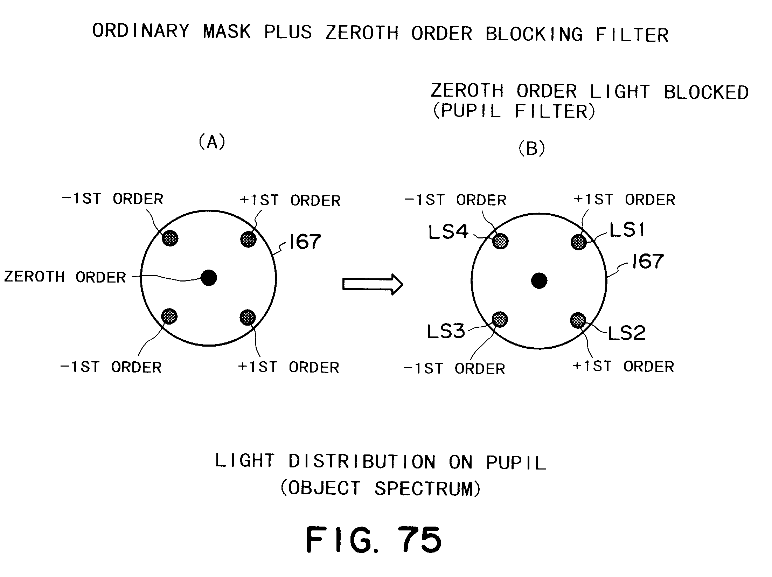

Figure 75 at (A) illustrates light intensity distribution (object spectrum) on the pupil 167, wherein there are five lights distributed, that is, zeroth order light and positive and negative first order lights.

Figure 75 at (B) shows the state in which zeroth order light is intercepted by using a zeroth order light blocking filter which may be the filter of Figure 85.

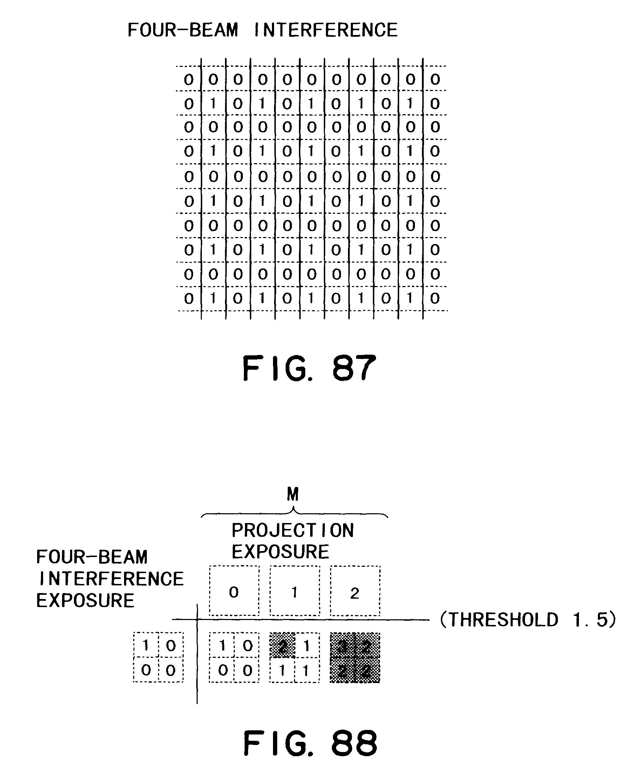

Figure 87 is a schematic view of an exposure pattern produced on a photosensitive substrate as a result of four-beam interference exposure using for effective light sources LS1 - LS4 in Figure 75, in accordance wit this embodiment, wherein the exposure pattern is illustrated in terms of exposure amount map. In the four-beam interference, the state of interference resulting when combined with the amplitude of light, will be treated.

In this embodiment, for an exposure pattern to be produced finally, the exposure amounts by lights from the light sources for the four-beam interference exposure are set at the same level.

In the exposure pattern shown in Figure 87, as a result of four-beam interference exposure, the exposure amount ranges by two stages of 0 and 1. To this exposure pattern, through ordinary exposure, a rough pattern is superposed (dual exposure) with exposure amount of three stages from 0 to 2.

The exposure threshold of the photosensitive substrate may be set to be larger than 1 (the largest exposure amount in the four-beam interference exposure) and smaller than 2 (the largest exposure amount in projection exposure of ordinary pattern), as shown in Figure 88, that is 1.5, for example.

Figure 88 is a schematic view of an example of pattern which is obtainable by dual exposure based on four-beam interference exposure and projection exposure of ordinary pattern. Figure 88 schematically shows a mask M with an ordinary pattern having three stages of transmission factor.

The bottom portion of Figure 88 shows exposure amounts in the exposure pattern produced as a result of four-beam interference exposure of Figure 87 and of projection exposure with use of the mask M, applying exposure amounts of three stages (0, 1, and 2). The regions with hatching represent portions above the exposure threshold, and these regions define a final exposure pattern in multiple exposure.

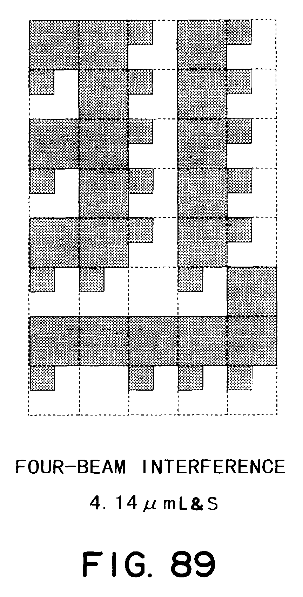

Figure 89 is a schematic view of an example of exposure pattern formed in accordance with to this embodiment. By changing the exposure amount in projection exposure in unit of block shown in Figure 88, a fine pattern can be produced in a wider area and in complicated shape.

Projection exposure with exposure amounts of three stages (0, 1, and 2) such as described above may be performed in a single exposure by use of a halftone mask M having multiple values as shown in Figure 88.

As shown in Figure 88, it has three-stage transmission factors effective to provide three-stage exposure amounts. The values of transmission factors are arbitrary, and, for example, it has transmission factors of 0%, 50% and 100%. Among them, the 0% block may be defined by chromium light blocking. The 100% block may comprise quartz substrate only.

The block having 50% in transmission factor, for example, may be formed by vacuum deposition of a material or materials having a refractive index n and an absorption coefficient c, satisfying the following relation:

$$n/c = (m\lambda)/(-1nT)$$

where T is 0.50, m is an integer of 1, and $\lambda$ is the wavelength.

With the structure described above, at the boundary where the transmission factor changes, the quantity of phase shift becomes equal to a multiple of $2\pi$, and there occurs no change in exposure pattern due to the phase shift effect. Thus, by superposition with the double-beam interference exposure, a desired pattern such as shown in Figure 89 can be produced.

While in the foregoing examples description has been made to a transmission type halftone mask, the present invention is applicable to a reflection type halftone mask, with essentially the same structure.

In the manner described hereinbefore, a projection exposure apparatus basically for ordinary projection exposure is used also to double-beam interference exposure. Further, since this method uses positive and negative first order light, the pitch of the double-beam interference mask can be made twice larger than the normal pitch. Moreover, there is no necessity of providing the mask with a fine phase film, as in Levenson type mask. This is very advantage in fabrication of the mask.

What is described above is an example of mask 161 and illumination therefor for performing double-beam interference exposure by use of an ordinary projection exposure apparatus. By setting the components such as described above, a largest region of the NA of a projection optical system can be used.

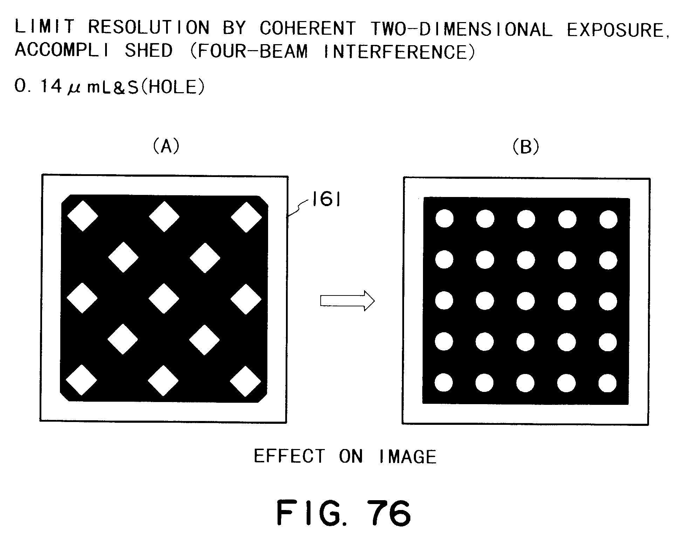

Figure 76 at (A) is a schematic view of an example of mask 161. Figure 76 at (B) shows a check-like pattern image to be formed on a photosensitive substrate 21 surface in accordance with this embodiment, by using the pupil filter 19a to intercept the zeroth order light and by performing double-beam interference with respect to two directions of horizontal and perpendicular directions.

In the state shown in Figure 76, pattern images of circular shape are formed two-dimensionally and periodically. About or less than the limit resolution, there is no spatially high frequency component and, depending on the resist threshold level, rectangular shape of check is rounded. Thus, a matrix distribution of fine circles can be produced.

In this embodiment, a check pattern produced by double-beam interference exposure, which would otherwise disappear only through high resolution pattern exposure because of the threshold of the photosensitive substrate, is superposed by multiple exposure with projection exposure of ordinary circuit pattern. By this, based on combined effect of these pattern exposures, the check pattern is selectively retrieved and, thus, a circuit pattern of desired shape can be produced.

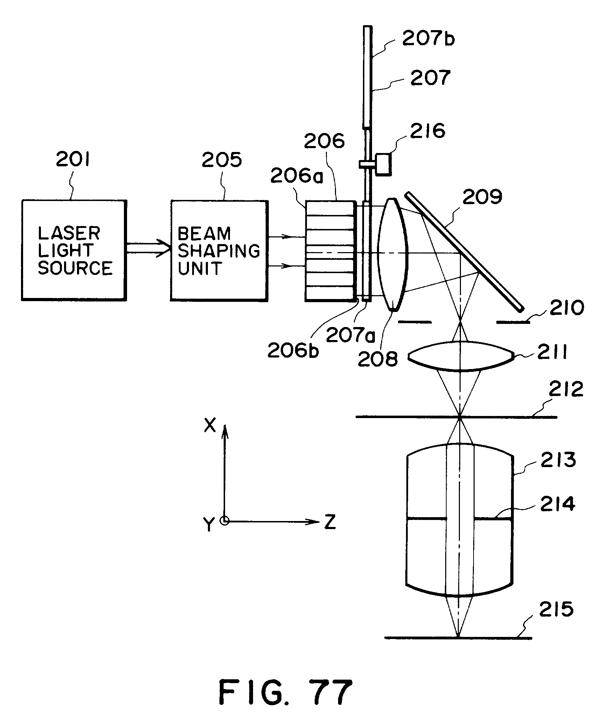

Figure 77 is a schematic view of a specific optical arrangement of an exposure apparatus, according to an embodiment of the present invention.

In this embodiment, the invention is applied to a step-and-repeat or step-and-scan type exposure apparatus, for lithography of submicron order or quarter-micron order.

In the drawing, laser light from a laser light source 201 enters a beam shaping unit 205 by which its beam diameter is enlarged. The light then impinges on a light entrance surface 206a of an optical integrator 206. The optical integrator 206 comprises a plurality of small lenses (fly's eye lenses) $6_i$ (i = 1 to N) having rectangular or circular sectional shape, which are arrayed two-dimensionally at a predetermined pitch. It defines secondary light sources adjacent the light exit surface 206b thereof.

Denoted at 207 is a stop which serves to determine the shape of secondary light sources. The stop 207 is provided with a stop changing mechanism (actuator) 216 so that various stops such as 207a, 207b, for example, are interchangeably placed at the light path by this mechanism in accordance with the illumination condition. As an example, the stop 207 may include an ordinary stop with circular opening, a ring-like illumination stop for changing light intensity distribution on a pupil plane 214 of a projection lens 213, a quadrupole illumination stop, and a small σ illumination stop, for example, one of which may be selectively placed at the light path.

In this embodiment, by using various stops 207, the light impinging on a condensing lens 208 is changed in various ways to control the light intensity distribution on the pupil plane 214 of the projection optical system 213 appropriately. The condensing lens 208 functions to collect plural light fluxes, emitted from the secondary light sources adjacent the light exit surface 206b of the optical integrator 206 and passed through the stop 207, so that, after reflection by a mirror 209, these light fluxes are superposed on the surface of a masking blade 210 to illuminate this surface uniformly. The masking blade 210 comprises a plurality of movable light blocking plates, for defining a desired aperture shape.

Denoted at 211 is an imaging lens which functions to transfer the aperture shape of the masking blade 210 onto the surface of a reticle (mask) 212, which is the surface to be illuminated, to thereby illuminate a required region on the reticle 212 surface uniformly.

Denoted at 213 is the projection optical system (projection lens) for projecting, in reduced scale, a circuit pattern of the reticle 212 onto a wafer (substrate) 215 placed on a wafer chuck. Denoted at 214 is the pupil plane of this projection optical system 213. On this pupil plane 214, various aperture stops such as shown in Figure 18 can be demountably disposed.

In the optical arrangement of this embodiment, the masking blade 210, the reticle 212 and the wafer 215 are placed in optically conjugate relation with each other. Also, the stop 207a and the pupil plane 214 of the projection optical system 213 are placed substantially in conjugate relation with each other.

With the structure described above, in this embodiment, the pattern of the reticle 212 is projected on the wafer 215 surface in reduced scale. Then, through a predetermined developing process, devices (semiconductor devices) are produced.

In this embodiment, as described above, stops having different aperture shapes are selectively used in accordance with the shape of the pattern of the reticle 212 which is going to be used, to thereby change the light intensity distribution to be formed on the pupil plane 214 of the projection optical system 213 in various ways.

As regards the illumination method in the illumination optical system, a KrF excimer laser, ArF excimer laser or $F_2$ excimer laser may be used to illuminate the mask pattern with light from the laser.

The projection optical system of the exposure apparatus may comprise one of a dioptric system, a catadioptric system, and catoptric system, for projecting the mask pattern.

The exposure apparatus may be of step-and-repeat type or step-and-scan type.

Next, an embodiment of a semiconductor device manufacturing method which uses a projection exposure apparatus according to any one of the preceding embodiments, will be explained.

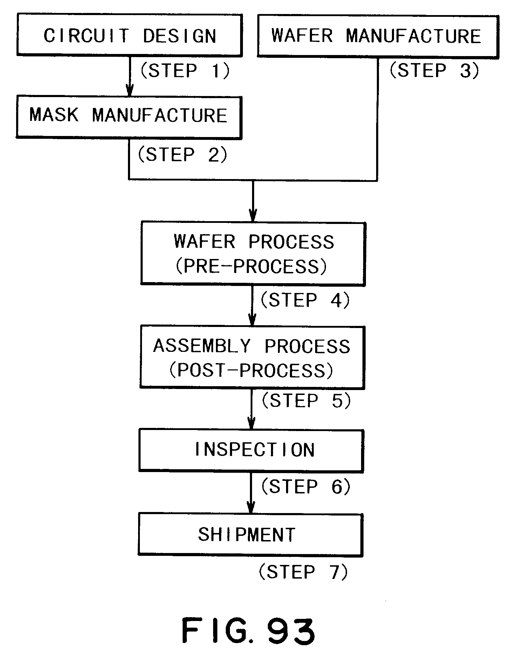

Figure 93 is a flow chart of procedure for manufacture of microdevices such as semiconductor chips (e.g. ICs or LSIs), liquid crystal panels, or CCDs, for example.

Step 1 is a design process for designing a circuit of a semiconductor device. Step 2 is a process for making a mask on the basis of the circuit pattern design. Step 3 is a process for preparing a wafer by using a material such as silicon. Step 4 is a wafer process which is called a pre-process wherein, by using the so prepared mask and wafer, circuits are practically formed on the wafer through lithography. Step 5 subsequent to this is an assembling step which is called a post-process wherein the wafer having been processed by step 4 is formed into semiconductor chips. This step includes assembling (dicing and bonding) process and packaging (chip sealing) process. Step 6 is an inspection step wherein operation check, durability check and so on for the semiconductor devices provided by step 5, are carried out. With these processes, semiconductor devices are completed and they are shipped (step 7).

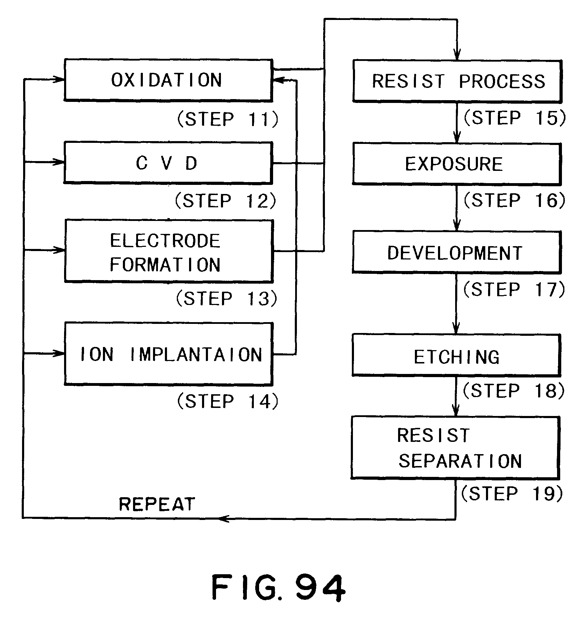

Figure 94 is a flow chart showing details of the wafer process.

Step 11 is an oxidation process for oxidizing the surface of a wafer. Step 12 is a CVD process for forming an insulating film on the wafer surface. Step 13 is an electrode forming process for forming electrodes upon the wafer by vapor deposition. Step 14 is an ion implanting process for implanting ions to the wafer. Step 15 is a resist process for applying a resist (photosensitive material) to the wafer. Step 16 is an exposure process for printing, by exposure, the circuit pattern of the mask on the wafer through the exposure apparatus described above. Step 17 is a developing process for developing the exposed wafer. Step 18 is an etching process for removing portions other than the developed resist image. Step 19 is a resist separation process for separating the resist material remaining on the wafer after being subjected to the etching process. By repeating these processes, circuit patterns are superposedly formed on the wafer.

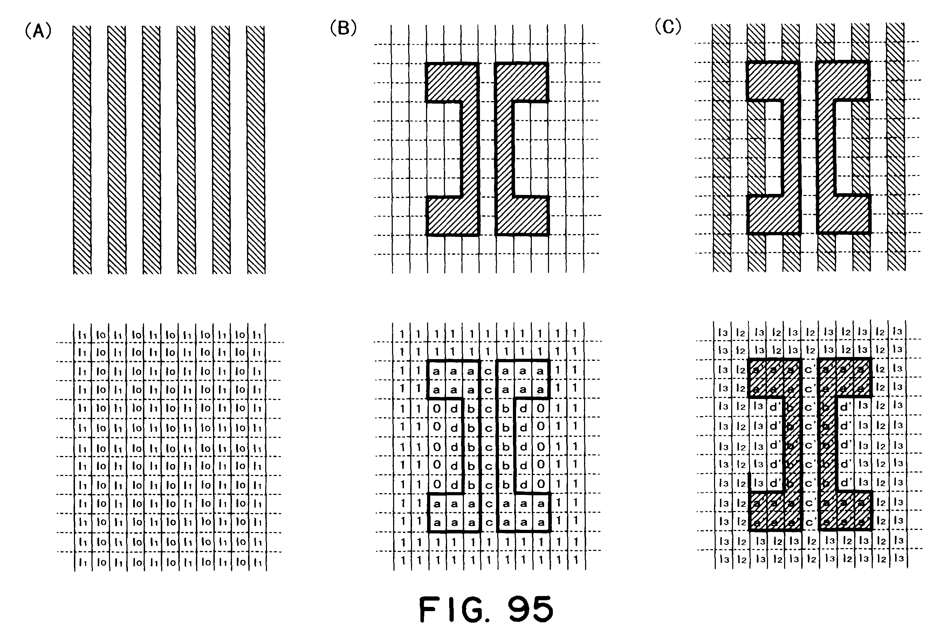

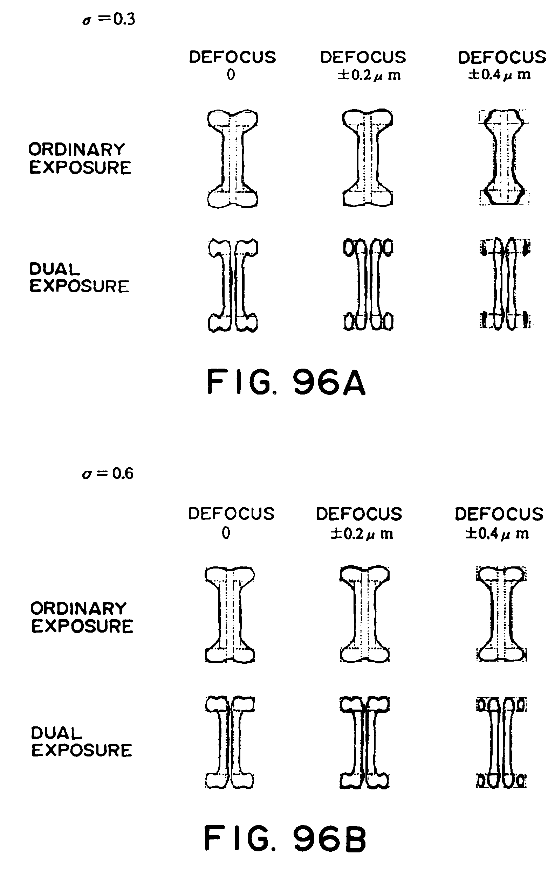

A further embodiment of the present invention will now be described with reference to Figures 95 and 96A - 96 similar to Figures 90, 91A, 91B, 92A and 92B, described hereinbefore. This embodiment relates to an example where a positive type resist is used in conjunction with a KrF excimer stepper of wavelength 248 nm.

Like the embodiment described hereinbefore, an optimum light quantity ratio is determined with respect to a positive type resist. In this positive type resist, through a development process, the portion having been irradiated with light transmitted through a reticle is removed while a portion blocked by the reticle remains. In order that a pattern corresponding to the reticle pattern remains after the development process, the exposure process may be performed by use of a reticle with a pattern made of a light blocking material, the light passing through the portion around the reticle pattern. In this type of reticle, the light intensity at the portion around the pattern may be 1 while the light intensity at the pattern portion is 0. Thus, after ordinary exposure process, there is provided a light quantity distribution such as shown in Figure 95, having a light intensity of 1 at the portion around the pattern.

In the case of positive type resist, when the maximum level of intensity distribution of an image of a periodic pattern is $I_0$ and the minimum level there of is $I_1$, a combined image may have an intensity distribution:

$$a' = k*a + I_1$$

$$a'' = k*a + I_0$$

$$b' = k*a + I_1$$

$$c' = k*c + I_0$$

$$d' = k*d + I_0$$

If the maximum intensity value around the pattern is $I_{2max}$ (corresponding to $I_2$ in Figure 95(A)) and the minimum intensity value around the pattern is $I_{2min}$ (corresponding to $I_3$ in Figure 95(C)),

$$I_{2max} = K*1+I_0 = I_2$$

$$I_{2min} = K*1+I_1 = I_3$$

The exposure amount distribution provided by periodic pattern exposure (at bottom of Figure 95(A)) and exposure amount distribution provided by ordinary projection exposure (best focus) (at bottom of Figure 95(B)), under different illumination conditions, are as follows:

[Illumination Condition 1]

Periodic pattern exposure was made with $\sigma = 0.3$, while ordinary pattern exposure was made with $\sigma = 0.3$ (Figure 96A).

$$I_0 = 0.80$$

$$I_1 = 0.23$$

$$a = 0.03$$

$$b = 0.27$$

$$c = 0.21$$

$$d = 0.58$$

When

$$k = 1.5,$$

$$a' = 0.28$$

$$a'' = 0.85$$

$$b' = 0.64$$

$$c' = 1.12$$

$$d' = 1.67$$

$$I_{2min} = 1.73$$

are obtained. When standardized by division by (K*1+1) to define peripheral intensity of 1, the following may result:

$$a' = 0.11$$

$$a'' = 0.34$$

$$b' = 0.23$$

$$c' = 0.45$$

$$d' = 0.67$$

$$I_{2min} = 0.69$$

Since standardized resist threshold value $I_C$ should be:

$$a' = k*a+I_1 < I_C$$

$$a'' = k*a+I_0 < I_C$$

$$b' = k*a+I_1 < I_C$$

$$c' = k*c+I_0 > I_C$$

$$I_{2min} = K*1+I_1 > I_C$$

it follows that $0.34 < I_C$ and $0.45 > I_C$.

[Illumination Condition 2]

Periodic pattern exposure was made with $\sigma = 0.3$, while ordinary pattern exposure was made with $\sigma = 0.6$ (Figure 96B).

$$I_0 = 0.80$$

$$I_1 = 0.23$$

$$a = 0.04$$

$$b = 0.26$$

$$c = 0.23$$

$$d = 0.58$$

when

$$k = 2.0$$

$$a' = 2.23$$

$$a'' = 0.88$$

$$b' = 0.75$$

$$c' = 1.26$$

$$d' = 1.96$$

$$I_{2min} = 2.23$$

are obtained. When standardized by division by (K*1+1) to define peripheral intensity of 1, the following may result:

$$a' = 0.01$$

$$a'' = 0.29$$

$$b' = 0.25$$

$$c' = 0.42$$

$$d' = 0.65$$

$$I_{2min} = 0.74$$

The standardized resist threshold $I_C$ is $0.29 < I_C$ and $0.42 > I_C$.

[Illumination Condition 3]

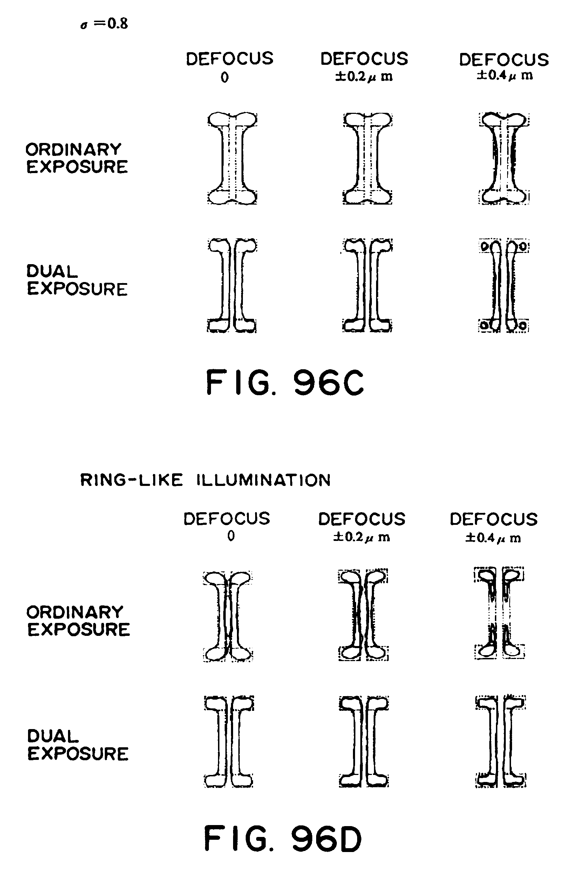

Periodic pattern exposure was made with $\sigma = 0.3$, while ordinary pattern exposure was made with $\sigma = 0.8$ (Figure 96C).

$$I_0 = 0.80$$

$$I_1 = 0.23$$

$$a = 0.05$$

$$b = 0.26$$

$$c = 0.27$$

$$d = 0.59$$

when

$$k = 2.5$$

$$a' = 0.36$$

$$a'' = 0.93$$

$$b' = 0.88$$

$$c' = 1.47$$

$$d' = 2.28$$

$$I_{2min} = 2.73$$

are obtained. When standardized by division by (K*1+1) to define peripheral intensity of 1, the following may result:

$$a' = 0.10$$

$$a'' = 0.26$$

$$b' = 0.25$$

$$c' = 0.42$$

$$d' = 0.65$$

$$I_{2min} = 0.78$$

Thus, the standardized resist threshold $I_C$ is $0.26 < I_C < 0.42$.

[Illumination Condition 4]

Periodic pattern exposure was made with $\sigma = 0.3$, while ordinary pattern exposure was made with $\sigma = 0.8$ in ring-like illumination. The illuminance distribution at the inside (ring inside) not greater than $\sigma$ 0.6 was zero (Figure 96D).

$$I_0 = 0.80$$

$$I_1 = 0.23$$

$$a = 0.06$$

$$b = 0.26$$

$$c = 0.35$$

$$d = 0.62$$

when

$$k = 3.0$$

$$a' = 0.41$$

$$a'' = 0.98$$

$$b' = 1.01$$

$$c' = 1.85$$

$$d' = 2.66$$

$$I_{2min} = 3.23$$

are obtained. When standardized by division by $(K*1+1)$ to define peripheral intensity of 1, the following may result:

$$a' = 0.10$$

$$a'' = 0.25$$

$$b' = 0.25$$

$$c' = 0.46$$

$$d' = 0.67$$

$$l_{2min} = 0.81$$

Thus, the standardized resist threshold $l_C$ is $0.25 < l_C < 0.46$.

When the standardized resist threshold is within the above-described range, the intensity of exposure amount distribution with standardized a', a" and b' is lower than the threshold, and c', d' and $l_{2min}$ are larger than the threshold. Since only the portion with exposure amount less than the resist threshold remains after the development, only exposure amount distribution of a', a" and b' remains as a pattern after the development. Thus, the gray portion at bottom of Figure 95(C) corresponds to the shape remaining after the developing process.

The intensity distribution described in this embodiment is standardized on an assumption that the light quantity applied to the reticle and the light quantity projected to the wafer are equal to each other. The light quantity ratio described is calculated on the basis of this intensity distribution, and an optimum light quantity ratio may be about the light quantity ratio mentioned above with reference to the illumination conditions described above.

Practically, the light quantity applied to the reticle may differ from the light quantity projected to the wafer surface. Also, depending on the illumination condition, the ratio of the received light quantity and the light quantity emitted therefrom may change. Therefore, in an exact sense, the optimum light quantity ratio may change. However, an optimum light quantity ratio may well be determined in accordance with calculations described above, on the basis of intensity distributions by the ordinary exposure and by the high-contrast periodic pattern exposure.

Namely, what is important is to adjust the exposure amounts in these exposure processes so that an optimum light quantity ratio is accomplished and, additionally, that the exposure amount distribution of a combined image satisfies the magnitude relation in calculation with respect to the resist threshold.

As has been described with reference to some foregoing embodiments, the exposure amount distribution varies with the illumination condition, and also the size of the pattern changes.

Further, a practical resist threshold may be a multiple of this standardized resist threshold, and a practical exposure amount distribution may be a multiple of this standardized exposure amount distribution. In practice, as regards the exposure amount distribution, the exposure amount may be adjusted in accordance with a resist threshold in practice so as to provide a proper accumulated exposure amount while maintaining an optimum light quantity ratio in the multiple exposure.

Namely, the pattern shape after a development process is determined by the magnitude relation between an accumulated exposure amount distribution in practice and a resist threshold in practice. In the case of positive type resist, the portion with exposure amount distribution less than the resist threshold remains. thus, the exposure amount distribution for a portion to be remained as a pattern may be adjusted to be less than the resist threshold.

While the invention has been described with reference to the structures disclosed herein, it is not confined to the details set forth and this application is intended to cover such modifications or changes as may come within the purposes of the improvements or the scope of the following claims.

## Claims

1. An exposure method for exposing a resist with a pattern image of a mask having patterns being different with respect to contrast of image,
   characterized in that:
   the position where an image of a pattern, of the patterns of the mask, having lower contrast of image is formed is exposed with an image of contrast higher than the lower contrast image, whereby contrast of exposure amount distribution related to the pattern of lower contrast is improved.

2. An exposure method for exposing a resist to an image of a pattern of a mask with radiation,
   characterized in that:
   an image of contrast higher than that of the image of the pattern is formed by use of radiation having the same wavelength as the first-mentioned radiation, and the position on the resist where the image of the pattern is formed is exposed with the image of higher contrast, whereby contrast of exposure amount distribution related to the pattern of the resist is improved.

3. An exposure method for exposing a resist with an image of a pattern of a mask, characterized in that:
   an image of contrast higher than that of an image of the pattern is formed without use of the mask, and the position on the resist where the image of the pattern is formed is exposed with the image of higher contrast, whereby contrast of exposure amount distribution related to the pattern of the resist is improved.

4. An exposure method according to Claim 2 or 3, wherein the mask has a circuit pattern such as a gate pattern, including a pattern of higher contrast of image and a pattern of lower contrast of image, and wherein the position where the image of pattern of lower contrast is formed is exposed with the higher contrast image.

5. An exposure method according to Claim 1 or 3, wherein the exposure with the pattern image of the mask and the exposure with the higher contrast image are made by use of the same exposure wavelength.

6. An exposure method according to any one of Claims 1 - 5, wherein the resist is exposed with the higher contrast image and the image of the pattern simultaneously.

7. An exposure method according to any one of Claims 1 - 5, wherein the resist is exposed with the higher contrast image and, thereafter, it is exposed with the image of the pattern.

8. An exposure method according to any one of Claims 1 - 5, wherein the resist is exposed with the image of the pattern and, thereafter, it is exposed with the higher contrast image.

9. An exposure method according to any one of Claims 1 - 5, wherein the image of higher contrast is formed by projecting a mask of phase shift type.

10. An exposure method according to Claim 9, wherein the phase shift type mask comprises a Levenson type phase shift mask.

11. An exposure method according to Claim 10, wherein the phase shift type mask includes a phase shifter portion for applying a mutual phase shift of 180 deg. to radiation beams passing through two regions, respectively, without passing a light blocking portion.

12. An exposure method according to Claim 9, wherein the phase shift type mask includes an isolated pattern provided by the phase shifter portion.

13. An exposure method according to Claim 11, wherein the phase shift type mask includes a repetition pattern having arrayed phase shifter portions.

14. An exposure method according to any one of Claims 1 - 13, wherein the image of higher contrast is formed by projecting two parallel lights, resulting from division of laser light, onto the resist in different directions, to cause interference of them on the resist.

15. An exposure method according to any one of Claims 1 - 12, wherein the image of higher contrast is formed by using a probe of light or electrons.

16. An exposure method according to any one of Claims 1 - 13, wherein the image of higher contrast is formed by illuminating a repetition pattern of the mask along an oblique direction and by projecting it.

17. An exposure method according to any one of Claims 1 - 16, wherein the first-mentioned mask comprises a phase shift mask.

18. An exposure method according to Claim 17, wherein the first-mentioned mask comprises a phase shift mask of one of halftone type, rim type and chromium-less shifter light blocking type.

19. An exposure method according to any one of Claims 1 - 18, wherein the pattern of the first-mentioned mask is illuminated along an oblique direction and is projected by a projection optical system.

20. An exposure method according to any one of Claims 1 - 16, wherein the radiation comprises one of ultraviolet rays, X-rays and electron rays.

21. An exposure method according to any one of Claims 1 - 4, wherein the image of the pattern is formed in a state where σ is not less than 0.6, and wherein the image of higher contrast is formed in a state where σ is not greater than 0.3 and by imaging a pattern of a phase shift mask.

22. An exposure method according to Claim 21, wherein the phase shift mask comprises a Levenson type phase shift mask.

23. An exposure method, characterized in that multiple exposure is performed with use of the same exposure wavelength, on the basis of a periodic pattern exposure wherein exposure is made by use of a periodic pattern formed by interference of two light beams, and of an ordinary exposure wherein exposure is made by use of a mask having a pattern of linewidth not larger than a resolving power of an exposure apparatus to be used.

24. An exposure method according to Claim 23, wherein the periodic pattern has a period upon a surface to be exposed which period is twice or about twice of a value of minimum linewidth of the mask pattern as converted with respect to the surface to be exposed.

25. An exposure method according to Claim 23, wherein the dual exposure is performed so that a center or peak of light intensity distribution of a pattern on the surface to be exposed, corresponding to the periodic pattern, is substantially registered with a center of an image of the minimum linewidth pattern of the mask pattern.

26. An exposure method according to any one of Claims 1, 2, 3, 4, 5 and 23, wherein each of the exposures is performed by use of exposure light having a center wavelength not longer than 250 nm.

27. An exposure method according to Claim 26, wherein the exposure light is supplied by KrF excimer laser or ArF excimer laser.

28. An exposure method, characterized in that multiple exposure is performed with use of the same exposure wavelength, on the basis of a periodic pattern exposure wherein exposure is made by use of a periodic pattern, and of an ordinary exposure wherein exposure is made by use of a mask having a pattern of a size not larger than a resolving power of an exposure apparatus to be used.

29. An exposure apparatus characterized by an exposure mode in which exposure is performed in accordance with an exposure method as recited in any one of Claims 1 - 28.

30. An exposure apparatus according to Claim 29, wherein said apparatus comprises an alignment system.

31. A device manufacturing method, characterized by transferring a device pattern of a mask onto a photosensitive substrate in accordance with an exposure method as recited in any one of Claims 1 - 28.

32. A multiple exposure method for exposing a resist so that, with a development process, a first fine pattern and a second fine pattern having a linewidth larger than that of the first fine pattern can be formed on the resist, said method comprising:

a first exposure step for exposing the resist in relation to the first fine pattern, on the basis of interference fringe provided by interference of plural lights and in accordance with an exposure amount with which the first fine pattern can not be formed through the development process; and
a second exposure step for exposing a portion of an exposed region of the resist, exposed with the interference fringe, in relation to the second fine pattern in accordance with an exposure amount with which the second fine pattern can be formed through the development process, and for exposing another portion of the exposed region of the resist, exposed with the interference fringe, in relation to the first fine pattern in accordance with an exposure amount with which the first fine pattern can not be formed through the development process, such that with the second exposure the first fine pattern is formed through the development process, wherein said second exposure step is performed by projecting, to the resist, mask patterns of shapes similar to the first and second fine patterns, respectively.

33. A method according to Claim 32, wherein the first and second fine patterns are contiguous.

34. A method according to Claim 32 or 33, wherein said first and second exposure steps are performed sequentially in the above-mentioned order or in an opposite order, or simultaneously.

**35.** A multiple exposure method for exposing a resist so that, with a development process, a first fine pattern and a second fine pattern having a linewidth larger than that of the first fine pattern can be formed on the resist, said method comprising:

a first exposure step for exposing the resist in relation to the first fine pattern, in accordance with an exposure amount with which the first fine pattern can not be formed through the development process; and

a second exposure step for exposing the resist in relation to the second fine pattern in accordance with an exposure amount with which the second fine pattern can be formed through the development process, and for exposing the resist in relation to the first fine pattern in accordance with an exposure amount with which the first fine pattern can not be formed through the development process, such that with the second exposure the first fine pattern is formed through the development process, wherein said second exposure step is performed by projecting, to the resist, mask patterns of shapes similar to the first and second fine patterns, respectively.

**36.** A method according to claim 35, wherein the first and second fine patterns are contiguous.

**37.** A method according to claim 35 or 36, wherein said first and second exposure steps are performed sequentially in the above-mentioned order or in an opposite order, or simultaneously.

**38.** A method of transferring a pattern from a mask to a substrate coated with a resist layer comprising the steps of:

exposing an area of the resist layer to a first fine pattern of bright and dark interference fringes in an exposure step wherein the bright fringes expose the resist layer with an exposure amount insufficient to activate the resist layer;

exposing said area of the resist layer to a second fine pattern in a second exposure step wherein a mask pattern of bright and dark regions is projected on to the resist layer, wherein the exposure amount at the bright regions is insufficient to activate the resist layer; and

developing the resist layer to reveal the pattern.

**39.** A method according to claim 38 further including an exposure step wherein at least a part of said area of the resist layer is exposed to a mask pattern of bright and dark regions is projected on to the resist layer, wherein the exposure amount at the bright regions is sufficient to activate the resist layer, prior to the developing step.

EXCIMER LASER — 191

ILLUMINATION OPTICAL SYSTEM — 192

193

194

195

196

197

198

199

$NA = \sin\theta$

FIG. 1

FIG. 2

PERIODIC
PATTERN
EXPOSURE
STEP

↓

NORMAL
EXPOSURE
STEP

↓

DEVELOPING
STEP

# FIG. 3

1 0 1 0 1 0 1 0 1 0 1

EXPOSURE $_E$
AMOUNT

1

0

POSTION ON IMAGE
PLANE (RESIST)

# FIG. 4A

EXPOSURE
AMOUNT

$E$

2

1

Eth

0

POSTION ON IMAGE
PLANE (RESIST)

# FIG. 4B

FILM THICKNESS d
AFTER DEVELOPMENT

EXPOSURE
AMOUNT E

NEGATIVE TYPE
RESIST

FIG. 5A

FILM THICKNESS d
AFTER DEVELOPMENT

EXPOSURE
AMOUNT E

POSITIVE TYPE
RESIST

FIG. 5B

NEGATIVE
TYPE
RESIST

POSITIVE
TYPE
RESIST

EXPOSURE
AMOUNT  E>Eth

FIG. 6

1 0 1 0 1 0 1 0 1 0 1

EXPOSURE AMOUNT E

POSITION ON IMAGE PLANE (RESIST)

FIG. 7

EXPOSURE AMOUNT E

FIG. 8

EXPOSURE PATTERN BY
NORMAL EXPOSURE

0  0  0  0  1  0  0  0  0  0  0

EXPOSURE
AMOUNT $E_2$

$E_2$
1
0

## FIG. 9A

LITHOGRAPHIC PATTERN AND
EXPOSURE PATTERN BY
DUAL EXPOSURE

EXPOSURE
AMOUNT
$E=E_1+E_2$

Eth
1
0

## FIG. 9B

EP 0 939 343 A1

EXPOSURE PATTERN BY
NORMAL EXPOSURE

LITHOGRAPHIC PATTERN AND
EXPOSURE PATTERN BY
DUAL EXPOSURE

0  0  0  0  2  2  0  0  0  0  0

EXPOSURE
AMOUNT $E_2$

EXPOSURE
AMOUNTE
$E = E_1 + E_2$

POSITION ON IMAGE
PLANE (RESIST)

POSITION ON IMAGE
PLANE (RESIST)

# FIG. 10A

# FIG. 10B

EP 0 939 343 A1

EXPOSURE PATTERN BY
NORMAL EXPOSURE

LITHOGRAPHIC PATTERN AND
EXPOSURE PATTERN BY
DUAL EXPOSURE

0  0  0  2  2  2  0  0  0  0  0

EXPOSURE
AMOUNT $E_2$

EXPOSURE
AMOUNTE  $E=E_1+E_2$

POSITION ON IMAGE
PLANE (RESIST)

POSITION ON IMAGE
PLANE (RESIST)

# FIG. 11A

# FIG. 11B

$0.3\,\mu m$

$0.2\,\mu m$

B

S

A ← → A'

B

$0.1\,\mu m$

B

# FIG. 12

EP 0 939 343 A1

(A)  (B)  (C)

**FIG. 13**

0. 12 μm

B

0. 24 μm

0. 12 μm

1. 2 μm

0. 12 μm

S

0. 36 μm

0. 36 μm

# FIG. 14

**DEFOCUS 0.0μm** **DEFOCUS 0.25μm** **DEFOCUS 0.5μm**

PERIODIC EXPOSURE

NORMAL EXPOSURE

DUAL EXPOSURE

RESIST PATTERN

# FIG. 15

FIG. 16

ILLUMINATION LIGHT

MASK

$P_{os}$   $P_0$   MASK

(A)   171

172

$P_{os}$   MASK

(B)

181

$\theta_0$

FIG. 17

ILLUMINATION LIGHT

MASK

$\theta_0$

$P_0$   MASK

CHROMIUM

$\theta_0$

ZERO-TH ORDER   NEGATIVE FIRST ORDER

FIG. 18

63

FIG. 19

FIG. 20

222

225

223

226

224

230

221

EXCIMER
LASER

(1a)
PARALLEL
ILLUMINATION
LIGHT

227

(1b)
OBLIQUE
INCIDENCE
ILLUMINATION
LIGHT

217

(1c)
SMALL-σ
ILLUMINATION
LIGHT

228

229

(2)
LARGE-σ
ILLUMINATION
LIGHT

# FIG. 21

```
┌─────────────────────────┐
│                         │
│  HIGH CONTRAST          │
│  IMAGE EXPOSURE         │
│  STEP                   │
│                         │
└─────────────────────────┘
            │
            ↓
┌─────────────────────────┐
│                         │
│  ORDINARY EXPOSURE      │
│  STEP                   │
│                         │
└─────────────────────────┘
            │
            ↓
┌─────────────────────────┐
│                         │
│  DEVELOPING             │
│  STEP                   │
│                         │
└─────────────────────────┘
```

# FIG. 22

FIG. 23A

FIG. 23B

FIG. 23C

FIG. 23D

FIG. 23E

FIG. 23F

FIG. 23G

FIG. 24A

FIG. 24B

FIG. 24C

FIG. 24D

FIG. 24E

FIG. 24F

FIG. 24G

FIG. 25A

FIG. 25B

FIG. 25C

FIG. 25D

FIG. 25E

FIG. 25F

FIG. 25G

FIG. 25H

FIG. 26A

FIG. 26B

FIG. 26C

FIG. 26D

FIG. 26E

FIG. 26F

FIG. 26G

FIG. 26H

FIG. 27A

FIG. 27B

FIG. 27C

FIG. 27D

FIG. 27E

FIG. 27F

FIG. 28A

FIG. 28B

FIG. 28C

(A)

(B)

(C)

FIG. 29

EP 0 939 343 A1

FIG. 30A

FIG. 30B

FIG. 30C

FIG. 30D

FIG. 30E

FIG. 30F

FIG. 31A

FIG. 31B

FIG. 31C

FIG. 32

EP 0 939 343 A1

FIG. 33B

FIG. 33A

M

FIG. 34A

Ma

FIG. 34D

FIG. 34B

FIG. 34E

FIG. 34C

FIG. 34F

FIG. 35A

FIG. 35E

FIG. 35B

FIG. 35C

FIG. 35D

DUAL EXPOSURE WITH PERIODIC
PATTERN AND CIRCUIT PATTERN

# FIG. 36A

CIRCUIT PATTERN
WITH SINGLE BAR

X

# FIG. 36B

CIRCUIT PATTERN
WITH TWO BARS

X

# FIG. 36C

CIRCUIT PATTERN
WITH THREE BARS

X

(A) EXPOSURE AMOUNT DISTRIBUTION BY ONLY
THREE-BAR PATTERN (CONTRAST IS POSITIVE : b>c)

INTENSITY

b

c

x

(B) EXPOSURE AMOUNT DISTRIBUTION BY
PERIODIC PATTERN ONLY

$I_0$

$I_1$

x

(C) EXPOSURE AMOUNT DISTRIBUTION BY
DUAL EXPOSURE

b′

c′

x

FIG. 37

(A) ISOLATED SINGLE BAR  (B) TWO BARS  (C) THREE BARS

PATTERN NO. = 1

PATTERN NO. = 2

PATTERN NO. = 3

INTENSITY DISTRIBUTION OF PERIODIC PATTERN: PATTERN NO. =1
INTENSITY DISTRIBUTION OF BAR PATTERN:      PATTERN NO. =2
INTENSITY DISTRIBUTION AFTER DUAL EXPOSURE: PATTERN NO. =3

# FIG. 38

EP 0 939 343 A1

EP 0 939 343 A1

(A) ISOLATED
SINGLE BAR

(B) TWO BARS

(C) THREE BARS

PATTERN
NO. = 1

PATTERN
NO. = 1

PATTERN
NO. = 1

PATTERN
NO. = 2

PATTERN
NO. = 2

PATTERN
NO. = 2

INTENSITY DISTRIBUTION IN SINGLE EXPOSURE OF PHASE SHIFT MASK

ILLUMINATION CONDITION $\sigma$=0.2 : PATTERN NO. = 1
ILLUMINATION CONDITION $\sigma$=0.5 : PATTERN NO. = 2

FIG. 39

CONTRAST IN SINGLE EXPOSURE OF PHASE SHIFT MASK
ILLUMINATION CONDITION σ =0. 5

(A) THREE BARS

(B) TWO BARS

(C) ISOLATED SINGLE BAR

# FIG. 40

CONTRAST IN DUAL EXPOSURE
ILLUMINATION CONDITION FOR PERIODIC PATTERN $\sigma=0.2$
ILLUMINATION CONDITION FOR ORDINARY PATTERN $\sigma=0.8$ RING-LIKE
LIGHT QUANTITY RATIO $k=1.5$

(A) THREE BARS

NA − 0.60(sigma0.2 & 2/3SIB),3bar

(B) TWO BARS

NA − 0.60(sigma0.2 & 2/3SIB),2bar

(C) ISOLATED SINGLE BAR

NA − 0.60(sigma0.2 & 2/3SIB),1bar

# FIG. 41

# LINEWIDTH LINEARITY ERROR OF BAR PATTERN EXPOSURE
## ILLUMINATION CONDITION $\sigma = 0.53 \sim 0.8$ RING-LIKE

(A) FIVE BARS

NA − 0.60 (2/3SIB),5bar

(B) TWO BARS

NA − 0.60 (2/3SIB),2bar

(C) ISOLATED SINGLE BAR

IDNA − 0.60 (2/3SIB),1bar

# FIG. 42

LINEWIDTH LINEARITY ERROR OF BAR PATTERN EXPOSURE
ILLUMINATION CONDITION FOR PERIODIC PATTERN $\sigma$ =0.2
ILLUMINATION CONDITION FOR ORDINARY PATTERN $\sigma$ =0.53~0.8 RING-LIKE
LIGHT QUANTITY RATIO k=1.5

(A) FIVE BARS

NA - 0.60 (sigma0.2 & 2/3SIB),5bar

(B) TWO BARS

NA - 0.60 (sigma0.2 & 2/3SIB),2bar

(C) ISOLATED SINGLE BAR

NA - 0.60 (sigma0.2 & 2/3SIB),1bar

# FIG. 43

DUAL EXPOSURE WITH PERIODIC PATTERN
AND ORDINARY PATTERN
(LINEWIDTH OF ORDINARY PATTERN
IS TRIPLE OF PERIODIC PATTERN)

INTENSITY DISTRIBUTION ON X-SECTION

PERIODIC
PATTERN

ORDINARY
PATTERN

INTENSITY
DISTRIBUTION
AFTER DUAL
EXPOSURE

# FIG. 44

DUAL EXPOSURE WITH PERIODIC PATTERN
AND ORDINARY PATTERN
(ORDINARY PATTERN HAS DIFFERENT
LINEWIDTHS)

FIG. 45

TWO-DIMENSIONAL IMAGE OF ISOLATED LINE

(A) TWO-DIMENSIONAL IMAGE BY ORDINARY EXPOSURE
ILLUMINATION CONDITION
$\sigma$ =0.8 RING-LIKE

def=0        def=0.25        def=0.5

(B) TWO-DIMENSIONAL IMAGE BY DUAL EXPOSURE
ILLUMINATION CONDITION FOR PERIODIC PATTERN
$\sigma$ =0.2

ILLUMINATION CONDITION FOR ORDINARY PATTERN
$\sigma$ =0.8 RING-LIKE

def=0        def=0.25        def=0.5

LINEWIDTH 0.12 $\mu$ m

LINEWIDTH IN LATERAL DIRECTION(%)

|  | def=0 | def=0.25 | def=0.5 |
|---|---|---|---|
| ORDINARY EXPOSURE | 100 | 82 | 0 |
| DUAL EXPOSURE | 100 | 88 | 39 |

LINEWIDTH IN LONGITUDINAL DIRECTION(%)

|  | def=0 | def=0.25 | def=0.5 |
|---|---|---|---|
| ORDINARY EXPOSURE | 87 | 84 | 0 |
| DUAL EXPOSURE | 91 | 89 | 58 |

FIG. 46

INTENSITY DISTRIBUTIONS BY PERIODIC PATTERN,
ORDINARY PATTERN AND DUAL EXPOSURE

(A) EXPOSURE AMOUNT DISTRIBUTION BY
    THREE-BAR PATTERN ONLY
    (CONTRAST IS ZERO: b=c)

(B) EXPOSURE AMOUNT DISTRIBUTION BY
    PERIODIC PATTERN ONLY

(C) EXPOSURE AMOUNT DISTRIBUTION BY
    DUAL EXPOSURE

# FIG. 47

INTENSITY DISTRIBUTIONS BY PERIODIC PATTERN, ORDINARY PATTERN AND DUAL EXPOSURE

(A) EXPOSURE AMOUNT DISTRIBUTION BY THREE-BAR PATTERN ONLY (CONTRAST IS NEGATIVE: b<c)

(B) EXPOSURE AMOUNT DISTRIBUTION BY PERIODIC PATTERN ONLY

(C) EXPOSURE AMOUNT DISTRIBUTION BY DUAL EXPOSURE

FIG. 48

ORDINARY ILLUMINATION PATTERN

"L" IS LINEWIDTH NOT RESOLVABLE BY SINGLE EXPOSURE
WITH EXPOSURE APPARATUS TO BE USED FOR EXPOSURE.

Cr PATTERN          Cr PATTERN

QZ

RETICLE SECTIONAL VIEW

FIG. 49

HALFTONE PHASE SHIFT PATTERN

"L" IS LINEWIDTH NOT RESOLVABLE BY SINGLE EXPOSURE
WITH EXPOSURE APPARATUS TO BE USED FOR EXPOSURE.

RETICLE SECTIONAL VIEW

# FIG. 50

RIM TYPE PHASE SHIFT PATTERN

DOTTED AREA IS Cr PATTERN(LIGHT BLOCKING PORTION),
AND PHASE SHIFTER RIM SURROUNDS IT.
"L" IS LINEWIDTH NOT RESOLVABLE BY SINGL EXPOSURE
WITH EXPOSURE APPARATUS TO BE USED FOR EXPOSURE.

RETICLE SECTIONAL VIEW

# FIG. 51

CHROMIUM-LESS SHIFTER LIGHT-BLOCKING
TYPE PHASE SHIFT PATTERN

"L" IS LINEWIDTH NOT RESOLVABLE BY SINGLE EXPOSURE
WITH EXPOSURE APPARATUS TO BE USED FOR EXPOSURE.

PHASE SHIFT PATTERN

RETICLE SECTIONAL VIEW

# FIG. 52

FIG. 53

FIG. 54

FIG. 55

90 (LEVENSON MASK)

91 (Cr)

92 (PHASE $\pi$)

93 (PHASE 0)

# FIG. 56

101 (MASK)

102 (Cr)

0.1 $\mu$m

# FIG. 57

EFFECTIVE LIGHT SOURCE (SMALL $\sigma$)

# FIG. 58

LIGHT DISTRIBUTION ON PUPIL (OBJECT SPECTRUM)
LIMIT RESOLUTION BY COHERENT TWO-DIMENSIONAL
EXPOSURE, ACCOMPLISHED (FOUR-BEAM INTERFERENCE)

0. 14 $\mu$ mL&S (HOLE)

# FIG. 59

EFFECTIVE LIGHT SOURCE
(45-DEG. QUADRUPOLE)

# FIG. 60

LEVENSON MASK PLUS OBLIQUE INCIDENCE MULTIPLE EXPOSURE

(A)

(B)

87

87d

87

87a

87c

87b

LIGHT DISTRIBUTION ON PUPIL
(OBJECT SPECTRUM)

FIG. 61

EP 0 939 343 A1

CORRESPONDING TO MULTIPLE EXPOSURE
OF ONE-DIMENSIONAL LIMIT RESOLUTION
0. 1 $\mu$ mL&S(HOLE)

87a     +     87b

+     87c     +     87d

LIGHT DISTRIBUTION ON PUPIL(OBJECT SPECTRUM)

FIG. 62

EFFECTIVE LIGHT SOURCE
(45-DEG. QUADRUPOLE)

FIG. 63

ORDINARY MASK PLUS OBLIQUE INCIDENCE MULTIPLE EXPOSURE

(A)

(B)

SHIFTED BY OBLIQUE
INCIDENCE ILLUMINATION

LIGHT DISTRIBUTION ON PUPIL
(OBJECT SPECTRUM)

# FIG. 64

EP 0 939 343 A1

CORRESPONDING TO MULTIPLE EXPOSURE
OF ONE-DIMENSIONAL LIMIT RESOLUTION
0. 1 μ mL&S(HOLE)

LIGHT DISTRIBUTION ON PUPIL(OBJECT SPECTRUM)

# FIG. 65

DOUBLE-BEAM
INTERFERENCE

| 0 | 1 | 0 | 1 | 0 | 1 | 0 | 1 | 0 | 1 | 0 |
|---|---|---|---|---|---|---|---|---|---|---|

| | | | | | | | | | | | |
|---|---|---|---|---|---|---|---|---|---|---|---|
| 0 | 0 | 1 | 0 | 1 | 0 | 1 | 0 | 1 | 0 | 1 | 0 |
| 1 | 1 | 2 | 1 | 2 | 1 | 2 | 1 | 2 | 1 | 2 | 1 |
| 0 | 0 | 1 | 0 | 1 | 0 | 1 | 0 | 1 | 0 | 1 | 0 |
| 1 | 1 | 2 | 1 | 2 | 1 | 2 | 1 | 2 | 1 | 2 | 1 |
| 0 | 0 | 1 | 0 | 1 | 0 | 1 | 0 | 1 | 0 | 1 | 0 |
| 1 | 1 | 2 | 1 | 2 | 1 | 2 | 1 | 2 | 1 | 2 | 1 |
| 0 | 0 | 1 | 0 | 1 | 0 | 1 | 0 | 1 | 0 | 1 | 0 |
| 1 | 1 | 2 | 1 | 2 | 1 | 2 | 1 | 2 | 1 | 2 | 1 |
| 0 | 0 | 1 | 0 | 1 | 0 | 1 | 0 | 1 | 0 | 1 | 0 |
| 1 | 1 | 2 | 1 | 2 | 1 | 2 | 1 | 2 | 1 | 2 | 1 |

DOUBLE-BEAM
INTERFERENCE

# FIG. 66

FIG. 67

FIG. 68

FIG. 69

(13a)
PARALLEL
ILLUMINATION
LIGHT

(13b)
ORDINARY
ILLUMINATION
LIGHT

EXPOSURE APPARATUS
WITH PUPIL FILTER

FIG. 70

14 (MASK)

Cr

FIG. 71

161

162

163

163a

164

−1ST
ORDER

ZEROTH
ORDER

+1ST
ORDER

165

166

167

−1ST
ORDER

+1ST
ORDER

ZEROTH
ORDER

PRINCPLE OF DOUBLE-BEAM
INTERFERENCE IN STEPPER

# FIG. 72

**FIG. 73**

EFFECTIVE LIGHT SOURCE (SMALL $\sigma$)

**FIG. 74**

ORDINARY MASK PLUS ZEROTH ORDER BLOCKING FILTER

ZEROTH ORDER LIGHT BLOCKED
(PUPIL FILTER)

(A)

(B)

LIGHT DISTRIBUTION ON PUPIL
(OBJECT SPECTRUM)

# FIG. 75

EP 0 939 343 A1

EP 0 939 343 A1

LIMIT RESOLUTION BY COHERENT TWO-DIMENSIONAL EXPOSURE,
ACCOMPLI SHED (FOUR-BEAM INTERFERENCE)

0. 14 $\mu$ mL&S(HOLE)

(A)

(B)

161

EFFECT ON IMAGE

FIG. 76

FIG. 77

EFFECTIVE LIGHT SOURCE
(45-DEG. QUADRUPOLE, LOW
TRANSMISSION FACTOR
AT 2 AND 4)

# FIG. 78

LEVENSON MASK PLUS OBLIQUE INCIDENCE (MULTI-VALUE TRANSMISSION)
MULTIPLE EXPOSURE

(A)

(B)

LIGHT DISTRIBUTION ON PUPIL
(OBJECT SPECTRUM)

# FIG. 79

EP 0 939 343 A1

CORRESPONDING TO MULTIPLE EXPOSURE
OF ONE-DIMENSIONAL LIMIT RESOLUTION
0. 1 $\mu$ mL&S(HOLE)

LIGHT DISTRIBUTION ON PUPIL(OBJECT SPECTRUM)

# FIG. 80

# FIG. 81

# FIG. 82

FIG. 83

SUPERPOSITION OF DOUBLE-BEAM INTERFERENCE

0. 1 $\mu$ m L&S

FIG. 84

A        B

# FIG. 85

LS4          ○          LS1

○                    ○

LS3          ○          LS2

SIDEROBES ARE EXCLUDED
(MAY BY INCLUDED IN NA, WITH LARGE σ)

# FIG. 86

FOUR-BEAM INTERFERENCE

| 0 | 0 | 0 | 0 | 0 | 0 | 0 | 0 | 0 | 0 | 0 |
|---|---|---|---|---|---|---|---|---|---|---|
| 0 | 1 | 0 | 1 | 0 | 1 | 0 | 1 | 0 | 1 | 0 |
| 0 | 0 | 0 | 0 | 0 | 0 | 0 | 0 | 0 | 0 | 0 |
| 0 | 1 | 0 | 1 | 0 | 1 | 0 | 1 | 0 | 1 | 0 |
| 0 | 0 | 0 | 0 | 0 | 0 | 0 | 0 | 0 | 0 | 0 |
| 0 | 1 | 0 | 1 | 0 | 1 | 0 | 1 | 0 | 1 | 0 |
| 0 | 0 | 0 | 0 | 0 | 0 | 0 | 0 | 0 | 0 | 0 |
| 0 | 1 | 0 | 1 | 0 | 1 | 0 | 1 | 0 | 1 | 0 |
| 0 | 0 | 0 | 0 | 0 | 0 | 0 | 0 | 0 | 0 | 0 |
| 0 | 1 | 0 | 1 | 0 | 1 | 0 | 1 | 0 | 1 | 0 |

# FIG. 87

M

PROJECTION EXPOSURE

FOUR-BEAM
INTERFERENCE
EXPOSURE

| 0 | 1 | 2 |
|---|---|---|

(THRESHOLD 1.5)

| 1 | 0 |
|---|---|
| 0 | 0 |

| 1 | 0 |
|---|---|
| 0 | 0 |

| 2 | 1 |
|---|---|
| 1 | 1 |

| 4 | 2 |
|---|---|
| 2 | 2 |

# FIG. 88

120

FOUR-BEAM INTERFERENCE

4. 14 $\mu$ mL&S

# FIG. 89

FIG. 90

(A)

(B)

(C)

$\sigma = 0.3$

| | DEFOCUS 0 | DEFOCUS $\pm 0.2\mu$ m | DEFOCUS $\pm 0.4\mu$ m |
|---|---|---|---|
| ORDINARY EXPOSURE | | | |
| DUAL EXPOSURE | | | |

FIG. 91A

$\sigma = 0.6$

| | DEFOCUS 0 | DEFOCUS $\pm 0.2\mu$ m | DEFOCUS $\pm 0.4\mu$ m |
|---|---|---|---|
| ORDINARY EXPOSURE | | | |
| DUAL EXPOSURE | | | |

FIG. 91B

$\sigma = 0.8$

DEFOCUS 0 · DEFOCUS ±0.2μm · DEFOCUS ±0.4μm

ORDINARY EXPOSURE

DUAL EXPOSURE

# FIG. 92A

RING-LIKE ILLUMINATION

DEFOCUS 0 · DEFOCUS ±0.2μm · DEFOCUS ±0.4μm · DEFOCUS ±0.6μm

ORDINARY EXPOSURE

DUAL EXPOSURE

# FIG. 92B

| CIRCUIT DESIGN | WAFER MANUFACTURE |
|---|---|

(STEP 1)　　　　　　　　(STEP 3)

| MASK MANUFACTURE |
|---|

(STEP 2)

| WAFER PROCESS (PRE-PROCESS) |
|---|

(STEP 4)

| ASSEMBLY PROCESS (POST-PROCESS) |
|---|

(STEP 5)

| INSPECTION |
|---|

(STEP 6)

| SHIPMENT |
|---|

(STEP 7)

# FIG. 93

| OXIDATION | RESIST PROCESS |
|---|---|
| (STEP 11) | (STEP 15) |
| C V D | EXPOSURE |
| (STEP 12) | (STEP 16) |
| ELECTRODE FORMATION | DEVELOPMENT |
| (STEP 13) | (STEP 17) |
| ION IMPLANTAION | ETCHING |
| (STEP 14) | (STEP 18) |
| | RESIST SEPARATION |
| REPEAT | (STEP 19) |

## FIG. 94

(C)

(B)

(A)

FIG. 95

$\sigma = 0.3$

|  | DEFOCUS 0 | DEFOCUS ±0.2 μ m | DEFOCUS ±0.4 μ m |
|---|---|---|---|
| ORDINARY EXPOSURE | | | |
| DUAL EXPOSURE | | | |

# FIG. 96A

$\sigma = 0.6$

|  | DEFOCUS 0 | DEFOCUS ±0.2 μ m | DEFOCUS ±0.4 μ m |
|---|---|---|---|
| ORDINARY EXPOSURE | | | |
| DUAL EXPOSURE | | | |

# FIG. 96B

$\sigma = 0.8$

|  | DEFOCUS 0 | DEFOCUS ±0.2μ m | DEFOCUS ±0.4μ m |
|---|---|---|---|
| ORDINARY EXPOSURE | | | |
| DUAL EXPOSURE | | | |

# FIG. 96C

RING-LIKE ILLUMINATION

|  | DEFOCUS 0 | DEFOCUS ±0.2μ m | DEFOCUS ±0.4μ m |
|---|---|---|---|
| ORDINARY EXPOSURE | | | |
| DUAL EXPOSURE | | | |

# FIG. 96D

European Patent
Office

**EUROPEAN SEARCH REPORT**

Application Number

EP 99 30 1386

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | "CONTROL OF PHOTORESIST EDGE SLOPE" IBM TECHNICAL DISCLOSURE BULLETIN, vol. 32, no. 3A, 1 August 1989, page 431/432 XP000049406 * abstract * | 1,2,5,7, 15,20, 21,29,30 | G03F7/20 |
| X | US 5 415 835 A (BRUECK STEVEN R J ET AL) 16 May 1995<br><br>* column 7, line 12 - line 32; figure 21 *<br>* column 3, line 62 - column 4, line 40 *<br>* column 2, line 52 - line 61 * | 1-5,7, 14,15, 20,23, 25-39 | |
| X | US 5 532 090 A (BORODOVSKY YAN A) 2 July 1996<br><br>* the whole document * | 1-5, 7-12,15, 17,18, 20-22, 29-31 | |
| X | EP 0 366 367 A (FUJITSU LTD) 2 May 1990<br><br>* figure 3 * | 1,2,5,7, 15,20, 29-31 | TECHNICAL FIELDS SEARCHED (Int.Cl.6)<br><br>G03F |
| X | EP 0 534 463 A (FUJITSU LTD) 31 March 1993<br><br>* claim 1 * | 1,2, 29-31 | |
| A | US 4 869 999 A (FUKUDA HIROSHI ET AL) 26 September 1989 | | |
| A | WO 94 24610 A (ASTARIX INC) 27 October 1994 | | |

The present search report has been drawn up for all claims

| Place of search | Date of completion of the search | Examiner |
|---|---|---|
| THE HAGUE | 18 June 1999 | Haenisch, U |

EPO FORM 1503 03.82 (P04C01)

**ANNEX TO THE EUROPEAN SEARCH REPORT
ON EUROPEAN PATENT APPLICATION NO.**                    EP 99 30 1386

This annex lists the patent family members relating to the patent documents cited in the above-mentioned European search report.
The members are as contained in the European Patent Office EDP file on
The European Patent Office is in no way liable for these particulars which are merely given for the purpose of information.

18-06-1999

| Patent document cited in search report | | Publication date | Patent family member(s) | | Publication date |
|---|---|---|---|---|---|
| US 5415835 | A | 16-05-1995 | US | RE35930 E | 20-10-1998 |
| US 5532090 | A | 02-07-1996 | NONE | | |
| EP 0366367 | A | 02-05-1990 | JP | 2114512 A | 26-04-1990 |
| | | | JP | 2680074 B | 19-11-1997 |
| | | | DE | 68917557 D | 22-09-1994 |
| | | | DE | 68917557 T | 15-12-1994 |
| | | | US | 5082762 A | 21-01-1992 |
| EP 0534463 | A | 31-03-1993 | JP | 5198479 A | 06-08-1993 |
| | | | JP | 5090121 A | 09-04-1993 |
| | | | JP | 7070468 B | 31-07-1995 |
| | | | JP | 2674400 B | 12-11-1997 |
| | | | JP | 5165191 A | 29-06-1993 |
| | | | EP | 0810474 A | 03-12-1997 |
| | | | EP | 0810475 A | 03-12-1997 |
| | | | KR | 9610026 B | 25-07-1996 |
| | | | US | 5472813 A | 05-12-1995 |
| | | | US | 5364716 A | 15-11-1993 |
| US 4869999 | A | 26-09-1989 | JP | 5088531 B | 22-12-1993 |
| | | | JP | 63042122 A | 23-02-1988 |
| | | | JP | 2102986 C | 22-10-1996 |
| | | | JP | 8010666 B | 31-01-1996 |
| | | | JP | 63064037 A | 22-03-1988 |
| | | | US | 4904569 A | 27-02-1990 |
| | | | US | 4937619 A | 26-06-1990 |
| | | | US | 4992825 A | 12-02-1991 |
| WO 9424610 | A | 27-10-1994 | US | 5702868 A | 30-12-1997 |

EPO FORM P0459

For more details about this annex : see Official Journal of the European Patent Office, No. 12/82